# EUROPEAN PATENT APPLICATION

(11) **EP 4 739 084 A1**
(43) Date of publication of application: **06.05.2026**
(21) Application number: 25202067.2
(22) Date of filing: 15.09.2025
(51) Int. Cl.: H10W 90/10, H10B 80/00, H10D 80/30, H10W 90/20, H10W 72/00

(54) **HIGH BANDWIDTH MEMORY STACK WITH SIDE EDGE INTERCONNECTION AND 3D IC STRUCTURE WITH THE SAME**

(30) Priority: 05.11.2024 US 202463716506 P; 13.12.2024 US 202463733458 P; 21.02.2025 US 202519059275; 21.02.2025 US 202519059297; 25.02.2025 US 202519062467; 25.02.2025 US 202519062566
(71) Applicant: nD-HI Technologies Lab, Inc., 114754 Taipei City (TW); Etron Technology, Inc., Hsinchu 300 (TW)
(72) Inventor: TONG, Ho-Ming, 114754 2F-2, NO. 22, LN. 35, JIHU RD., NEIHU DIST., TAIPEI CITY (TW); LU, Chao-Chun, NO. 6, TECHNOLOGY ROAD 5, HSINCHU SCIENCE PARK, HSINCHU (TW)
(74) Representative: Herrero & Asociados, S.L.

(57) **Abstract**

An IC structure includes a memory stack including semiconductor dies horizontally separate with each other, wherein each semiconductor die has a top surface, a bottom surface, four sidewalls, and a plurality of edge pads arranged along a sidewall. The IC structure further includes a memory controller under the first memory stack and electrically connected to the edge pads of each semiconductor die, a processor circuit disposed over and electrically connected to the memory controller, and a packaging substrate under and electrically connected to the memory controller. A die area of the memory controller is larger than the sum of a horizontal cross-section area of the memory stack and a die area of the processor circuit. There is no interposer between the packaging substrate and the memory controller, and there is no TSV in each semiconductor die.

## Description

### FIELD

This disclosure relates in general to a memory stack within IC structure, and more particularly to a high bandwidth memory stack with side edge interconnections and 3D IC structure including the same.

### BACKGROUND

2.5D/3D ICs have been recognized as a next generation semiconductor technology, which has the advantage of high performance, low power consumption, small physical size and high integration density. 2.5D/3D ICs provide a path to continue to meet the performance/cost demands of next generation devices while remaining at more relaxed gate lengths with less process complexity. Thus, 2.5D/3D ICs are expected to find broad based utilities in applications such as HPC (high-performance computing) and data centers, AI (artificial intelligence)/ML (machine learning), 5G/6G networks, graphics, smart phones/wearables, automotive and others that demand "extreme," ultra-high-performance, higher-power-efficiency devices.

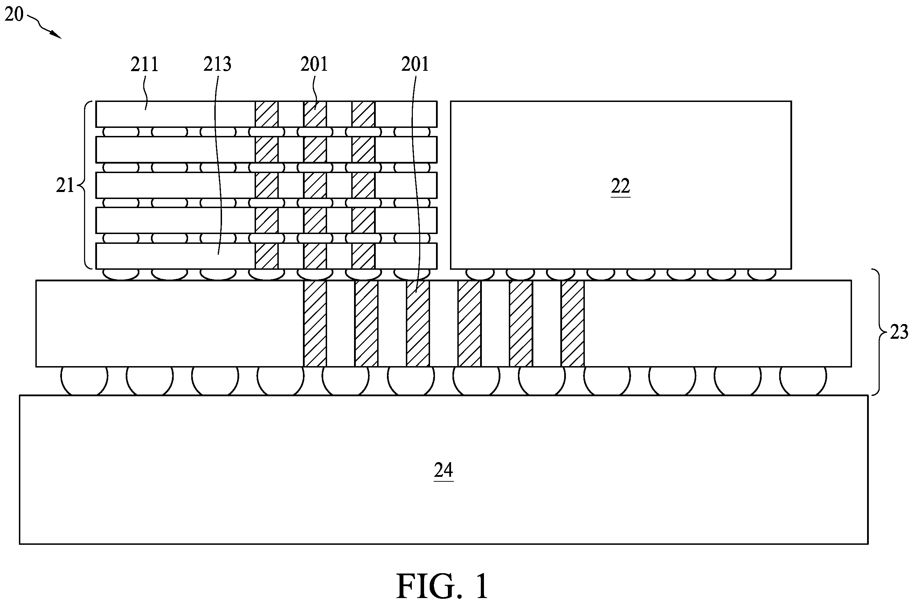

Commercial 2.5D/3D ICs such as a 3D high-bandwidth memory (HBM) DRAM memory die stack on logic are increasingly being used, and those HBM devices contain through silicon vias (TSVs) in both active dies and in the silicon interposer. Furthermore, 2.5D/3D ICs also allow for vertical stacking of heterogeneous dies from different manufacturing processes and nodes, chip reuse and chiplets-in-SiP (system-in-a-package) for high-performance applications, which have been already pushing the limits of a single die at the most advanced node. As shown in FIG. **1****,** a COWOS (chips-on-wafer-on-substrate) structure **20** includes an HBM structure **21** (with a plurality of DRAM memory dies **211** and a controller **213**) with TSVs 201, a logic die **22** (such as a GPU or an SOC chip), a silicon interposer **23** with TSVs and a packaging substrate **24,** wherein the HBM structure **21** and the logic die **22** are stacked on the silicon interposer **23,** and the silicon interposer **23** is then stacked on the packaging substrate **24.**

However, 2.5D/3D ICs adopt packaging topologies with bottom/top electrical interconnects created by the aforementioned interconnect technologies such as micro-bumps, TSVs and redistribution layers (RDL). The bottom/top electrical interconnects impose a severe constraint on PPAC (power, performance, area and cost) optimization by designers of 3D ICs to come up with optimal design solutions, especially the difficulty of forming TSVs in semiconductor dies and the alignment of TSVs for each semiconductor die.

Furthermore, as the monolithic integration capability of a silicon chip has grown from GSI (Giga Scale Integration: Over billions of transistors on a die) toward TSI (Tera Scale Integration: Trillions of transistors on a die) soon, the power consumption of running such a huge number of transistors is increasing sharply, which elevates adversely the junction temperature of transistors and thus the entire chip temperature due to current limited heat-dissipation capability (e.g. Thermal conductivity index of silicon dioxide/ silicon is very low. To be worse, due to the stack of multiple DRAM memory semiconductor dies (or HBM) in 2.5D/3D ICs, the insufficient heat dissipation problem causing higher temperature to chip operation is regarded as the worst problem for the HBM structure.

### SUMMARY

According to a first aspect of the present disclosure, an IC structure includes a first memory stack, wherein the first memory stack includes a plurality of semiconductor dies horizontally separate with each other, wherein each semiconductor die has a top surface, a bottom surface opposite to the top surface, and four sidewalls comprising a first sidewall, a second sidewall, a third sidewall and a fourth sidewall, and a plurality of edge pads arranged along the first sidewall. The area of the bottom surface or the top surface of each semiconductor die is larger than that of any sidewall. The IC structure further includes a logic die with memory controller under the first memory stack and electrically connected to the plurality of edge pads of each semiconductor die, a logic die with processor circuit disposed over and electrically connected to the logic die with memory controller, and a packaging substrate under and electrically connected to the logic die with memory controller. A die area of the logic die with memory controller is larger than the sum of a horizontal cross-section area of the first memory stack and a die area of the logic die with processor circuit. There is no interposer between the packaging substrate and the logic die with memory controller, and there is no TSV in each semiconductor die.

According to some embodiments of the present disclosure, the IC structure further includes an upward extending thermal conductivity layer and/or a laterally extending thermal conductivity layer. The upward extending thermal conductivity layer is disposed between two adjacent semiconductor dies. The thermal conductivity of the upward extending thermal conductivity layer is higher than that of Si or SiO2. The laterally extending thermal conductivity layer covers each second sidewall of the plurality of semiconductor dies and is thermally coupled to the upward extending thermal conductivity layer, wherein the laterally extending thermal conductivity layer is opposite to the first sidewalls of the plurality of semiconductor dies, and the thermal conductivity of the laterally extending thermal conductivity layer is higher than that of Si or SiO₂.

According to some embodiments of the present disclosure, the upward extending thermal conductivity layer or the laterally extending thermal conductivity layer includes undoped polysilicon, large crystalline silicon, SiC, BN, AlN, W, or copper.

According to some embodiments of the present disclosure, each semiconductor die includes a DRAM die or memory die, and the plurality of edge pads of each DRAM die includes about 128 to 5000 edge pads, and a pitch between two adjacent edge pads is between about 5 µm and about 100 µm.

According to some embodiments of the present disclosure, the plurality of edge pads of each semiconductor die includes a subset of data pads, and the logic die with memory controller selects a predetermined data width from the subset of data pads of one semiconductor die, or portion of the plurality of semiconductor dies, or all the plurality of semiconductor dies.

According to some embodiments of the present disclosure, the predetermined data width selected by the logic die with memory controller is set by a mode register in each semiconductor die.

According to some embodiments of the present disclosure, the logic die with memory controller selects the predetermined data width from the subset of data pads of a portion or all of the plurality of semiconductor dies by a cross-bar circuit.

According to some embodiments of the present disclosure, the logic die with memory controller selects the predetermined data width from the subset of data pads of one, a portion or all of the plurality of semiconductor dies by a plurality of SRAM array respectively corresponding to the plurality of semiconductor dies, wherein each SRAM array temporarily holds the predetermined data width from the corresponding semiconductor die.

According to some embodiments of the present disclosure, the logic die with memory controller includes multiple TSVs.

According to some embodiments of the present disclosure, the IC structure further includes a heat sink over the logic die with processor circuit, and a top surface of the heat sink is leveled with that of the first memory stack.

According to some embodiments of the present disclosure, the IC structure further includes a second memory stack. The second memory stack includes a plurality of semiconductor dies and an upward extending thermal conductivity layer. The plurality of semiconductor dies horizontally separate with each other, wherein each semiconductor die comprises a top surface, a bottom surface opposite to the top surface, and four sidewalls with a first sidewall, a second sidewall, a third sidewall and a fourth sidewall, and a plurality of edge pads arranged along the first sidewall, wherein the area of the bottom surface or the top surface of each semiconductor die of the second memory stack is larger than that of any sidewall. The upward extending thermal conductivity layer between two adjacent semiconductor dies; wherein the thermal conductivity of the upward extending thermal conductivity layer is higher than that of Si or SiO2, wherein the first memory stack and the second memory stack are horizontally spaced apart from the logic die with processor circuit, and are disposed along one side of the logic die with processor circuit.

According to some embodiments of the present disclosure, the IC structure further includes a second memory stack, a third memory stack, and a fourth memory stack. Each of them includes a plurality of semiconductor dies and an upward extending thermal conductivity layer. The plurality of semiconductor dies horizontally separate with each other, wherein each semiconductor die comprises a top surface, a bottom surface opposite to the top surface, and four sidewalls with a first sidewall, a second sidewall, a third sidewall and a fourth sidewall, and a plurality of edge pads arranged along the first sidewall, wherein the area of the bottom surface or the top surface is larger than that of any sidewall. The upward extending thermal conductivity layer between two adjacent semiconductor dies; wherein the thermal conductivity of the upward extending thermal conductivity layer is higher than that of Si or SiO2, wherein the first memory stack, the second memory stack, the third memory stack and the fourth memory stack are horizontally spaced apart from the logic die with processor circuit, and are disposed along four sides of the logic die with processor circuit, respectively.

According to some embodiments of the present disclosure, each edge pad of each semiconductor die includes an edge contact in a back-end-of-line (BEOL) region and a conductive via over the edge contact and in a dielectric layer at the top surface, wherein the area of the conductive via is greater than that of the edge contact.

According to some embodiments of the present disclosure, each edge pad of each semiconductor die includes an edge contact in a back-end-of-line (BEOL) region and a conductive via over the edge contact and in a redistribution layer (RDL) at the top surface, wherein the area of the conductive via is greater than that of the edge contact.

According to some embodiments of the present disclosure, the edge contact electrically connects to a signal pad in a back-end-of-line (BEOL) region of the semiconductor die surrounded by a seal ring structure.

According to some embodiments of the present disclosure, each edge pad of each semiconductor die includes a conductive line in a redistribution layer (RDL), the conductive line is electrically connected to a signal pad in a back-end-of-line (BEOL) region of the semiconductor die surrounded by a seal ring structure.

According to some embodiments of the present disclosure, the RDL includes a plurality of stacked dielectric layers within which the conductive line is located.

According to some embodiments of the present disclosure, a portion of the conductive line is configured to be disposed in a scribe line region of a semiconductor wafer prior to dicing of the semiconductor wafer. BRIEF

### DESCRIPTION OF THE DRAWINGS

Aspects of the present disclosure are best understood from the following detailed description when read with the accompanying figures. It should be noted that, in accordance with the standard practice in the industry, various structures are not drawn to scale. In fact, the dimensions of the various structures may be arbitrarily increased or reduced for clarity of discussion.
FIG. **1** shows a semiconductor COWOS structure, according to a comparative embodiment of the present disclosure.
FIGS. **2A** to **2C** show cross-sectional views of structures in different stages of a method of manufacturing an integrated circuit (IC) structure, in accordance with some embodiments of the present disclosure.
FIG. **2D** shows a perspective view of a redistribution layer, in accordance with various embodiments of the present disclosure.
FIGS. **2E** and **2F** show cross-sectional views of an IC structure, in accordance with various embodiments of the present disclosure.
FIG. **2G** shows a cross-sectional view of a redistribution layer of the IC structure shown in FIGS. **2B, 2C****,** **2E** and **2F****,** in accordance with various embodiments of the present disclosure.
FIGS. **3A** to **3D** show cross-sectional views of structures in different stages of a method of manufacturing an IC structure, in accordance with some embodiments of the present disclosure.
FIGS. **3E** and **3F** show cross-sectional views of an IC structure, in accordance with various embodiments of the present disclosure.
FIGS. **4A** to **4G** show cross-sectional views of structures in different stages of a method of manufacturing an IC structure, in accordance with some embodiments of the present disclosure.
FIGS. **4H** to **4N** show cross-sectional views of an IC structure, in accordance with various embodiments of the present disclosure.
FIGS. **5A** and **5B** show cross-sectional views of an IC structure, in accordance with various embodiments of the present disclosure.
FIG. **5C** shows a cross-sectional view of an interconnect structure of the IC structure shown in FIGS. **5A** and **5B****,** in accordance with various embodiments of the present disclosure.
FIGS. **6A** to **6E** show cross-sectional views of structures in different stages of a method of manufacturing a semiconductor package, in accordance with various embodiments of the present disclosure.
FIGS. **7A** to **7H** show cross-sectional views of structures in different stages of a method of manufacturing a semiconductor package, in accordance with various embodiments of the present disclosure.
FIGS. **7I** and **7J** show cross-sectional views of semiconductor packages, in accordance with various embodiments of the present disclosure.
FIGS. **8A** and **8B** show a perspective view and a cross-sectional view, respectively, of a memory die with multiple edge pads, according to some embodiments of the present disclosure.
FIGS. **8C** shows a cross-sectional view of a semiconductor wafer containing memory dice with multiple edge pads, according to some embodiments of the present disclosure.
FIGS. **8D** and **8E** show cross-sectional views of another memory die with multiple edge pads, according to some embodiments of the present disclosure.
FIG. **9A** shows a perspective view of a conventional high-bandwidth memory (HBM) structure.
FIG. **9B** shows a perspective view of a new high-bandwidth memory (NuHBM) stack or shelf, according to some embodiments of the present disclosure.
FIGS. **10A** and **10B** respectively show an exemplary layout 40a and a specification table for low power double data rate 5 (LPDDR5) memory, according to some embodiments of the present disclosure.
FIG. **11** shows cross-sectional views of intermediate stages of forming a NuHBM stack or shelf, according to some embodiments of the present disclosure.
FIGS. **12A to 12C** show an IC structure with NuHBM shelf, according to some embodiments of the present disclosure.
FIGS. **13A** and **13B** show another IC structure with NuHBM shelf, according to some embodiments of the present disclosure.
FIGS. **14A** and **14B** show another IC structure with NuHBM shelf, according to some embodiments of the present disclosure.
FIGS. **15A** and **15B** show another IC structure with multiple NuHBM shelfs, according to some embodiments of the present disclosure.
FIG. **16** shows another IC structure with multiple NuHBM shelfs, according to some embodiments of the present disclosure.
FIGS. **17A** and **17B** show cross-sectional views of a semiconductor package assembly, in accordance with various embodiments of the present disclosure.

### DETAILED DESCRIPTION

The following disclosure provides many different embodiments, or examples, for implementing different features of the provided subject matter. Specific examples of elements and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper," "on" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, although the terms such as "first," "second" and "third" describe various elements, components, regions, layers and/or sections, these elements, components, regions, layers and/or sections should not be limited by these terms. These terms may be only used to distinguish one element, component, region, layer or section from another. The terms such as "first," "second" and "third" when used herein do not imply a sequence or order unless clearly indicated by the context.

Embodiments of the present invention disclose methodologies, processes and structures to create redistribution layers (RDL) and interconnects (e.g., through-silicon vias, through-mold vias, metal vias, metal pads for copper hybrid bonding, and micro-bumps or solder bumps for flip-chip assembly) on four side surfaces of 3D ICs and short 3D IC structure stacks (detailed descriptions of which are provided below), wherein each stacked layer consists of one or more ICs in an x-y direction (in-plane direction) and a z direction (out-of-plane direction or IC thickness direction).

Embodiments of the package structures proposed in the present disclosure allow for at least the following features: (a) five-sided power and signal distribution (through a front-side and four side faces of the 3D IC package); (b) skip-die and multi-sided interconnection (e.g., from a bottom die or a substrate such as an interposer directly to a top die and other ICs in the stack) through the four side faces and/or interior interconnections using combinations of RDLs, TSVs and through mold vias (TMVs); (c) RDLs on side surfaces to be interconnected in three dimensions through use of bendable flexible printed circuits (flexes); and (d) ability to use various interconnection technologies covering RDLs, TSVs, micro-bumps, solder bumps, copper hybrid bonds and fine-pitch Flexes. Therefore, the proposed package structures can effectively reduce lengths of global and IC packaging interconnect routes and increase a number of transistors visited within one clock cycle.

In this invention, the side face(s) of memory dies are used for interconnecting dies in the 2.5D/3D IC stack to allow for skip-die signals and power distribution. Moreover, the high thermal conductivity material is disposed between two adjacent memory dies and thermally coupled to another high thermal conductivity material covering other side face of memory dies stack.

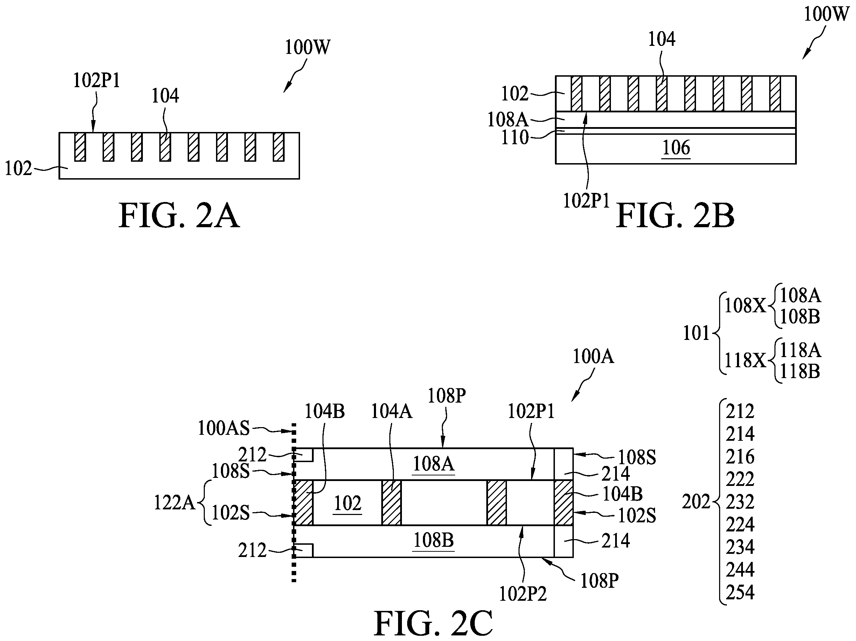

FIGS. 2A to 2C show cross-sectional views of structures in different stages of a method of manufacturing an IC structure **100A,** in accordance with some embodiments of the present disclosure. According to some embodiments, the IC structure **100A** shown in FIG. 2C is a semiconductor package device. The IC structure **100A** may be formed from a semiconductor device **100W,** which is a wafer-level device, wherein the IC structure **100A** is formed by separating the semiconductor device **100W** using a singulation or dicing process covering mechanical dicing, laser dicing, plasma etching or dicing, dry etching, wet etching (e.g., with an acid etch), the like, or a combination thereof.

Referring to FIG. 2A, the semiconductor device **100W** is received or provided. Initially, a substrate 102 is provided or received. According to some embodiments, the substrate 102 is formed of a semiconductor material such as bulk silicon. According to some embodiments, the substrate 102 is formed of other semiconductor materials, such as silicon germanium, silicon carbide, gallium arsenide, or the like. In the present embodiment, the substrate **102** is a P-type semiconductive substrate (acceptor type). In some other embodiments, an N-type semiconductive substrate (donor type) can be used. Alternatively, the substrate **102** includes another elementary semiconductor, such as germanium; a compound semiconductor including gallium arsenic, gallium phosphide, indium phosphide, indium arsenide, or indium antimonide; an alloy semiconductor including SiGe, GaAsP, AlInAs, AlGaAs, GaInAs, GaInP, or GaInAsP; or a combination thereof. In yet another embodiment, the substrate **102** includes portions to form a semiconductor-on-insulator (SOI) substrate. In other embodiment, the substrate **102** may include a doped epitaxial layer, a gradient semiconductor layer, and/or a semiconductor layer overlaying another semiconductor layer of a different type, such as a silicon layer on a silicon germanium layer.

A plurality of conductive vias **104** are formed in the substrate **102.** The conductive vias **104** may extend from a primary surface **102P1** of the substrate **102** to a thickness of the substrate **102.** Throughout the present disclosure, "primary surface" is used to indicate an upper surface or a bottom surface of a circuit or a device, which has a greatest surface area among six surfaces of a device or a layer. Similarly, "secondary surface" is used to indicate a lateral side surface of a circuit or a device (there are often four such side surfaces of the circuit or device), which has a surface area less than the surface area of the primary surface. The conductive vias **104** may include conductive materials, such as copper, tungsten, molybdenum, cobalt, ruthenium, titanium, tantalum, aluminum, silver, gold, or other suitable materials. The conductive vias **104** may include a single layer, or multilayer structure which can include a diffusion barrier layer, a seed layer to aid in electroplating, a filling layer, a combination thereof, or the like.

In an exemplary forming process of the conductive vias **104,** a plurality of holes (not shown) are formed on the primary surface **102P1** of the substrate **102.** The holes may be formed using a dry etch (e.g., a reactive ion etch, RIE), a wet etch, a combination thereof, or the like. Following hole opening, a deposition process, e.g., plasma enhanced chemical vapor deposition (PECVD), can be used to deposit silicon dioxide to passivate the hole openings and physical vapor deposition (PVD), sputter deposition, atomic layer deposition (ALD), or other suitable deposition operations is performed to deposit the materials of the conductive vias **104** in the holes and over the primary surface **102P1.** The conductive vias **104** may be referred to herein as through-silicon vias (TSV) after the hole filling process.

According to some embodiments, a planarization process, e.g., chemical mechanical planarization (CMP), dry etching (e.g., using RIE), grinding, wet etching and/or other suitable etching operations is performed to remove excess conductive materials and planarize upper surfaces of the conductive vias **104** which are flush with the primary surface **102P1.** Following planarization, a primary RDL **108A** is deposited on the primary surface **102P1** with surface finish and pads for subsequent bonding as needed.

Referring to FIG. **2B****,** another substrate or a temporary carrier **106** is provided or received and the semiconductor structure **100W** is bonded to the temporary carrier **106.** According to some embodiments, the substrate **106** is a carrier substrate or a supporting substrate. The carrier substrate **106** may be formed of glass, silicon, ceramics, or other suitable carrier materials. A release layer **110** is formed over the carrier substrate **106.** Examples of the release layer include release/adhesion layers commonly used in fan-out processes. The release layer **110** is an temporary layer formed over the carrier substrate **106** and can allow for easier removal of the carrier substrate **106** from the semiconductor device **100W** by laser irradiation, thermos-mechanical release, grinding, CMP, dry or wet etching/cleaning, or a combination thereof.

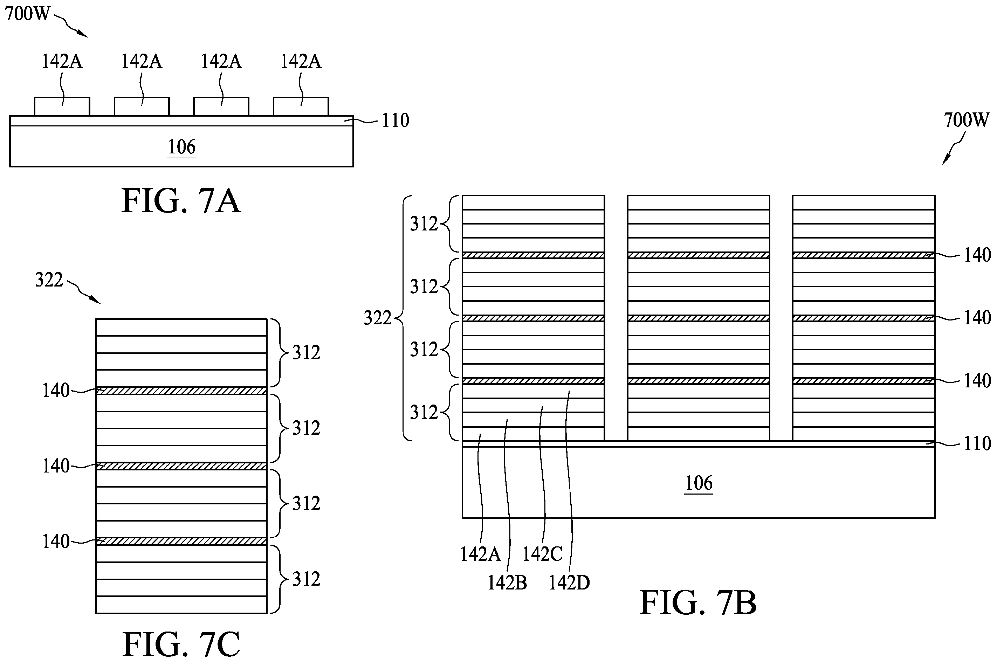

Besides the release layers used in fan-out processing, the release layer can also be a combination of Ti (titanium)/Au (gold) on the carrier and Ti/Au on the backside of an IC structure. Au here can also be Cu (copper) or a solder on both surfaces. Compression or reflow bonding can be used to achieve bonding of the carrier and the IC structure. Annealing is optional and can be done on an as-needed basis. When silicon is used as the carrier, the release layer can be SiO₂, Si₃N₄ and others that are common in wafer BEOL and/or MEMS/NEMS processing. The release layers as such may also serve as the permanent bonding layers between IC structures (such as those shown in FIG. **7B**).

Pre-bonding conditioning of the carrier and the IC structure surfaces can involve:
- Chemical mechanical polish (CMP) to achieve, preferably a surface roughness, RA (arithmetic average roughness or sometimes root mean square roughness) < 1 nm for both diamond and silicon when needed. This level of RA can be achieved by CMP for silicon, and by a combination of sacrificial SiO₂ layer deposition, and SiO₂ planarization by CMP and deep reactive ion etching (DRIE) for diamond,
- Wet surface pre-treatments involving ultrasonic de-ionized (DI) water clean, H₂SO₄/H₂O₂ treatment, NH₃/H₂O₂ treatment, and N₂ blow dry
- Plasma/inductively coupled plasma reactive ion etching (ICP-RIE): O₂, H₂/O₂,
- Deep RIE (DRIE): O₂/CF₄, and
- Activation of the bonding surfaces (with and/or without the glue layers) inside bonding machines prior to bonding by a fast atom beam gun, FAB (using, for instance, argon neutral atom beam at ~1 keV), or by an ion gun (using for instance, argon ion at ~60 eV) to remove oxide films in vacuum and to reveal dangling bonds at the surfaces for bonding.
- (Note 1: FAB works well for (sputtered) Si/Si, Si/SiO₂, metals, compound semiconductors and single crystal oxides, while ion guns is known to work for SiO₂/SiO₂, Glass, Si₃N₄ (silicon nitride)/Si₃N₄, Si/Si, Si/SiO₂, metals, compound semiconductor, and single crystal oxides.)
- (Note 2: A vacuum of 10⁻⁶ Pa (pascal) is required during bonding to prevent re-adsorption to activated bonding surfaces.)

Besides the aforementioned direct bonding approaches, an ultrathin glue or bonding layer such as CVD poly- silicon (poly-Si) can be deposited on the mating IC structures (FIG. **7B**) as a permanent bonding layer or on both the IC structure and the carrier as a temporary release layer to achieve high low-temperature direct bonding yield. For heat sensitive applications, poly-Si (whose thermal conductivity, TC, is more than 100 times that of SiO₂) is preferred over SiO₂ for use to create the thin bonding layers in terms of minimizing the thermal resistivity impact to the final IC or package structure. Glue layers are typically ultrathin, around 100 nm or less than 100 nm, to minimize their thermal impacts. When used as a permanent layer, higher-TC and lower-thermal expansion materials are preferred. Glue layer candidates include the following and their combinations (or alloys):
- Non-metals: Si (e.g., poly-silicon), SiO₂, Si₃N₄, Al₂O3₃ (alumina), diamond, boron nitride, graphene
- Metals: Ti, W, Pt, Cr, Au, Cu, Ir, nickel (Ni), iron (Fe), Ag-In, Au-In, Ag, Sn, Mo
- Metal-on-oxides: Ir on SrTiO₃, Ir on YSZ/Si, Ir on MgO, sapphire or TaO₃

When metallic glue layers are used for bonding the IC structures (see, for instance, FIG. **7B**), it is advisable to deposit a barrier layer such as Ti on the backside of the IC structures prior to glue layer deposition to prevent metal diffusion in silicon lattices which can poison the devices. This is particularly true for ultrathin ICs. Diamond growth on silicon seed is a common practice during diamond CVD. Silicon nitride (Si₃N₄) is common in wafer BEOL processing. Alumina can be deposited by atom layer deposition. When it comes to extreme thermal conductivity, graphene is another material worth considering besides diamond. In monolayer, graphene can have a thermal conductivity of 30 - 50 W/cm.K. It can be considered as a glue or bonding layer assuming proper 3D molecular structures. Graphene can be grown on the silicon

(100) surface using a direct cobalt-assisted two-step ion beam synthesis. It can also be grown on silicon through a simple transfer-free synthesis method. Epitaxial graphene can be grown on crystalline and semi-insulating surface (e.g., SiC and silicon), and graphene nanostructures with exceptional properties have been realized by a selective growth process on SiC surface. In addition to diamond and graphene, boron nitride merits attention with cubic boron nitride in particular as it is known to have a similar crystalline structure to diamond and a high in-plane TC (~ 16 W/cm.K). Furthermore, the glue layer can be a combination of Ti/Au on one IC structure and Ti/Au on the backside of another IC structure for bonding. Prior to Au deposition and as needed, thin metallization based on Ti, W or Cr can also be deposited. Thin layers of transient liquid bonding materials such as silver-indium (Ag-In) and Au-In, sintered Ag, In, Au or Cu can also be applied with matching metallization (e.g., Au, Ag or Cu). Glue layers can be deposited by CVD, atomic layer deposition (ALD), physical vapor deposition, thermal oxidation (in the case of silicon) or other means. Following deposition, glue layers can be conditioned through a combination of the aforementioned pre-bonding surface pre-treatments, DRIE (e.g., using a mixture of SF₆ and O₂), plasma/ICP-RIE (using O₂, Ar, N₂, Ar/O₂), and FAB (using, e.g., Ar neutral atom) or ion gun (using, e.g., Ar ion) in bonding stations.

Following the creation of the primary RDL **108A,** the planarized structure with the primary RDL **108A** is bonded to the substrate **106** with the help of the release layer through-and the bulk portion of the substrate **102** underlying the conductive vias **104** is removed to expose bottom surfaces of the conductive vias **104** (see FIG. **2B**). Another RDL **108B** can then be deposited on the revealed conductive vias **104** in FIG. **2B****,** complete with surface finish and solder bumps or micro-bumps as needed. Following the formation of the RDL **108B,** mounting of the resultant structure with the RDL **108A** and **108B** on the carrier **106** on a wafer mount tape frame, release of the carrier 106, and singulation of the individual packages, the semiconductor structure **100A** in FIG. **2C** is formed.

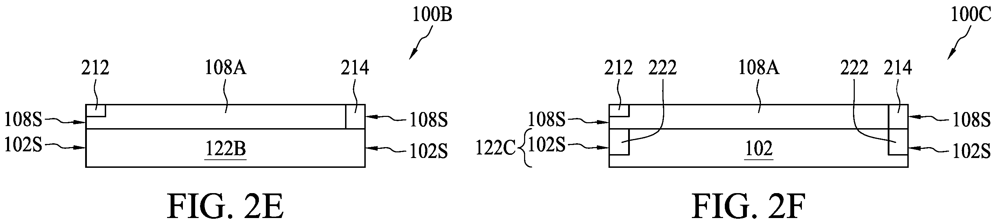

Based on the processes shown in FIGS. **2A** to **2C****,** various layers, and structures can be formed to create the semiconductor structure **100A** containing exposed edge pads, edge vias and edge TSVs which can go all the way or partially through the thickness of the silicon or the potting material, or its subset, for instance, a structure containing only the RDL **108A** with edge pad/via interconnections in the RDL (FIG. **2E**), or a structure containing both the RDL **108A** with edge interconnections and edge TSVs (see FIG. **2F**).

According to some embodiments, the release layer **110** includes a polymer-based material. According to some embodiments, the release layer **110** is an epoxy-based thermal release material, such as a light-to-heat-conversion (LTHC) release coating, which loses its adhesive property when heated or exposed to a laser. According to other embodiments, the release layer **110** is an ultraviolet (UV) glue, which loses its adhesive property when exposed to UV light. The release layer **110** may be thermoplastic or thermoset material. According to some embodiments, the release layer **110** includes polyimide or silicone-based materials. According to some other embodiments, the release layer **110** is a mixture of metal and non-metal materials. Metal candidates of the release layer can include nickel, chromium, titanium, gold, copper, manganese, iron, cobalt, tungsten, molybdenum, ruthenium, and tantalum, whereas non-metal candidates can include oxides, nitrides, phosphates and chromates of the metals. The release layer **110** may be disposed by spin-coating as a liquid and cured. In other embodiments, the release layer **110** may be a laminate film laminated on the carrier substrate **106.** In yet some other embodiments, bonding between the substrate **102** and the temporary carrier **106** can be achieved by direct bonding based on, for instance, oxide-to-oxide or polyimide-to-polyimide without needing the release layer **110.**

The RDL **108A** is part of an interconnect structure **101** of the IC structure **100A.** The RDL **108A** includes one or more interconnected conduction paths formed through one or more conductive lines in conductive line layers and one or more conductive vias in conductive via layers (not separately shown) to route power and signals of a first circuit from one side of the RDL **108A** to a second circuit on the same side or on an opposite side of the RDL **108A.** The RDL **108A** may include an encapsulating material (or an encapsulant such as a polyimide or an oxide layer to facilitate direct or copper hybrid bonding) encapsulating the conductive line layers and the conductive via layers. According to some embodiments, the encapsulating material includes one or more dielectric materials, e.g., silicon oxide, silicon nitride, silicon carbide, silicon oxynitride, polyimide, a combination thereof, or the like. Due to use of the RDL **108A** of the interconnect structure **101,** distribution of signals and power of devices or circuits in the IC structure **100A** can meet design requirements. Throughout the present disclosure, an RDL, e.g., the RDL **108A,** which is formed on a primary surface, e.g., the primary surface **102P1,** of a circuit or a device is referred to as a primary RDL **108A.** More structural details of the primary RDL **108A** are discussed below.

According to some embodiments, the substrate **102** is arranged over and bonded to the primary RDL **108A.** The bonding of the substrate **102** to the primary RDL **108A** may be performed using thermal bonding, thermos-compression bonding, flip-chip bonding, hybrid bonding, or the like. Although not illustrated, the conductive vias **104** of the substrate **102** are electrically coupled to one of the conductive lines or one of the conductive vias of the primary RDL **108A** to extend a signal-delivery network or a power-delivery network of the RDL **108A.** Further, an upper portion of the substrate **102** is removed or thinned from a top portion of the substrate **102.** The bottom surfaces of the conductive vias **104** are exposed accordingly. The removal or thinning of the upper portion of the substrate **102** may be performed using CMP, grinding, a dry etch (e.g., RIE), a wet etch, or the like. The conductive vias **104** then become the TSVs **104** accordingly.

Referring to FIG. 2C, a singulation or dicing process is performed to separate the semiconductor device **100W** into individual IC structures **100A** following mounting of the structure with RDL **108A** and RDL **108B** on a wafer mount frame, and release of the carrier **106.** The singulation or dicing process may be performed using a diamond blade, a laser, a plasma with a masking layer deposited on, for instance, the RDL **108A,** wet etching or a combination thereof to singulate the semiconductor devices **100W** along scribe lines to form the individual IC structures **100A.** The interconnect structure **101** in the IC structure **100A** comprises the TSV die **122A,** an interior interconnect structure **108X** such as interior pads and vias in the RDLs **108A, 108B,** and an edge interconnect structure **118X** such as edge pads and vias in the RDLs.

During singulation or dicing, the areas that are cut away are called dicing, saw or die streets and they are typically between 50 µm to 100 µm wide. Dicing saw may use a diamond blade which rotates at 30,000 rounds per minute and is cooled with de-ionized water. To reveal the edge pads or vias, it is preferable that the sizes of the edge pads or vias are comparable to the dicing street width and dicing is carried out in immediate vicinity of the edge pads or vias (but not directly through the edge pads or vias), followed by light wet etching of the silicon as needed and warranted. To minimize bottom side chipping during mechanical blade dicing, it can be advantageous to dice the wafer first with the carrier support, followed by carrier release. Laser ablation dicing which can enable a dicing street width of 10 µm can also be used first to remove the fine wire layer on the dicing street's surface (and expose the edge pads adjacent to it) using a non-contact laser, followed by cutting the residual substrate with laser scribing and/or blade dicing. This process reduces problems like chipping, die cracking, and layer peeling. In laser ablation dicing, the laser heats the material to such a temperature that the area under the laser spot is ablated or simply vaporized. Alternatively, dicing can be carried out by stealth dicing which is dry and does not require liquid. Stealth dicing works as a two-stage process in which a laser beam (e.g., a pulsed Nd:YAG laser at the 1064 nm wavelength for silicon) is first directed to scan along intended cut lines to create defect regions and then an underlying membrane film (which is attached to wafer, followed by wafer carrier release) is expanded to induce fracture. Stealth laser dicing has the potential to replace blade dicing as a next generation ultrathin wafer singulation technology in support of 3D IC packaging as stealth laser allows for faster cutting, higher accuracy, less damage, and a smaller dicing street width. In comparison with mechanical and laser dicing, plasma dicing (also known as deep reactive ion etching) is a relatively new method of applying the Bosch dry etch process that can render the dies particle- and contamination-free with high-precision cuts. This method requires a custom mask design for effective plasma dicing. It etches all narrow dicing streets at the same time into the wafer using a plasma gas such as sulfur hexafluoride, resulting in high precision, throughputs and quality. Plasma dicing can produce cuts that are non-rectangular in shape, which is beyond the reach of blade dicing. Plasma dicing causes minimal damage to the wafer surface or trench sidewall, resulting in better die strengths, improved device reliability, and longer device life. Plasma dicing is fast gaining popularity within the semiconductor industry as the preferred solution, particularly as chips become smaller, thinner and more complex.

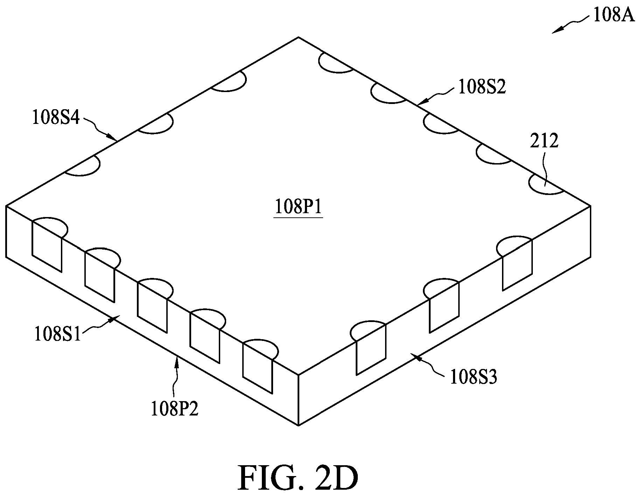

As a result of the singulation or dicing process, the IC structure **100A** includes four secondary planes or side planes **100AS,** although FIG. **2D** only illustrates two secondary planes **100AS.** The TSV die **122A** includes side surfaces **102S** on its four sides, while the primary RDL **108A** and the primary RDL **108B** include side surfaces **108S** on their four sides. The side surface **102S** of the TSV die **122A** and the side surfaces **108S** of the two primary RDLs, **108A,** and **108B,** together constitute or coincide with the secondary plane **100AS** of the IC structure **100A.** Through appropriate arrangement, the TSVs **104** are formed in the TSV die **122A** and comprise two TSV types after the singulation or dicing process: interior TSVs **104A** and edge TSVs **104B,** wherein the interior TSV **104A** is fully surrounded by the substrate **102** and the primary RDLs **108A** and **108B,** while the edge TSV **104B** has at least one side surface exposed through the side surfaces **102S** of the substrate **102.**

Similarly, the primary RDL **108A** or **108B** includes conductive pads **212** and conductive vias **214,** formed from conductive elements **202** such as the conductive lines and the conductive vias, respectively, wherein the conductive elements **202** comprise two parts: interior conductive elements **202** and edge conductive elements **202.** Through appropriate arrangement, the conductive pads **212** and the conductive vias **214** are formed in the IC structure **100A** and comprise two parts after the singulation or dicing processes: interior conductive pads/vias, **212** and **214,** and edge conductive pads/vias, **212** and **214,** in which the interior conductive pads/vias, **212** and **214,** are fully surrounded by the substrate material and the encapsulating material of the two primary RDLs, **108A** and **108B,** while the edge conductive pads/vias **212, 214** have at least one side surface exposed through the side surfaces **108S** of the primary RDL, **108A** or **108B.**

According to some embodiments, the edge conductive pads **212** have at least one upper surface exposed through a primary surface **108P** of the primary RDL **108A** or **108B.** The interior or edge conductive pads **212** may be arranged on a topmost conductive line layer of the respective primary RDL **108A** or **108B,** which is most distal to the TSV die **122A.** According to some embodiments, the conductive pads **212** are arranged parallel to the primary surface **108P** of the primary RDL **108A** or **108B.** The conductive pads **212** may stop short of the TSV die **122A.** Further, the edge conductive pads **212** have at least one side surface exposed through the secondary plane **100AS** of the IC structure **100A** or the secondary surface **108S** of the primary RDL **108A** or **108B.**

Likewise, according to some embodiments, the edge conductive vias **214** have at least one upper surface exposed through the primary surface **108P** of the primary RDL **108A** or **108B.** The edge conductive vias **214** may be arranged to extend through a thickness (in a z-direction) of the respective primary RDL **108A** or **108B.** According to some embodiments, the edge conductive vias **214** are referred to herein as the TSVs of the primary RDL **108A or 108B.** Further, the edge conductive vias **214** have at least one side surface exposed through the secondary plane **100AS** of the IC structure **100A** or the secondary surface **108S** of the primary RDL **108A** or **108B.**

FIG. **2D** shows a perspective view of the primary RDL **108A** or **108B,** in accordance with various embodiments of the present disclosure. The primary RDL **108A** or **108B** includes primary surfaces **108P,** e.g., an upper primary surface **108P1** and a lower primary surface **108P2,** and four secondary (side) surfaces **108S,** e.g., a front secondary surface **108S1,** a rear secondary surface **108S2,** a right secondary surface **108S3** and a left secondary surface **108S4.** A plurality of conductive elements **202,** e.g., the conductive pads/vias **212,** are formed on the primary RDL **108A or 108B** and exposed through the four secondary surfaces **108S.** The arrangement of the conductive pads **212** of the primary RDL **108A** or **108B** in FIG. **2D** is shown for illustrative purposes. The conductive pad **212** or other conductive elements can be formed or exposed through one or more of the four secondary surfaces **108S.**

As discussed above, throughout the present disclosure, the TSVs **104** (see **104A** and **104B** in FIG. **2C**), the conductive pads **212,** the conductive vias **214** and all other conductive members of the interconnect structure **101** in FIG. **2C** are part of what are collectively referred to as the conductive elements **202** in the interconnect structure **101** of the IC structure **100A.** The TSVs **104,** the conductive pads **212** and the conductive vias **214** are configured to form at least part of the interconnect structure **101** of the IC structure **100A** for fan-in or fan-out interconnections for devices or package layers to be electrically coupled to the IC structure **100A** through the two primary surfaces **108P** in FIG. **2C** (i.e., the upper primary surface **108P1** and the lower primary surface **108P2;** see FIG. **2D**) of the IC structure **100A,** as well as through the four secondary surfaces, 108S1 through **108S4** (see FIG. **2D**), of the IC structure **100A.** According to some embodiments, the TSVs **104** and the conductive vias **214** of the primary RDLs **108A** and **108B** can be coupled to form a collective TSV of the IC structure **100A.** For example, the right-side edge conductive via **214** (FIG. **2C**) of the primary RDL **108A,** the right-side edge TSV **104** and the right-side edge conductive via **214** of the primary RDL **108B** constitute a stacked edge TSV of the IC structure **100A** to extend through the substrate thickness of the IC structure **100A.**

FIG. **2E** shows a cross-sectional view of an IC structure **100B,** in accordance with various embodiments of the present disclosure. The IC structure **100B** is similar to the IC structure **100A** in many aspects, e.g., the primary RDL **108A,** the conductive pad **212** and the conductive via **214,** and therefore details of such similar aspects are not repeated for brevity. A main difference between the IC structure **100A** and the IC structure **100B** is that the TSV die **122A** of the IC structure **100A** is replaced with a semiconductor die **122B** in the IC structure **100B,** and the primary RDL **108B** in the IC structure **100A** is absent from the IC structure **100B.** According to some embodiments, the semiconductor die **122B** can be at least one of a CPU die, a GPU die, a TPU die, a MEMS die, an AP die, an FPGA die, an ASIC die, a memory die, a transceiver die, a network interface die, an integrated photonics die, a packet buffer/router die or another suitable die. The semiconductor die **122B** may include a substrate **102** comprising a material similar to that of the substrate **102** of the IC structure **100A** shown in FIG. **2D****.** The semiconductor die **122B** therefore constitutes a substrate or body of the IC structure **100B.** According to some embodiments, the semiconductor die **122B** does not include any edge interconnect structure **118X** exposed through the side surfaces **102S** of the semiconductor die **122B.**

FIG. **2F** shows a cross-sectional view of an IC structure **100C,** in accordance with various embodiments of the present disclosure. The IC structure **100C** is similar to the IC structure **100B** in many aspects, e.g., the primary RDL **108A,** the conductive pad **212,** and the conductive via **214,** and therefore details of such similar aspects are not repeated for brevity. Further, the IC structure **100C** includes a semiconductor die **122C,** which can be at least one of a CPU die, a GPU die, a TPU die, a MEMS die, an AP die, an FPGA die, an ASIC die, a memory die, a transceiver die, a network interface die, an integrated photonics die, a packet buffer/router die or another suitable die. The semiconductor die **122C** may include a substrate **102** similar to the substrate **102** of the IC structure **100A** shown in FIG. **2D****.** A main difference between the semiconductor die **122C** and the semiconductor die **122B** is that the semiconductor die **122C** further includes an edge interconnect structure **118X,** e.g., edge conductive pads **222,** exposed through the secondary planes or side surfaces **102S** of the semiconductor die **122C.** According to some embodiments, an edge conductive pad **222** is electrically connected to the conductive via **214** of the primary RDL **108A** for establishing a stacked conductive via for the semiconductor die **122C.** The semiconductor die **122C** therefore constitutes a body of the IC structure **100C.**

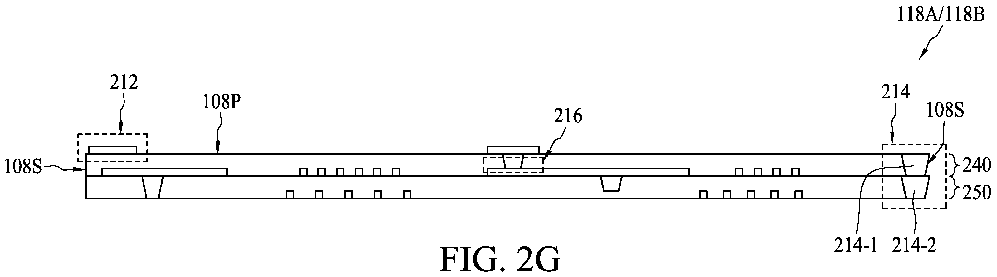

FIG. **2G** shows a cross-sectional view of a primary RDL **108A** or **108B** of the IC structure **100A, 100B** or **100C** shown in FIGS. **2B** to **2F****,** in accordance with various embodiments of the present disclosure. As illustrated in FIG. **2G****,** the primary RDL **108A** or **108B** is formed of a first major conductive line/via layer **240** and a second major conductive line/via layer **250** under the first major conductive line/via layer **240.** Each of the first major conductive line/via layer **240** and the second major conductive line/via layer **250** includes one or more conductive lines and conductive vias (all of which are part of the collective conductive elements **202** of the interconnect structure **101** in the primary RDL **108A** or **108B**) extending in a horizontal or vertical direction. The conductive lines or vias are electrically insulated by a dielectric layer, referred to as an inter-metal dielectric (IMD) layer. The IMD layer may include one or more dielectric materials, such as silicon oxide, silicon nitride, silicon oxynitride, silicon carbide, polyimide, or other suitable dielectric materials. Some of the conductive vias in the first major conductive line/via layer **240** extend half-way in the vertical direction, while some of the conductive vias, e.g., a conductive via **214-1,** in the first major conductive line/via layer **240,** extend through an entire thickness of the first major conductive line/via layer **240.** Similarly, some of the conductive vias in the second major conductive line/via layer **250** extend halfway in the vertical direction, while some of the conductive vias, e.g., a conductive via **214-2,** in the second major conductive line/via layer **250,** extend through a thickness of the second major conductive line/via layer **250.** The conductive vias **214-1** and **214-2** are electrically connected to form a stacked conductive via **214** of the primary RDL **108A** or **108B** traversing the primary RDL **108A** or **108B.** According to some embodiments, the first major conductive line/via layer **240** includes two conductive line layers and a conductive via layer between the two conductive line layers, wherein a conductive via **216** is arranged in the conductive via layer to electrically connect two conductive lines in the adjacent conductive line layers, Referring to FIG. **2F** and FIG. **2G****,** the conductive via **214** of the IC structure **100C** shown in FIG. **2F** is considered a conductive via connecting the adjacent first and second major conductive line/via layers, **240** and **250.** According to some embodiments, the stacked conductive via **214** is part of the edge interconnect structure **118X** and is exposed through a secondary surface **108S** of the primary RDL **108A or 108B.** Although FIG. **2G** illustrates only two major conductive line/via layers, **240** and **250,** the present disclosure is not limited thereto. Other numbers of major conductive line/via layers and configurations of conductive lines or conductive vias in each major conductive line/via layer are also within the contemplated scope of the present disclosure.

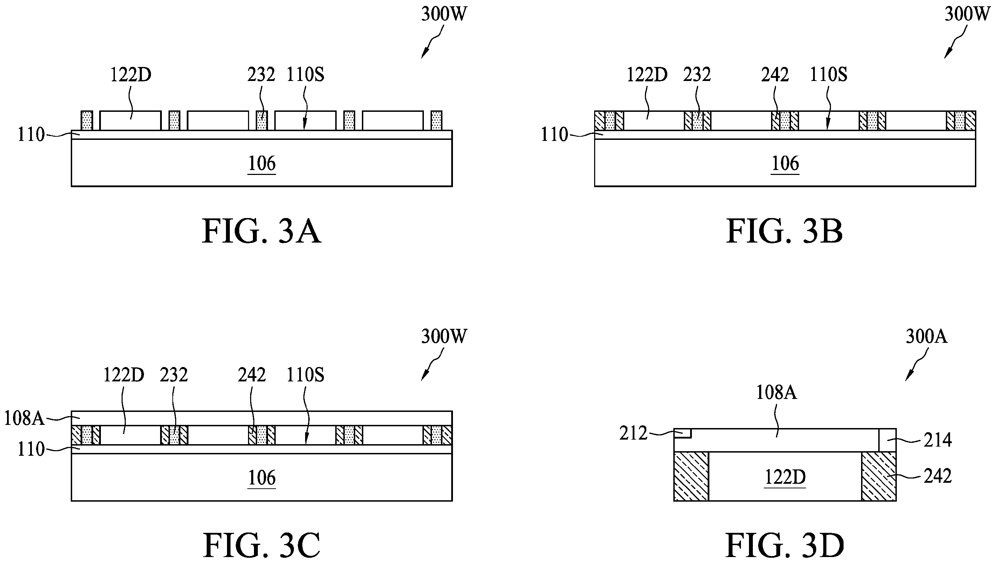

FIGS. **3A** to **3D** show cross-sectional views of structures in different stages of a method of manufacturing an IC structure **300A,** in accordance with some embodiments of the present disclosure. According to some embodiments, the IC structure **300A** shown in FIG. **3D** is a semiconductor package device. The IC structure **300A** may be formed from a semiconductor device **300W,** which is a wafer-level device, wherein the IC structure **300A** is formed by separating the semiconductor device **300W** using a singulation or dicing process.

Referring to FIG. **3A****,** the carrier substrate **106** is received or provided. Further, the release layer **110** is formed over the carrier substrate **106** as in the case of FIGS. **2A** to **2C****.** A plurality of semiconductor dies **122D** are arranged over the release layer **110.** The semiconductor die **122D** may include at least one of a CPU die, a GPU die, a TPU die, a MEMS die, an AP die, an FPGA die, an ASIC die, a memory die, a transceiver die, a network interface die, an integrated photonics die, a packet buffer/router die or another suitable die. Further, a plurality of conductive pillars or vias **232** are created over the release layer **110** in between adjacent semiconductor dies **122D** with suitable pitches and are encapsulated by a molding compound or a suitable potting material (such as an epoxy, for instance, Epotek **377**) as shown in FIG. **3B****.** The conductive vias **232** may be alternately created in the semiconductor dies **122D.** The plurality of semiconductor dies **122D** and the conductive vias (pillars) **232** are referred to herein as a reconstituted structure and arranged on a carrier surface **110S** of the release layer **110** or the carrier substrate **106.** The conductive vias **232** may include a conductive material, e.g., tungsten, copper, titanium, tantalum, molybdenum, ruthenium, cobalt, aluminum, silver, gold, or another suitable material. The plurality of semiconductor dies **122D** and the conductive vias **232** may have substantially equal heights. According to some embodiments, the semiconductor dies **122D** and the conductive vias **232** are arranged over the release layer **110** by a pick-and-place bonding process.

Referring to FIG. **3B****,** the reconstituted structure of the semiconductor device **300W** is molded or encapsulated using a potting material (e.g., an encapsulating material, a molding material or an insulating element) **242.** The potting material **242** may include a dielectric material, such as silicon oxide, silicon nitride, silicon carbide, silicon oxynitride, epoxy-based molding material, a polymeric material, or the like. A molding or a deposition process is performed to deposit the potting material **242** in between the semiconductor dies **122D** and the conductive vias **232** which can be created prior to bonding of the semiconductor dies **122D** and potting material deposition. According to some embodiments, a planarization process, e.g., CMP, grinding, wet etching, a dry etch (e.g., RIE), and/or another suitable etching operation, is performed to remove excess potting material **242** and planarize an upper surface of the potting material **242** revealing the conductive vias **232** from the upper surfaces of the semiconductor dies **122D.** According to some embodiments, since the conductive vias **232** are within and laterally surrounded by the potting material **242,** the conductive vias **232** are also referred to herein as through-molding vias (TMV) **232.**

Referring to FIG. **3C****,** the primary RDL **108A** is formed over the upper surfaces of the potting material **242,** the semiconductor dies **122D** and the TMVs **232.** Materials, configurations and methods of forming the primary RDL **108A** are similar to those described with reference to FIGS. **2B** to **2G****,** and repeated description of the primary RDL **108A** is omitted for brevity.

Referring to FIG. **3D****,** a singulation or dicing process is performed to separate the semiconductor device **300W** into individual IC structures **300A.** Further, the carrier substrate **106** is removed or detached from the semiconductor device **300W** by releasing the release layer **110** from the semiconductor device **300W.** Through appropriate arrangement, the conductive pads/vias **212/214** are formed in the IC structure **300A** and comprise two pad/via types after the singulation or dicing process: interior conductive pads/vias (not separately shown) **212** and edge conductive pads/vias **214.** Properties of the conductive pads/vias **212** and the conductive pads/vias **214** are similar to those of the IC structure **100C** shown in FIG. **2F****,** and repeated description thereof is omitted for brevity. The IC structure **300A** is different from the IC structure **100C** mainly in that in the IC structure **300A,** the semiconductor die **122D** is laterally surrounded or encapsulated by the potting material **242** while in the case of **100C** only the edges of the die and RDLs are exposed. The semiconductor die **122D** and the potting material **242** constitute a body of the IC structure **300A.**

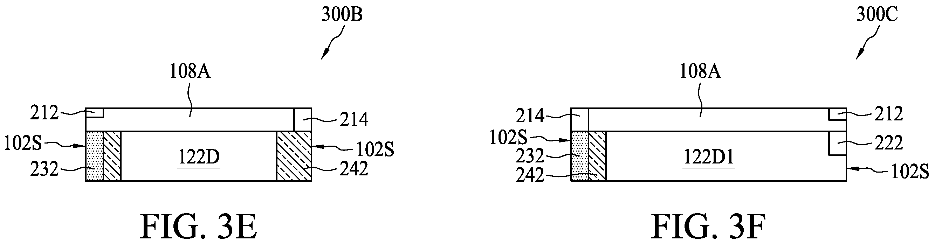

FIG. **3E** shows a cross-sectional view of an IC structure **300B,** in accordance with various embodiments of the present disclosure. The IC structure **300B** is similar to the IC structure **300A** in many aspects, e.g., the primary RDL **108A,** the conductive pad **212** and the conductive via **214,** and therefore details of such similar aspects are not repeated for brevity. A main difference between the IC structure **300A** and the IC structure **300B** is that, in addition to the semiconductor die **122D** and the potting material **242,** a body of the IC structure **300B** further includes an edge TMV **232,** which extends through a thickness of the semiconductor die **122D** or partially through a thickness of the semiconductor die **122D.** The edge TMV **232** is part of the edge interconnect structure **118X.**

FIG. **3F** shows a cross-sectional view of an IC structure **300C,** in accordance with various embodiments of the present disclosure. The IC structure **300C** is similar to the IC structure **300B** in many aspects, e.g., the primary RDL **108A,** the conductive pad **212,** the conductive via **214** and the TMV **232,** and therefore details of such similar aspects are not repeated for brevity. Further, the IC structure **300C** includes a semiconductor die **122D1,** which replaces the semiconductor die **122D** and can be at least one of a CPU die, a GPU die, a TPU die, a MEMS die, an AP die, an FPGA die, an ASIC die, a memory die, a transceiver die, a network interface die, an integrated photonics die, a packet buffer/router die or another suitable die. A main difference between the semiconductor die **122D** and the semiconductor die **122D1** is that the semiconductor die **122D1** further includes a portion of the edge interconnect structure **118X,** e.g., an edge conductive pad **222** exposed through the secondary planes or side surfaces **102S** of the semiconductor die **122D1.** Materials, configuration and a method of forming the edge conductive pad **222** of the IC structure **300C** are similar to those of the conductive via **222** described with reference to FIG. **2F****.** A body of the IC structure **300C** therefore includes the semiconductor die **122D1,** the potting material **242,** the conductive via **222** and the TMV **232.** According to some embodiments, the primary RDL **108A** of the IC structure **300C** includes a conductive via **214** electrically connected to the TMV **232** in the body of the IC structure **300C** for establishing a stacked conductive via for the IC structure **300C.**

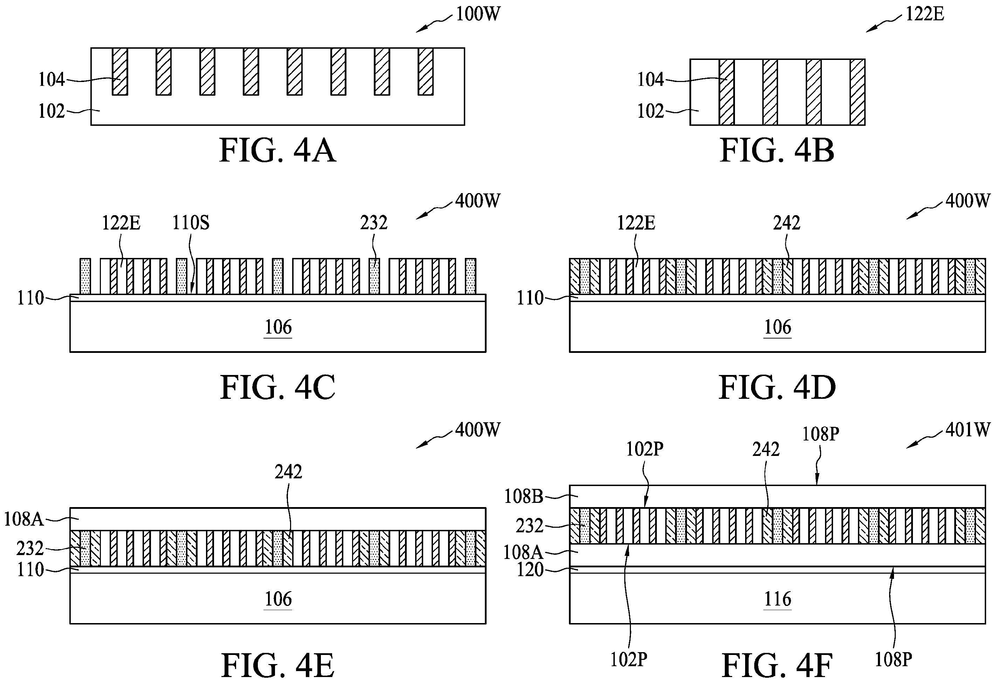

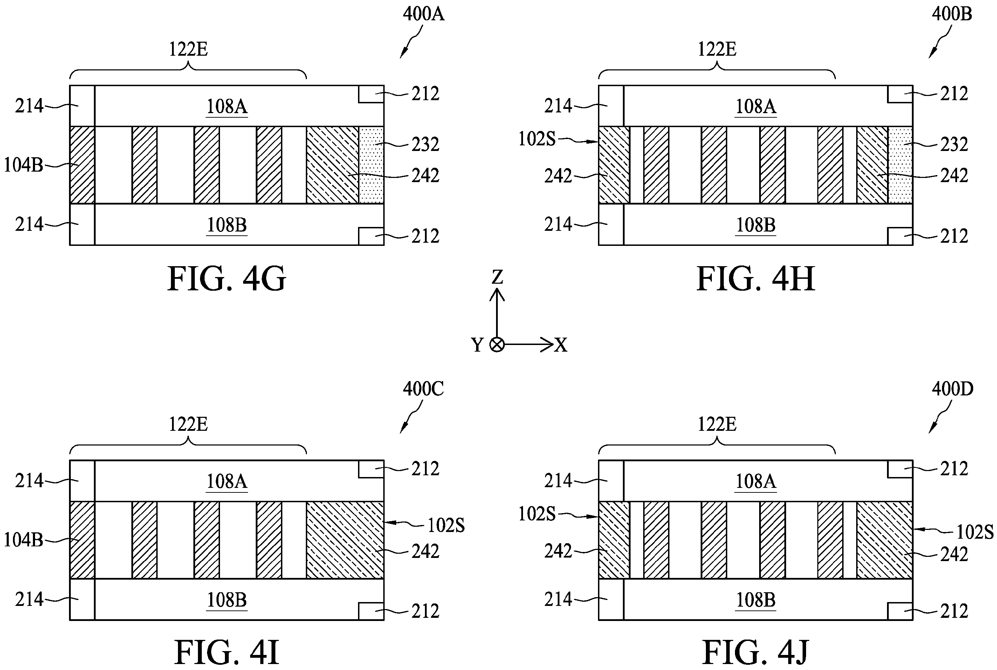

FIGS. **4A** to **4G** show cross-sectional views of structures in different stages of a method of manufacturing an IC structure **400A,** in accordance with some embodiments of the present disclosure. According to some embodiments, the IC structure **400A** shown in FIG. **4G** is a semiconductor package device. The IC structure **400A** may be formed from a semiconductor device **100W** (see FIG. **4A**), which is a wafer-level device, wherein the IC structure **400A** is formed by separating the semiconductor device **400W** using a singulation or dicing process.

Referring to FIG. **4A****,** the substrate **102** is received or provided as the semiconductor device **100W.** Further, conductive vias **104** are formed in the substrate **102.** Referring to FIG. **4B****,** a bulk portion of the substrate **102** below the conductive vias **104** is removed, e.g., by CMP, grinding, or an etching operation such that the conductive vias **104** become TSVs **104.** A singulation or dicing process is performed to separate the semiconductor device **100W** into a plurality of TSV dies **122E,** which are similar to the TSV die **122A** described with reference to FIG. **2C****.**

Referring to FIG. **4C****,** the carrier substrate **106** is received or provided in a semiconductor device **400W.** Further, the release layer **110** is formed over the carrier substrate **106.** A plurality of TSV dies **122E** and a plurality of TMVs **232** are arranged over the release layer **110** to form a reconstituted structure on a carrier surface **110S** of the release layer **110** or the carrier substrate **106.** The TMVs **232** may be alternately arranged with the TSV dies **122E.** The TMVs **232** may include a conductive material, e.g., tungsten, copper, titanium, tantalum, molybdenum, cobalt, ruthenium, aluminum, silver, gold, or another suitable material. The plurality of TSV dies **122E** and the plurality of TMVs **232** may have substantially equal heights. According to some embodiments, the TSV dies **122E** and the TMVs **232** are arranged over the release layer **110** by a pick-and-place bonding process.

Referring to FIG. **4D****,** the semiconductor device **400W** is molded or encapsulated using a potting material (e.g., an encapsulating material or a molding material) **242.** A deposition process or a molding process is performed to deposit the potting material **242** in between the TSV dies **122E** and the TMVs **232.** According to some embodiments, a planarization process, e.g., CMP, grinding, et etching, or another suitable etching operation, is performed to remove excess potting material **242** and planarize an upper surface of the potting material **242,** an upper surface of the TSV dies **122E** and an upper surface of the TMVs **232,** revealing the TSVs and the TMVs

Referring to FIG. **4E****,** the primary RDL **108A** is formed over the upper surfaces of the potting materials **242,** the TSV dies **122E** and the TMVs **232.** Materials, configuration and a method of forming the primary RDL **108A** are similar to those described with reference to FIGS. **2B** to **2G****,** and repeated description of the primary RDL **108A** is omitted for brevity.

According to some embodiments, an order of the processing steps shown in FIGS. **4C** and **4D** can be altered. For example, initially, the plurality of TSV dies **122E** are arranged over the release layer **110** without the TMVs **232.** Subsequently, the potting material **242** is deposited to fill the gaps between the TSV dies **122E** and is planarized. A hole opening operation by, for instance, laser is performed to form via holes between the TSV dies **122E** which are subsequently filled with conductive materials forming the TMVs **232.** The vias may be laterally surrounded by the potting material **242.**

Referring to FIG. **4F****,** another carrier substrate **116** is provided or received in another semiconductor device **401W.** Another release layer **120** is formed over the carrier substrate **116.** Further, the structure in FIG. **4E** is flipped over with its RDL **108A** side bonded to the second carrier substrate **116** with the use of a release layer **120** and carrier **106** is released. Subsequently, another primary RDL **108B** with surface finish and bonding pads is formed over the other side of the TSV dies **122E,** the potting material **242** and the TMV **232**s supported by the second carrier **116.** Materials, configurations, and methods of forming the carrier substrate **116,** the release layer **120** and the primary RDL **108B** are similar to those of the carrier substrate **106,** the release layer **110** and the primary RDL **108A** described with reference to FIG. **2C****,** and therefore details of such similar features are not repeated for brevity. Moreover, the carrier substrate **116** is removed from the semiconductor device **401W** by releasing the release layer **120** following wafer mounting

Referring to FIG. **4G****,** a singulation or dicing process is performed to separate the reconstituted structure of the semiconductor device **401W** into individual IC structures **400A.** Through appropriate arrangement, the TMVs **232** and edge TSVs **104B** are formed in the IC structure **400A** and comprise
- two TMV types after the singulation or dicing process: interior TMVs (not shown) and edge TMVs **232,** and
- two TSV types after the singulation or dicing process: interior TSVs and edge TSVs **104B.**

Properties of the conductive pads **212** and the conductive vias **214** of the primary RDLs **108A or 108B** are similar to those of the IC structure **100A** shown in FIG. **2C****,** and repeated descriptions thereof are omitted for brevity. The IC structure **400A** is different from the IC structure **100A** mainly in that the IC structure **400A** further includes the potting material **242** filling a space between the semiconductor die **122D** and the TMV **232.** The semiconductor die **122D,** the TMV **232** and the potting material **242** constitute a body of the IC structure **400A.**

FIGS. **4H to 4N** show cross-sectional views of IC structures **400B, 400C, 400D, 400E, 400F, 400G** and **400H,** respectively, in accordance with various embodiments of the present disclosure. Since the IC structures **400B, 400C, 400D, 400E, 400F, 400G** and **400H** are seen as variants of the baseline IC structure **400A** in many aspects, the following description will focus only on differences between the IC structure **400A** and other IC structures **400B to 400H.**

Referring to FIG. **4H****,** a main difference between the IC structure **400B** and the IC structure **400A** is that, in the IC structure **400B,** the TSV die **122E** containing interior TSVs is laterally surrounded or encapsulated by the potting material **242** and there exists no edge TSV in the IC structure **400B.**

Referring to FIG. **4I**, a main difference between the IC structure **400C** and the IC structure **400A** is that the TMV **232** is absent in the IC structure **400C.** Referring to FIG. **4J****,** the IC structure **400D** does not possess edge TSVs nor edge TMVs which are both present in the IC structure **400A.**

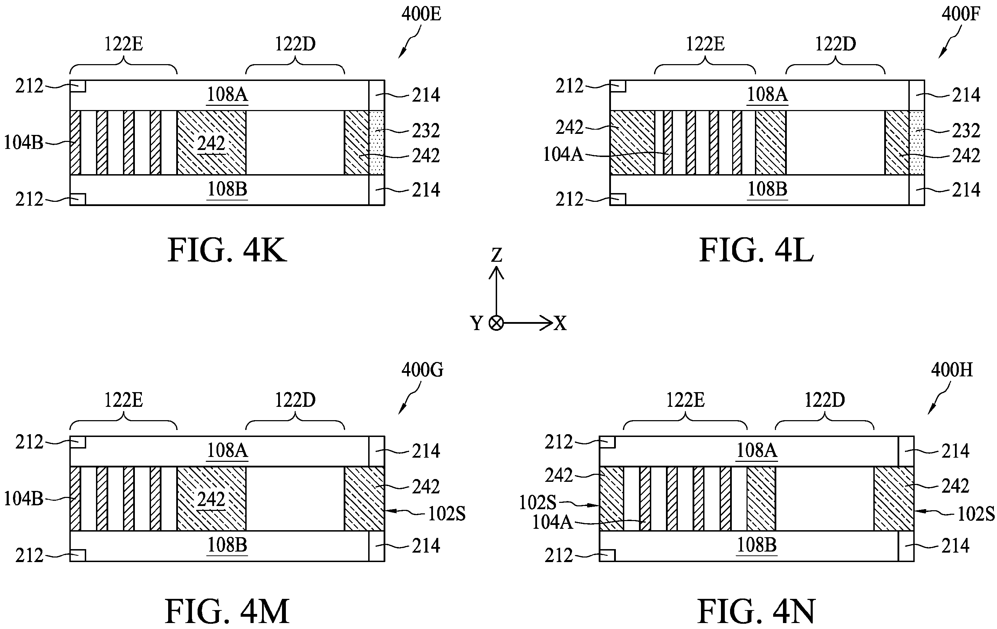

The IC structures **400E, 400F, 400G** and **400H** shown in FIGS. **4K** to **4N** can be seen as multi-die versions of the corresponding single-die IC structures **400A, 400B, 400C** and **400D,** wherein multiple dies are arranged in a same package layer of the IC structures **400E** through **400H.** Referring to FIG. **4K****,** a main difference between the IC structure **400E** and the IC structure **400A** is that the IC structure **400E** further includes a second semiconductor die **122D** besides the first semiconductor die, i.e., the TSV die **122E,** both of which can be of the same or different sizes. A body of the IC structure **400E** is thus comprised of the semiconductor die **122D,** the TSV die **122E,** the TMV **232,** the potting material **242** and the RDLs, **108A** and **108B.** The semiconductor die **122D** and the TSV die **122E** are arranged in a same package layer. The semiconductor die **122D** (which can also contain interior or edge TSVs) is laterally surrounded or encapsulated by the potting material **242.** Further, in the IC structure **400E,** the TMV **232** serves as an edge TMV, which can be electrically connected to the edge conductive via **214** of the primary RDL **108A** and the edge conductive via **214** of the primary RDL **108B** to form a stacked TSV extending through an entire thickness of the IC structure **400E.**

Referring to FIG. **4L****,** a main difference between the IC structure **400F** and the IC structure **400E** is that, in the IC structure **400F,** the TSV die **122E** is further laterally surrounded or encapsulated by the potting material **242** and the IC structure **400F** contains no edge TSVs.

Referring to FIG. **4M****,** a main difference between the IC structure **400G** and the IC structure **400E** is that the edge TMV **232** is absent from the IC structure **400G** which contains the edge TSV **104B.**

Referring to FIG. **4N****,** the IC structure **400H** can be seen as a combination of features of the IC structures **400F** and **400G,** in which a body of the IC structure **400H** comprises only the semiconductor die **122D,** the TSV die **122E,** the potting material **242** and the RDLs **108A** and **108B** without edge TSVs and edge TMVs. According to some embodiments, the potting material **242** laterally surrounds and encapsulates the semiconductor dies **122D** and **122E.** The potting material **242** is exposed through two secondary planes **102S** of the body of the IC structure **400H.**

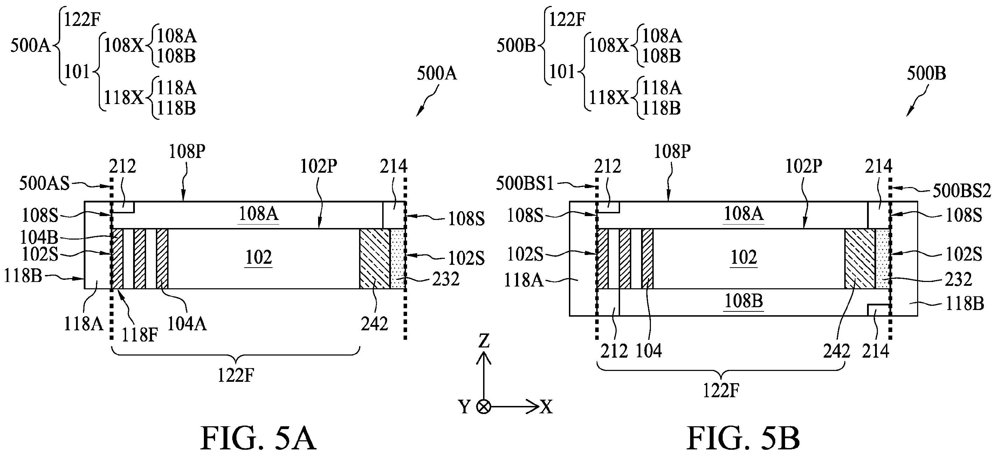

FIG. **5A** shows a cross-sectional view of an IC structure **500A,** in accordance with various embodiments of the present disclosure. A body of the IC structure **500A** comprises a semiconductor die **122F,** a TMV **232** and a potting material **242.** The semiconductor die **122F** may include at least one of a CPU die, a GPU die, a TPU die, a MEMS die, an AP die, an FPGA die, an ASIC die, a memory die, a transceiver die, a network interface die, an integrated photonics die, a packet buffer/router die or another suitable die. The semiconductor die **122F** is similar to the semiconductor die **122D1** shown in FIG. **3F****,** except that the edge conductive pad **222** of the semiconductor die **122D1** is replaced with a plurality of TSVs **104** (including interior TSVs **104A** and edge TSVs **104B**), in which one edge TSV **104B** is exposed through a secondary plane **500AS** of the IC structure **500A.** Further, in contrast to the IC structures described previously, the IC structure **500A** further includes a secondary RDL **118A** arranged on the secondary plane **500AS** of the IC structure **500A** and electrically connected to the primary RDL **108A.**

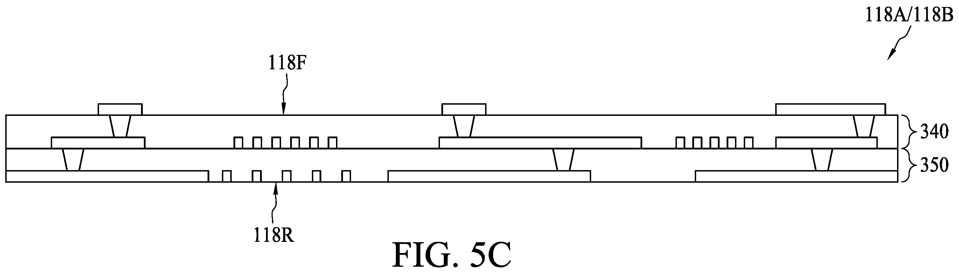

FIG. **5C** shows a cross-sectional view in greater detail of the secondary RDL **118A** of the IC structure **500A** shown in FIG. **5A****,** in accordance with various embodiments of the present disclosure. The secondary RDL **118A** is similar to the primary RDL **108,** e.g., the primary RDL **108A** or **108B,** described with reference to FIG. **2G****.** The secondary RDL **118A** shown in FIG. **5C** includes two major conductive line/via layers **340, 350** similar to the first and second major conductive line/via layers, **240** and **250,** of the primary RDL **108A or 108B** in FIG. **2G****.** Referring to FIG. **5C****,** the secondary RDL **118A** includes a front interconnect surface **118F** and a back interconnect surface **118R** opposite to the front interconnect surface **118F.** The secondary RDL **118A** is electrically connected to an edge interconnect structure **118X,** e.g., the edge TSV **104B** of the semiconductor die **122F** or an edge conductive pad **212** of the primary RDL **108A,** of the IC structure **500A.** According to some embodiments, the secondary RDL **118A** is considered part of the edge interconnect structure **118X** of the IC structure **500A.** With such configuration, the primary RDL **108A** can be electrically connected to the semiconductor die **122F** not only through an interior interconnect structure **108X** via a primary surface **102P** of a substrate **102** of the IC structure **500A** and a primary surface **108P** of the primary RDL **108A** facing the substrate **102,** but also through the edge interconnect structure **118X** including the edge TSV **104B** and the secondary RDL **118A** via a side surface (secondary plane) **102S** of the body of the IC structure **500A** and a front interconnect surface **118F** of the secondary RDL **118A.** A routing capacity and design flexibility of the IC structure **500A** provided for the semiconductor die **122F** is therefore increased as compared to IC structures without the secondary RDL **118A** and other edge interconnections.

FIG. **5B** shows a cross-sectional view of an IC structure **500B,** in accordance with various embodiments of the present disclosure. The IC structure **500B** is substantially similar to the IC structure **500A** in many aspects, and therefore descriptions of similar features are not repeated for brevity. A main difference between the IC structure **500B** and the IC structure **500A** is that, in addition to the secondary RDL **118A** arranged on a left-side secondary plane **500BS1** of the IC structure **500B,** the IC structure **500B** further includes a secondary RDL **118B** arranged on a right-side secondary plane **500BS2** of the IC structure **500B** opposite to the secondary RDL **118A.** A material and a configuration of the secondary RDL **118B** may be similar to those of the secondary RDL **118A,** as illustrated in FIG. **5C****.** However, other configurations and numbers of major conductive line/via layers for the secondary RDLs, **118A** and **118B,** are also within the contemplated scope of the present disclosure. The secondary RDL **118B** is thus also considered part of the edge interconnect structure **118X** of the IC structure **500B** and can be electrically connected to the primary RDL **108A.**

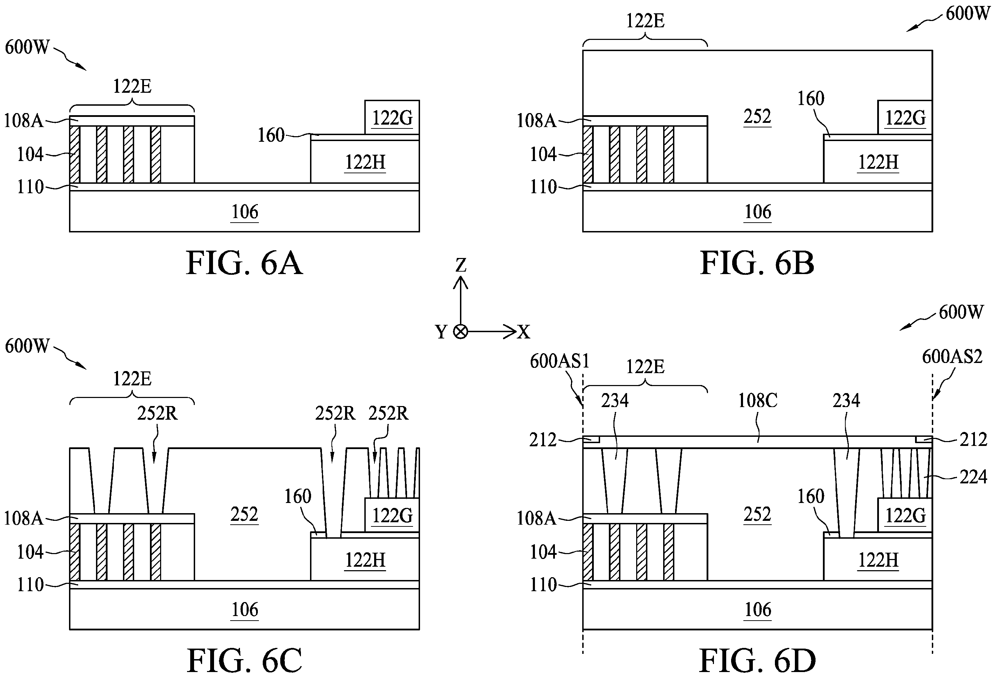

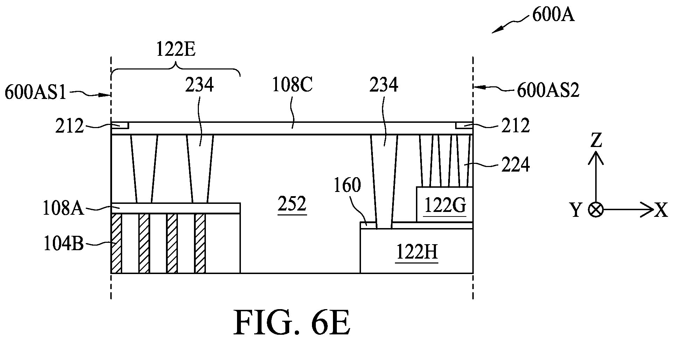

FIGS. **6A** to **6E** show cross-sectional views of structures in different stages of a method of manufacturing a semiconductor package **600A,** in accordance with various embodiments of the present disclosure. According to some embodiments, the IC structure **600A** shown in FIG. **6E** is a semiconductor package device. The IC structure **600A** may be formed from a semiconductor device **600W,** which is a wafer-level device, wherein the IC structure **600A** in FIG. **6E** is formed by separating the semiconductor device **600W** using a singulation or dicing process.

Referring to FIG. **6A****,** a carrier substrate **106** is provided or received. A release layer **110** is formed over an upper surface of the carrier substrate **106.** A plurality of semiconductor dies, e.g., semiconductor dies, **122E, 122G** and **122H,** are prepared. A TSV die **122E** may be replaced with semiconductor dies described above, such as the semiconductor dies **100A, 100B, 100C, 300A, 300B, 300C,** and **400A** to **400H.** The TSV die **122E** includes a plurality of TSVs **104** and a primary RDL **108A** on an upper surface of the TSVs **104.** According to some embodiments, the semiconductor die **122G** or **122H** can be at least one of a CPU die, a GPU die, a TPU die, a MEMS die, an AP die, an FPGA die, an ASIC die, a memory die, a transceiver die, a network interface die, an integrated photonics die, a packet buffer/router die, another suitable die or any of the semiconductor dies described above.

Sizes or dimensions of the semiconductor dies **122E, 122G** and **122H** may be similar or different. For example, the semiconductor dies **122E, 122G** and **122H** may have substantially equal or different heights, lengths or widths.

A pick-and-place process is performed to pick known good dies (KGDs) of the semiconductor dies **122E, 122G** and **122H,** and bond the KGDs over the release layer **110.** A bonding or die attachment layer **160** is formed on the semiconductor die **122H** after the semiconductor die **122H** is placed over the release layer **110.** The bonding layer **160** may aid in attachment of the semiconductor die **122G** to the semiconductor die **122H.** According to some embodiments, the bonding layer **160** is a die attachment film, an array of micro-bumps configured to perform flip-chip bonding, a direct bonding layer or a hybrid bonding layer configured to generate bonds. According to some embodiments, the semiconductor dies **122G** and **122H** are vertically stacked. The semiconductor die **122E** may be arranged side-by-side adjacent to the stacked semiconductor dies, **122G** and **122H,** in a same package layer. The semiconductor dies **122E, 122G** and **122H** may be of substantially the same or different sizes.

Referring to FIG. **6B****,** the semiconductor device **600W** is molded or encapsulated using a potting material or a suitable material **252.** A material and a configuration of the potting material **252** are similar to those of the potting material **242** and can include molding compound and thick-film photoresists. A molding or deposition process is performed to deposit the potting material **252** in between the semiconductor dies **122E, 122G** and **122H** and embed the semiconductor dies **122E, 122G** and **122H.** The potting material **252** may have a height greater than that of the semiconductor dies **122E, 122G** and **122H.** According to some embodiments, a planarization process, e.g., CMP, grinding, etching (dry and/or wet) or another suitable etching operation, is performed to remove excess potting material **252** and generate a uniform upper surface of the potting material **252** (see FIG. **6B**).

FIG. **6C** illustrates a formation of a plurality of via holes **252R** in the potting material **252.** The holes may be created by laser ablation. Alternatively, if a thick film photoresist is used as the encapsulation material, it can be laminated on, patterned and developed to create the holes that extend from the upper surface of the potting material **252** to the bonding pads with proper surface finishes of the semiconductor dies **122E, 122G** and **122H** with the pads exposed under the via holes **252R.**

Referring to FIG. **6D****,** a conductive material with proper passivation is deposited in the via holes **252R,** e.g., by PVD, CVD, ALD, plating, or the like. The conductive material may include at least one of tungsten, copper, titanium, molybdenum, cobalt, ruthenium, tantalum, aluminum, silver, gold, and other suitable materials. One or more conductive pillars **224** are thus formed over and electrically connected to the semiconductor die **122G.** At least one conductive pillar **224,** formed on a secondary plane **600AS2** (at the present time such secondary plane **600AS2** is still a hypothetical plane before the dicing process) of the semiconductor device **600W,** is configured as an edge conductive pillar **224.** Further, one or more conductive plugs **234** are formed over and electrically connected to the TSV die **122E** and/or the semiconductor die **122H.** As a result, a body of the IC structure **600A** includes the semiconductor dies, **122E, 122H** and **122G,** the primary RDL **108A,** the bonding layer **160,** the potting material **252,** the conductive vias **104,** the interior conductive pillars **224,** the conductive plugs **234** and the edge conductive pillar **224.** According to some embodiments, the TSVs **104,** the conductive pillars **224,** and the conductive plugs **334** are of substantially the same or different lengths.

Another primary RDL **108C** is formed over the upper surface of the potting material **252** and electrically connected to the semiconductor dies **122E, 122G** and **122H.** According to some embodiments, the primary RDL **108C** at least includes an edge conductive pad **212** on a secondary plane, **600AS1** or **600AS2** (at the present time the secondary planes **600AS1** and **600AS2** are still hypothetical planes before the dicing process) of the semiconductor wafer **600W.**

Subsequently, following wafer mounting, the carrier substrate **106** is removed or detached from the semiconductor device **600W** by removing or releasing the release layer **110** from the semiconductor device **600W.** FIG. **6E** shows an individual IC structure **600A** formed using a singulation or a dicing process to separate the semiconductor device **600W** into individual IC structures **600A.** Through appropriate arrangement, the edge conductive pads **212,** the edge TSV **104B** and the edge conductive pillar **224** can be formed and exposed through at least one of the secondary planes, **600AS1** and **600AS2,** of the IC structure **600A.** The primary RDL **108C** is configured to be electrically connected to the semiconductor dies **122E, 122G** and **122H** through an interior interconnect structure **108X,** e.g., the conductive plugs **234** and interior conductive copper pillars **224.** Further, the primary RDL **108C** is configured to be electrically connected to the semiconductor dies **122E, 122G** and **122H** through an edge interconnect structure **118X,** e.g., the edge TSV **104** and the edge conductive pillar **224.** A routing distance can thus be reduced with the help of the edge interconnect structure **118X.**

Referring to FIG. **6E** and FIGS. **5A** and **5B,** according to some embodiments, the secondary RDLs **118A** and **118B** of the IC structures **500A** and **500B** are applicable to the IC structure **600A.** In other words, although not separately shown, the secondary RDL **118A** or **118B** can be arranged on the secondary surfaces **600AS1** and **600AS2,** respectively, to be electrically connected to conductive elements **202** of the primary **RDL108C,** the edge TSV **104** (in FIG. **6E** use **104** instead of **104B** to be consistent with FIG. **6D**), and/or the edge conductive pillars **224.** According to some embodiments where the IC structure **600A** includes an edge conductive plug **234,** the secondary RDL **118A** or **118B** can be electrically connected to such edge conductive plug **234.**

The embodiments of the present disclosure discussed above provide advantages. The collective edge conductive element **202** can appear in a form of edge conductive pads **212,** in a form of edge conductive vias **214,** in a form of edge TSVs **104,** or in a form of edge TMVs **224** as shown in FIG. **6E****.** Further, the primary RDLs, **108A** and **108C,** or the secondary RDLs **118A** and **118B** (see FIG. **5B**) may be formed with or without the edge conductive pads **212,** with or without the edge conductive vias **214,** with or without the edge TSVs **104,** with or without the edge conductive via **222** (see FIGS. **2F** and **3F**), with or without the edge TMVs **232** (FIG. **5B**), with or without the edge conductive pillars **224,** and with or without the edge conductive plugs **234.** The edge conductive elements **202** can be disposed at a periphery of the IC structures or at a periphery of the RDLs. Further, the edge conductive vias **222** can cover an entirety or a part of a thickness of the body of the respective IC structure. Moreover, the edge TSVs **104,** the edge TMVs **232,** the edge conductive pillars **224** and the edge conductive plugs **234** can appear inside the IC structures to facilitate interior interconnection of the IC structures in different stacked layers in addition to the edge interconnection arranged on the side faces.

The conductive pillars **224** the conductive plugs **234** and the TMVs **232** (FIG. **5B**) are formed based on hole opening and hole filling process steps, and they can be created by a number of methods which include a bonded vertical wire (e.g., palladium, Pd, coated Cu) approach and a laser via approach and through-photosensitive-thick-film (TPTF) approach. The bonded vertical wire approach follows the tall copper pillar process steps with wire bonding replacing the tall copper pillar formation steps. When Pd-coated Cu wire is used, thin gold (Au) can be used as the bonding pad. In the laser via approach, the ICs are first bonded to the carrier substrate **106,** followed by for instance, overmolding, planarization, laser via hole opening, via hole sidewall Cu plating, via hole plating or plugging with a photosensitive polymer or a solder, planarization, RDL creation, carrier release and dicing. The TPTF process flow consists of sequentially laminating a thick photosensitive film on the bonded ICs, multiple or single exposure and development to create TMV holes (i.e., through-photosensitive-thick-film via holes), barrier/seed layer deposition, Cu plating, via hole plugging as needed, back-grinding/planarization, RDL creation, carrier release and dicing. The ICs here can have RDLs and TSVs. Multiple exposure provides process freedom to form vias with different sizes and depths. The TMV related processes can accommodate multiple ICs both in the x-y plane and in the vertical z direction as illustrated in FIG. **6E****.** Moreover, the semiconductor dies, **122E, 122H** and/or **122G,** in FIG. **6E** can be pre-bumped with solder bumps or copper pillar micro-bumps prior to bonding them to the carrier substrate **106** in FIG. **6A****.** Following die bonding, overmolding can ensue followed by planarization and RDL creation.

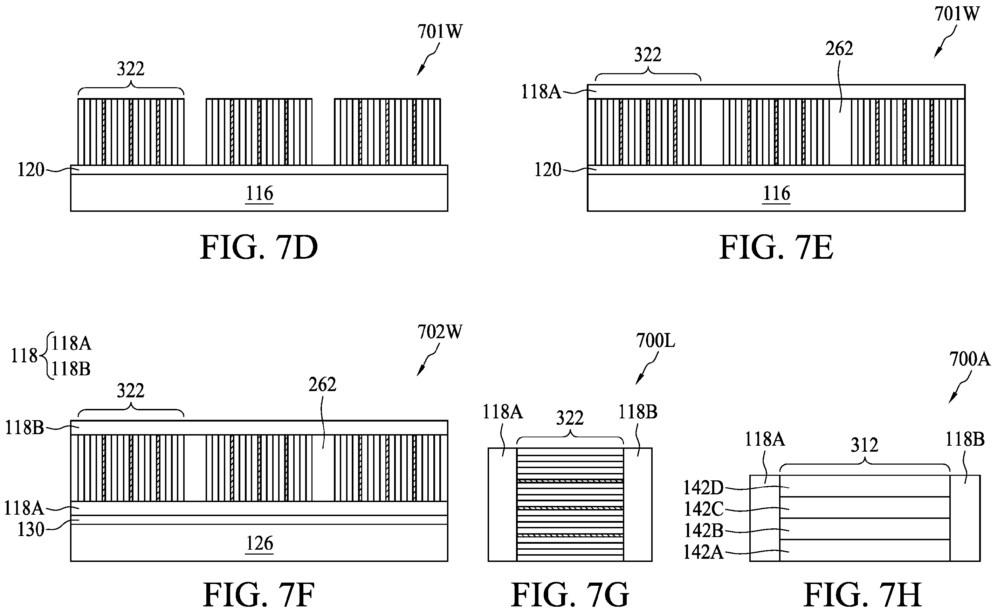

FIGS. **7A** to **7H** show cross-sectional views of structures in different stages of a method of manufacturing a semiconductor package **700A,** in accordance with various embodiments of the present disclosure. According to some embodiments, the semiconductor package **700A** shown in FIG. **7H** is a semiconductor package device. The semiconductor package **700A** may be formed from semiconductor devices **700W** and **701W,** which are wafer-level devices, wherein the semiconductor package **700A** is formed by separating the semiconductor device **701W** using a singulation or dicing process.

FIG. **7A** to FIG. **7C** illustrate formation of a plurality of tall IC stacks **322** from a plurality of IC structures **142.** Referring to FIG. **7A****,** a carrier substrate or a supporting substrate **106** is provided or received. A release layer **110** is formed over an upper surface of the carrier substrate **106.** A pick-and-place process is performed to pick and bond a plurality of known-good IC structures **142,** e.g., IC structures **142A** with the help of a bonding layer to form the first tier of short IC stacks **312** as shown in FIG. **7A** over the release layer **110** with a suitable pitch to enhance yield. According to some embodiments, the IC structures **142** can be made up of IC structures **400A, 400B, 400C, 400D, 400E, 400F, 400G, 400H, 500A, 500B,** and/or **600A;** however, other types of IC structures, e.g., the IC structure **100A, 100B, 100C, 300A, 300B, 300C** and/or the like, are also possible. The IC structures **142** covering **142A, 142B, 142C** and **142D** as illustrated in FIG. **7B** for demonstration may include memory and/or processor analog dies. The IC structures **142** may also cover MEMS devices, passives as well as analog, mixed-signal and digital signal processing ICs.

Referring to FIG. **7B****,** another plurality of IC structures **142,** e.g., IC structures **142B,** are bonded to the corresponding IC structures **142A** to form the second tier of the short IC stacks **312.** The bonding of IC structures **142B** to IC structures **142A** may be achieved using thermo-compression bonding (TCB), flip-chip bonding, hybrid bonding, direct bonding, bonding via glue layers (e.g., Ti/Au), a die attachment film or paste, or other suitable bonding processes. A process of forming the short IC stacks **312** may continue until a predetermined tier number (total number of tiers) K is achieved, wherein the tier number K is a natural number. In the depicted example in FIG. **7B****,** the tier number K is four. That means each short IC stack **312** is constructed by four stacked IC structures **142A, 142B, 142C** and **142D.** This process generates known-good short IC stacks. Alternatively, the short IC stacks **312** can be formed by bonding of a plurality of **142D** to a plurality of **142C** with the resultant structures further processed as needed and then released, the known-good structures picked, the known-good structures bonded to a plurality of known-good **142B,** etc. and the process is repeated until the short IC stacks **312** are formed in FIG. **7B****.**

After the first short IC stacks **312** are completed, a release (or bonding) layer **140** of a suitable thickness is formed over each short IC stack **312.** A material of the release layer **140** may be different from that of the release layer **110** to avoid interference with each other during the respective release processes. Subsequently, another set of known-good short IC stacks **312** is formed over the release layers **140** of first known-good short IC stacks **312.** As shown in FIG. **7B****,** the formation of the short IC stacks **312** and the formation of the release layers **140** are proceeded alternately until a predetermined number L of short IC stacks is achieved to form the tall IC stacks **322** in FIG. **7C****,** wherein the short IC stack number L (i.e., total number of short IC stacks) is a natural number. In the depicted example, the short IC stack number L is four. As a result, the short IC stacks **312** are stacked to form tall IC stacks **322** through the release layers **140.**

Referring to FIG. **7C****,** each tall IC stack **322** is released from the carrier substrate **106** by releasing the release layer **110.** As a result, four short IC stacks **312** are alternately arranged with three release layers **140** to form a column of the tall IC stack **322.** In the depicted example, there are three columns of the tall IC stacks **322** in the semiconductor device **700W.** The numbers K, L, and a column number introduced above are used for illustrative purposes. Other numbers are also within the contemplated scope of the present disclosure.

FIG. **7D** to FIG. **7H** illustrate formation of the semiconductor package **700A** from the plurality of tall IC stacks **322.** Referring to FIG. **7D****,** a carrier substrate **116** is provided or received. A release layer **120** is formed over an upper surface of the carrier substrate **116.** A pick-and-place process is performed to pick and bond a plurality of known-good tall IC stacks **322** and arrange them over the release layer **120** with a suitable pitch to enhance yield. The tall IC stacks **322** are reconstituted on the carrier substrate **116** and bonded to the release layer **120** through their side surfaces. In other words, the tall IC stacks **322** are lying down such that the vertically-stacked IC structures **142** in the tall IC stack **322** are positioned upright in the x-y plane or IC length and width direction with one of their four side surfaces bonded to the release layer **120.**

Referring to FIG. **7E****,** the reconstituted tall IC stacks **322** of the semiconductor device **701W** are molded or encapsulated using a potting material **262.** A material and a configuration of the potting material **262** are similar to those of the potting material **242** or **252.** A molding or deposition process is performed to deposit the potting material **262** in between the laid-down tall IC stacks **322.** According to some embodiments, a planarization process, e.g., CMP, grinding, etching (dry and/or wet) or another suitable etching operation, is performed to remove excess potting material **262** and planarize an upper surface of the potting material **262** and have it flush with a side surface of the tall IC stacks **322.** Subsequently, an edge interconnect structure, RDL **118A** is formed over or bonded to at least an edge interconnect of the side surface (secondary plane) of the tall IC stacks **322.**

FIG. **7F** illustrates formation of another edge interconnect structure, RDL **118B,** on another side surface of the tall IC stacks **322** opposite to the secondary RDL **118A.** Another carrier substrate **126** is provided or received in another semiconductor device **702W.** Another release layer **130** is formed over the carrier substrate **126** to facilitate the creation of **118B.** Materials, configurations, and methods of forming the carrier substrate **126** and the secondary RDLs, **118A** and **118B,** are similar to the secondary RDLs, **108A** and **108B** described in FIG. **5B** and the primary RDLs, **108A** and **108B,** in FIG. **2C****,** and therefore details of such similar features are not repeated for brevity. A material of the release layer **130** may be different from that of the release layer **120** to avoid interference with each other during respective release processes. Subsequently, the carrier substrate **116** is removed from the semiconductor device **701W** by removing the release layer **120** after the semiconductor structure **701W** in FIG. **7E** is bonded to the second carrier **126** on the side of RDL **118A.** The edge interconnect RDL structure **118B** is formed or bonded to a lower secondary surface of the tall IC stacks **322** opposite to an upper secondary surface of the tall IC stacks **322.**

Referring to FIG. **7G****,** a singulation or dicing process is performed to separate the semiconductor device **701W** into tall IC stack structures **700L.** The singulation or dicing process may be performed to cut through the semiconductor device **701W** at locations of the potting material **262** with the potting material **262** cleaned by, for instance, dry and/or wet etching while taking care to keep each tall IC stack **322** intact during the dicing process. According to some embodiments, a wet etching or cleaning process is performed to remove residual potting materials **262** left on the tall IC stacks structures **700L.**

FIG. **7H** illustrates formation of the individual semiconductor packages **700A,** i.e., the short IC stack structures, from the respective IC structures, i.e., the tall IC stack structures **700L.** A release process, a singulation process and/or a dicing process is performed to detach the release layers **140** (FIG. **7B****)** from each of the tall IC stack structures **700L** such that the different semiconductor packages **700A,** i.e., the respective short IC stacks **312** containing the edge interconnect RDL structures, **118A** and **118B,are** separated from each other. According to some embodiments, an etching or dicing process is performed to aid in the release process, e.g., by dicing, a continuous-wave laser beam, dry etching (e.g., by plasma) and/or wet etching to cut through the secondary RDLs **118A** and **118B,** at the locations of the release layers **140.** As illustrated in FIG. **7H****,** the semiconductor package **700A** includes a stack of short IC stack structures **142** and two secondary RDLs, **118A** and **118B,** arranged on two side surfaces of the short IC stack **142.** The secondary RDLs, **118A** and **118B,** can help increase a routing area of the IC structures **142,** reduce a routing distance, and improve routing capacity and design flexibility of the semiconductor package **700A.**

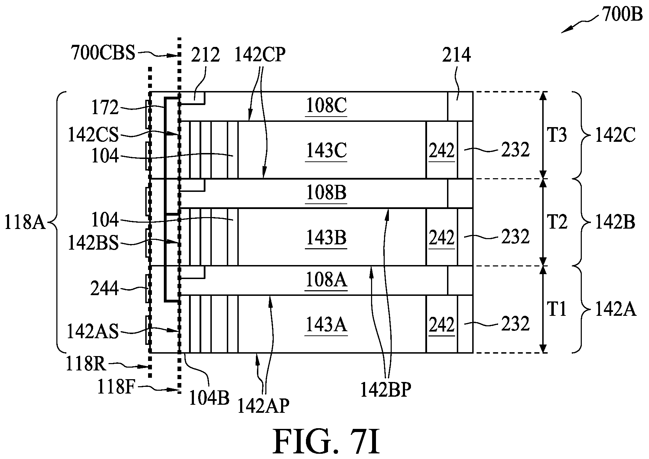

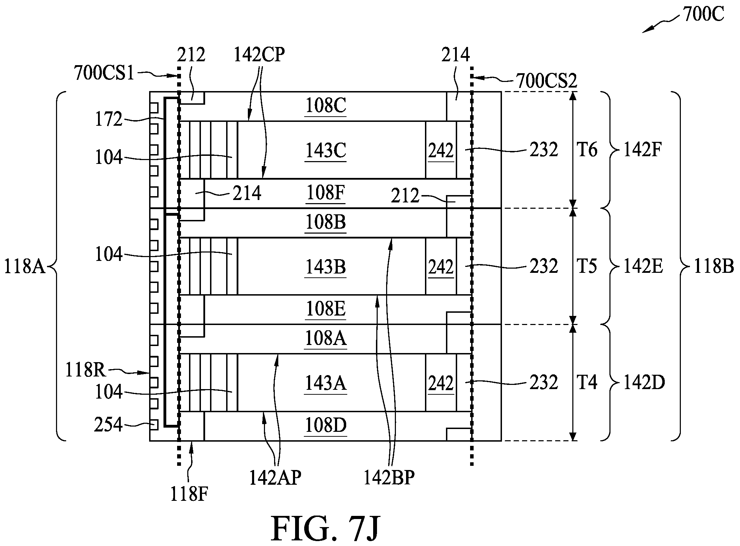

FIGS. **7I** and **7J** show cross-sectional views of semiconductor packages, **700B** and **700C,** in accordance with various embodiments of the present disclosure. The semiconductor packages, **700B** and **700C,** can be seen as detailed versions of the semiconductor package **700A** with some minor changes. For example, referring to FIG. **7I**, the semiconductor package **700B** includes three IC structures, **142A, 142B** and **142C,** in a vertical stack, wherein each IC structure **142A, 142B or 142C,** comprises a respective body and a respective primary RDL **108A, 108B or 108C** on its top side, arranged on the respective upper primary surfaces, **142AP, 142BP or 142CP.** The body of the IC structure **142A** comprises a semiconductor die **143A,** the edge TMV **232,** the edge TSV **104** and the potting material **242,** wherein the semiconductor die **143A** includes a plurality of TSVs **104** and a plurality of TMVs **232.** Moreover, the body of the IC structure **142B** comprises a semiconductor die **143B,** the edge TMV **232** and the potting material **242,** wherein the semiconductor die **143B** includes a plurality of TSVs **104** and a plurality of TMVs **232.** Likewise, the body of the IC structure **142C** comprises a semiconductor die **143C,** the edge TMV **232** and the potting material **242,** wherein the semiconductor die **143C** includes a plurality of TSVs **104** and a plurality of TMVs **232.** IC structures **142A, 142B** and **142C** can be different sizes and can contain a wide variety of combinations in terms of interior and edge interconnects covering TSVs and TMVs. According to some embodiments, the semiconductor die, **143A, 143B or 143C,** can be at least one of a CPU die, a GPU die, a TPU die, a MEMS die, an AP die, an FPGA die, an ASIC die, a memory die, a transceiver die, a network interface die, an integrated photonics die, a packet buffer/router die or another suitable die (e.g., an interconnect die such as an interposer). According to some embodiments, the semiconductor package **700B** only includes a single secondary RDL **118A** arranged on a left-side secondary plane **700BS** of the semiconductor package **700B.**

According to some embodiments, the IC structures, **142A, 142B** and **142C,** are characterized by substantially equal or unequal thicknesses **T1, T2** and T3, respectively. Each IC structure, **142A, 142B or 142C,** may include a thickness in a range between about **30** µm and about **775** µm.

The secondary RDL **118A** includes a front interconnect surface **118F** and a back interconnect surface **118R** opposite to the front interconnect surface **118F.** The secondary RDL **118A** is electrically connected to the secondary plane **700BS** through the front interconnect surface **118F** to aid in routing efficiency and flexibility. For example, the secondary RDL **118A** includes a conductive trace or wire **172** extending along a longitudinal axis of the secondary RDL **118A** and electrically connecting the edge conductive pad **212** of the primary RDL **108C** and the edge TSV **104B** of the semiconductor die **143C** and **143A** while bypassing the bodies of the IC structures **142A, 142B** and **142C.** Further, the secondary RDL **118A** can be used to connect other circuits through the back interconnect surface **118R.** For example, the secondary RDL **118A** includes one or more conductive bumps, micro-bumps, or a bump pad array **244** (all of which referred to as external connections of the secondary RDL **118A)** on the back interconnect surface **118R,** wherein the conductive bump **244** is configured to electrically connect the secondary RDL **118A** to circuits or layers adjacent to the secondary RDL **118A.**

Referring to FIG. **7J****,** the semiconductor package **700C** is similar to the semiconductor package **700B** in many aspects, and descriptions of such similar features are not repeated for brevity. According to some embodiments, the semiconductor package **700C** includes three IC structures, **142D, 142E** and **142F,** in a stack, wherein each IC structure, **142D, 142E or142F,** comprises a respective body and two respective primary RDLs, **108A/108D, 108B/108E** and **108C/108F,** arranged on respective upper and lower primary surfaces, **142AP, 142BP** and **142CP.**

The semiconductor package **700C** differs from the semiconductor package **700B** further in that, in the case of **700C,** the secondary RDL **118A** arranged on a secondary plane **700CS1** of the semiconductor package **700C** includes an array of conductive pads **254** on the back interconnect surface **118R** of the secondary RDL **118A.** According to some embodiments, the conductive pads **254** have upper surfaces that are coplanar with the back interconnect surface **118R** of the secondary RDL **118A.** Such coplanar arrangement of the secondary RDL **118A** is helpful in performing hybrid bonding with other circuits or layers. Additionally, in contrast to the semiconductor package **700B,** the semiconductor package **700C** further includes another secondary RDL **118B** arranged on a secondary plane **700CS2.** A configuration of interconnections in the secondary RDL **118B** may be similar to or different from that in the secondary RDL **118A.** The secondary RDL **118B** may include external connections such as micro-bumps, hybrid bonding layers, direct bonding layers, a flexible circuit connector, a combination thereof, or the like. Further, the secondary RDL **118A** (or **118B)** includes a conductive trace or wire **172** extending in the longitudinal axis of the secondary RDL **118A** and electrically connecting the edge conductive pads **212** of the primary RDLs **108C** and **108B** and the edge conductive via **214** of the primary RDL **108D** while bypassing the bodies of the IC structure **142D, 142E** and **142F** to enable skip-die and multi-sided power supply and signaling.

According to some embodiments, the IC structures, **142D, 142E** and **142F,** are of substantially equal or unequal thicknesses, **T4, T5** and **T6,** respectively. Each IC structure, **142D, 142E or 142F,** may include a thickness in a range between about 30 µm and about 775 µm.

Semiconductor packages, **700A, 700B** and **700C,** allow for skip-die and multi-sided power supply and signaling through interior interconnect structures **108X** covering TMVs, primary RDLs **108** and TSVs, skip-die and multi-sided power supply and signaling through edge interconnect structures **118X** covering secondary RDLs **118** and edge interconnects, as well as skip-die and multi-sided power supply and signaling through both the interior interconnect structure **108X** and edge interconnect structure **118X.** These semiconductor packages endowed with multi-sided power supply and signaling enable "PPAC optimization per cubic millimeter" of 3D ICs (exemplified herein by short IC stacks) to be accomplished, wherein a vertical dimension of the 3D ICs can be expanded to cover ICs, interposer, IC package substrate, IC package and system PCB (see, for instance, FIGS. **7I** and **7J****).**

Referring to FIGS. **7A** and **7B****,** according to some embodiments, the carrier substrate **106** can be a 12" wafer carrier or a larger panel carrier in order to increase carrier utilization. Referring to FIG. **7B****,** the release layer **140** can also be a permanent bonding layer such as a die attach film (DAF) used in stacked-die packaging - similar to that used in bonding the dies (IC structures, **142A to 142D)** together to form the short 3D IC stacks **312** - wherein the film is pre-applied to backside of the dies, **142A to 142B,** while still in wafer form and the die/film combos are picked up for die bonding from wafer tape following wafer saw.

Referring to FIG. **7E****,** as discussed previously, the reconstituted tall IC stacks **322** of the semiconductor device **701W** are molded or encapsulated using a potting material **262.** A material and a configuration of the potting material **262** are similar to those of the potting material **242** or **252.** A molding or deposition process is performed to deposit the potting material **262** in between the laid-down tall IC stacks **322.** According to some embodiments, an overmolding operation is performed to deposit the potting material **262.** According to some embodiments, the potting material **262** can also be a permanent bonding layer such as a molding compound or an encapsulant. According to some embodiments, a planarization process, e.g., CMP, grinding, etching (dry and/or wet) or another suitable etching operation, is performed to remove excess potting material **262** and planarize an upper surface of the potting material **262** and have it flush with a side surface of the tall IC stacks **322** which is also planarized simultaneously with the potting material **262.** Subsequently, an edge interconnect structure, RDL **118A** is formed over or bonded to at least an edge interconnect of the side surface (secondary plane) of the tall IC stacks **322.** According to some embodiments, a bumping operation is performed for die-edge interconnection, in which a plurality of bonding pads are formed on one side of the tall IC stacks **322** or the RDL **118A** to electrically connect the tall IC stacks **322** to the RDL **118A.**

Referring to FIG. **7F****,** another carrier substrate **126** is provided or received in another semiconductor device **702W.** Another release layer **130** is formed over the carrier substrate **126** to facilitate the creation of RDL **118B.** The semiconductor device **701W** in FIG. **7E** is bonded to the second carrier **126** on the side of RDL **118A.** Subsequently, the carrier substrate **116** is released from the semiconductor device **701W** by releasing the release layer **120.** According to some embodiments, a planarization operation is performed on an exposed secondary surface of the tall IC stacks **322** and the potting material **262** after the carrier substrate **116** is removed and before RDL **118B** is formed. The edge interconnect RDL structure **118B** is formed or bonded to the lower secondary surface of the tall IC stacks **322** opposite to an upper secondary surface of the tall IC stacks **322.**

Referring to FIG. **7G****,** the carrier substrate **126** is removed or detached from the semiconductor device **702W** by releasing the release layer **130.** A singulation or dicing process is performed to separate the semiconductor device **702W** into tall IC stack structures **700L.** The singulation or dicing process may be performed to cut through the semiconductor device **702W** at locations of the potting material **262** which can be devoid of metal wiring and even dielectric passivation to facilitate clean separation of the etching or dicing operation with the potting material **262** cleaned by, for instance, dry and/or wet etching while taking care to keep each tall IC stack structure **700L** intact during the dicing process. According to some embodiments, a wet etching or cleaning process is performed to remove residual potting materials **262** left on the tall IC stacks structures **700L.** According to some embodiments, a planarization operation is performed on the exposed primary surface of the tall IC stack structures **700L** to remove the residual potting materials **262.**

Referring to FIG. **7H****,** the individual semiconductor packages **700A,** i.e., the short IC stack structures **312,** are formed from the respective IC structures, i.e., the tall IC stack structures **700L.** A release process, a singulation process and/or a dicing process is performed to detach the release layers **140** (FIG. **7B****)** from each of the tall IC stack structures **700L** such that the different semiconductor packages **700A,** i.e., the respective short IC stacks **312** containing the edge interconnect RDL structures, **118A** and **118B,** are separated from each other. According to some embodiments, an etching or dicing process is performed to aid in the release process, e.g., by dicing, a continuous-wave laser beam, dry etching (e.g., by plasma) and/or wet etching to cut through the secondary RDLs **118A** and **118B,** at the locations of the release layers **140** which can be devoid of metal wiring and even dielectric passivation to facilitate clean separation of the etching or dicing operation. According to some embodiments, a combination of the wet etching operation, a dicing operation and a planarization operation is performed.

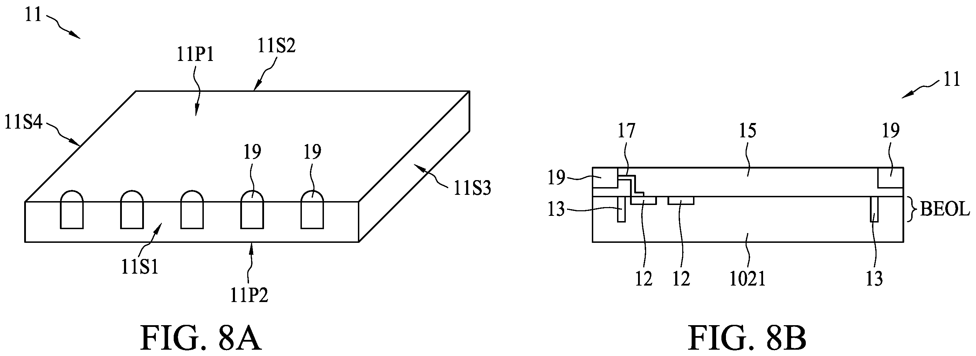

FIGS. **8A** show a perspective view and a cross-sectional view of an edge-pad semiconductor die (or semiconductor die hereinafter) **11** according to some embodiments of the present disclosure. The edge-pad semiconductor die **11** has a top surface **11P1,** a bottom surface **11P2,** and four sidewalls **11S1, 11S2, 11S3,** and **11S4,** wherein the area of the top surface/bottom surface **11P1/11P2** is far larger than those of the sidewalls **11S1, 11S2, 11S3,** and **11S4** (as shown in FIG. **8A****).** The semiconductor die **11** further includes "edge pads" **19** in the form of peripheral pads residing at the periphery or side faces or sidewalls (such as sidewalls **11S1, 11S2, 11S3,** and/or **11S4**) of the edge-pad semiconductor die **11** in FIG. **8A****.**

Further, throughout the present disclosure, multiple edge-pad semiconductor dies **11** arranged in a stack or shelf can be named as new high bandwidth memory (NuHBM) or NuHBM system. Hereinafter, the NuHBM system may be also referred to the memory stack or memory shelf (or NuHBM stack or NuHBM shelf), which includes a plurality of edge-pad semiconductor dies or exemplary semiconductor memory die **11** shown in FIG. **8A****.**

Referring to FIG. **8B****,** in one embodiment, the edge-pad semiconductor die **11** includes a memory die **1021** and a redistribution layer (RDL) **15** over a top surface of the memory die **1021.** The memory die **1021** can also be a DRAM die. In one embodiment, there is no through-silicon-vias (TSVs) in the memory die **1021** of the edge-pad semiconductor die **11** which includes edge pads along one the side surface. There are one or more signal pads **12** within the memory die **1021,** and a seal ring **13** surrounding the signal pad **12.** The memory die **1021** may include a **BEOL** (back end of line) region arranged on a front side of the memory die **1021.** In one embodiment, each edge pad **19** of each semiconductor die **11** includes the conductive line **17** in the redistribution layer **15** (RDL), and the conductive line **17** is electrically connected to the signal pad **12** in the back-end-of-line (BEOL) region of the semiconductor die **11** surrounded by the seal ring **31.** Referring to FIG. **8B****,** in the substrate of the memory die **1021,** all signal pads **12** are located within a region defined by the seal ring **13** of the substrate, and the edge pads **19** are located in the RDL **15** and electrically connected to the signal pads **12** (see of FIG. **8B****)** in the BEOL region.

In some embodiments, the interconnect structure of the RDL **15** may include a plurality of conductive line layers, a plurality of conductive vias, and one or more edge pads **19.** The conductive lines, conductive vias and edge pads together construct the various conduction paths of the interconnect structure. FIG. **8B** shows a conductive line **17** and vertical conductive vias arranged in the RDL **15** and electrically connecting the signal pad **12** to the edge pads **19.**

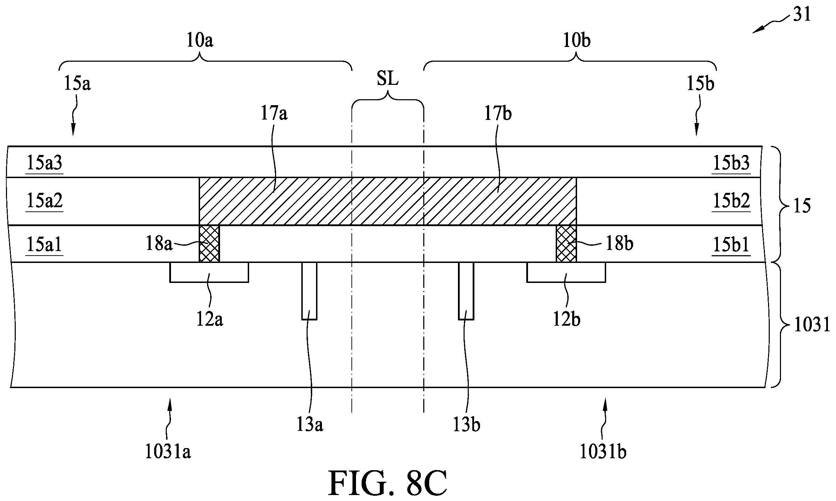

FIGS. **8C** shows a cross-sectional view of a portion semiconductor wafer **31** containing multiple edge-pad semiconductor dies according to some embodiments of the present disclosure. In some embodiments, as shown in FIG. **8C****,** a plurality of edge-pad semiconductor dies, e.g., exemplary edge-pad semiconductor dies **10a** and **10b,** are formed on a semiconductor wafer **31.** The boundaries of the adjacent edge-pad semiconductor dies **10a** and **10b** are defined by scribe line regions SL. In some embodiments, each edge-pad semiconductor die 10a or 10b includes a memory die **1031a** or **1031b** and an RDL **15a** or **15b** disposed over the respective memory die **1031a** or **1031b.** The memory die **1031a** or **1031b** further includes signal pads **12a** or **12b,** and seal rings **13a** or **13b,** in the memory dies **1031a** and **1031b,** respectively. Furthermore, the RDL **15a** or **15b** includes one or more conductive lines **17a** or **17b** or vias **18a** or **18b,** whichever appropriate for RDL design, electrically connected to the corresponding signal pads **12a** or **12b,** respectively. The RDL **15a** (or **15b)** further includes stacked dielectric or isolating layers **15a1, 15a2** and **15a3** (or **15b1, 15b2,** or **15b3),** within which the conductive line **17a** or **17b** is located. In some embodiments, the exposed portion of the conductive line or via **17a** or **17b** after wafer dicing performed in the scribe line region SL serves as the edge pad as previously described, such as shown in FIGS. **8B****.** The dielectric or isolating layers in one embodiment may be made of SiO₂.

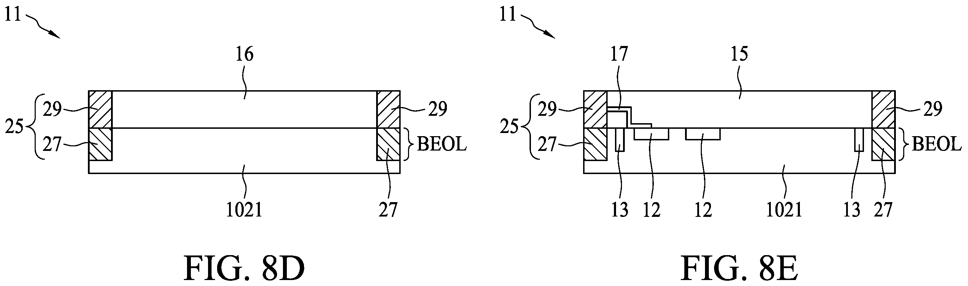

FIGS. **8D** and **8E** show cross-sectional views of the edge-pad semiconductor die or chip **11,** according to some embodiments of the present disclosure. In some embodiments, the memory die **1021** of the edge-pad semiconductor die **11** has edge contacts **27** formed during the manufacturing process of the BEOL region, such as formed in a M4 or M5 metal layer. To increase the contact area of the edge pad, a dielectric layer **16** with one or more conductive via **29** or conductive lines is formed over the memory die **1021.** Referring to FIG. **8D****,** the conductive via **29** may correspond to or be aligned with the respective edge contacts **27.** In some embodiments, the area (for example, the exposed lateral area) of the conductive via **29** is greater than that of the edge contact **27.** In some embodiments, the edge contact **27** is electrically or physically connected to the corresponding conductive via **29.** Thus, each edge pad **25** of the edge-pad semiconductor die **11** may include an edge contact **27** and a conductive via **29.** In another embodiment, the dielectric layer **16** is replaced by the RDL **15,** as shown in FIG. **8E****.** Same numeral labels in FIG. **8D** and FIG. **8E** refer to substantially identical or functionally identical components and the associated description can be referred thereto without repeating here for brevity.

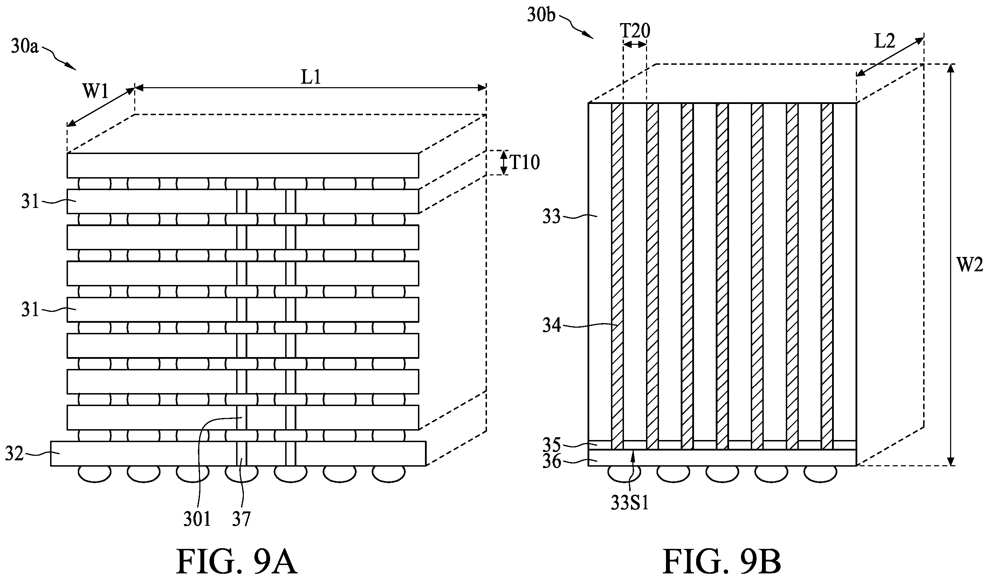

FIG. **9A** shows a perspective view of a conventional high-bandwidth memory (HBM) structure **30a,** which includes a plurality of DRAM chips **31** (such as 12 chips for HBM3 or 16 chips for HBM4) vertically stacked together above a controller **32,** wherein each DRAM chip **31** has a width **W1** about 9.5mm, a length **L1** about 10.5mm, and a thinner thickness **T10** about 0.05mm due to the requirement of multiple TSVs **37** therein. Usually, four DRAM chips **31** are grouped together to output 1K bits of data bus width, wherein each DRAM chip **31** outputs 256 bits. Thus, when 12 DRAM chips in the HBM3 configuration are divided into three group, each group with 4 DRAM chips can output 1K bits of data, respectively.

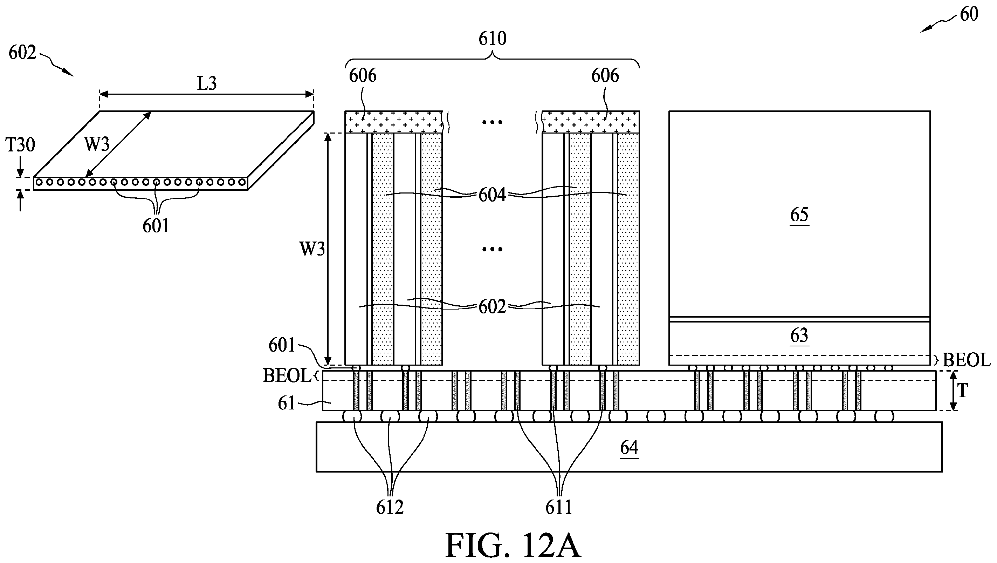

FIG. **9B** shows a perspective view of a NuHBM stack or shelf **30b,** according to some embodiments of the present disclosure. In contrast to the conventional HBM structure **30a,** the NuHBM stack or shelf **30b** of the present invention includes a plurality of edge-pad semiconductor dies **33,** a plurality of high thermal conductivity layer **34** (optionally), and a memory controller **36.** In some embodiments, the plurality of edge-pad semiconductor dies **33** are horizontally separate or horizontally stacked together, such as 16 or 24 chips or more. In some embodiments, each edge-pad semiconductor chips **33** has a width **W2** of about 9.5mm, a length **L2** of about 10.5mm (like the one used in the HBM stack structure **30a),** and a regular thickness **T20** about 0.5mm without TSVs therein. Moreover, for heat dissipation purposes, the high thermal conductivity "HTC" material or layer **34** (such as SiC/AlN/BN/W/Cu/undoped polysilicon/large crystalline silicon......) is disposed adjacent to one edge-pad semiconductor chip **33** respectively, or disposed between two disposed edge-pad semiconductor chips **33.** Furthermore, although not separately shown in FIG. **9B****,** one or more HTC material or layers, e.g., the feature **606** shown in FIG. **12A****,** could be used to cover the top of the edge-pad semiconductor dies or chips **33** and couple to the other HTC layer **34** between the edge-pad semiconductor dies **33.**

The NuHBM shelf **30b** may further include a plurality of edge pads 35 arranged along a lower sidewall **33S1** in the direction of the length **L2** about 10.5mm. For example, when the hybrid bonding with a bonding pitch of about 5µm is used, each edge-pad semiconductor die **33** has 2100 edge (I/O) pads **35** (10.5mm/5µm=2100) in the direction of the length **L2;** and when solder ball bonding with a bonding pitch of about 30µm is used, each edge-pad semiconductor die **33** has 350 edge pads **35** (10.5mm/30µm=350), and when the bonding pitch is 40µm and the length **L2** is 10.5 mm, it could provide 262 edge pads **35** (with a 128-bit output data for I/O). If necessary, an edge RDL (see U.S. Application No. 18/471,670, and U.S. Application No. 19/059,275, all content of which is incorporated by reference herein) could be optionally used for the formation of edge pads. Therefore, suppose one half of the edge pads **35** are used for data I/O, each edge-pad semiconductor chip **33** could have 175-bit output data (assuming a bonding pitch of about 30µm) or 1K-bit output data (a bonding pitch of about 5µm), or other numbers of the edge pads **35** depending on the different bonding pitches. The plurality of edge-pad semiconductor dies **33** (i.e., NuHBM stack or shelf) are electrically coupled to the memory controller 36 through the edge pads **35,** such that the memory controller **36** can output the data with a desired data width based on the number of output data of one edge-pad semiconductor die **33,** the combined output data of two or more edge-pad semiconductor dies **33,** or the combined output data of all edge-pad semiconductor dies **33.**

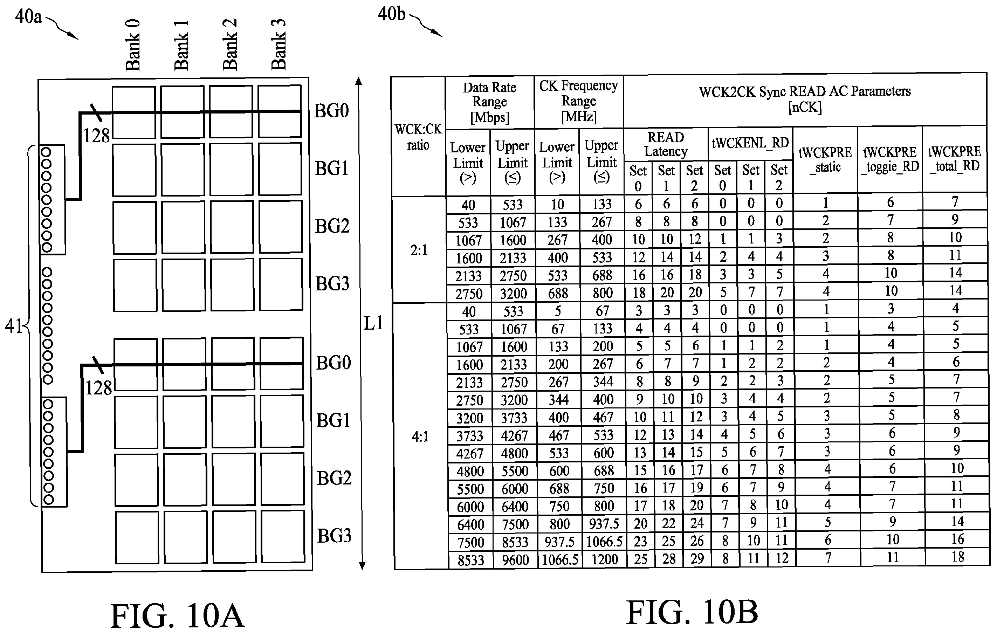

FIGS. **10A** and **10B** respectively show an exemplary layout **40a** and a specification table for a low power double data rate 5 (LPDDR5) memory chip. The 16Gb (gigabit) LPDDR5 memory chip **40a** may have an area of around **47** mm², in which all pads **41** of the LPDDR5 chip 40a are located close to the edge of the chip with a data width of 16 bits. Each I/O pad **41** has a bandwidth of about 9.6Gb/s. In the event the 16Gb LPDDR5 memory chip **40a** is used for the edge-pad semiconductor chip of the present invention, it may have 759 edge pads **35** along the direction of a length **L1** of about 7.59mm when the boning pitch is about 10µm, wherein assuming one half of the edge pads **35** are used for data I/O, each edge-pad semiconductor die adopting the LPDDR5 memory chip **40a** could have a data bus width of 379 bits. If four such 16Gb LPDDR5 memory chips 40a are horizontally stacked together as an NuHBM shelf, each NuHBM shelf can have a data bus width of 1516 bits (379 bits × 4) and a bandwidth around 14553 Gb/s (1516 × 9.6 Gb/s).

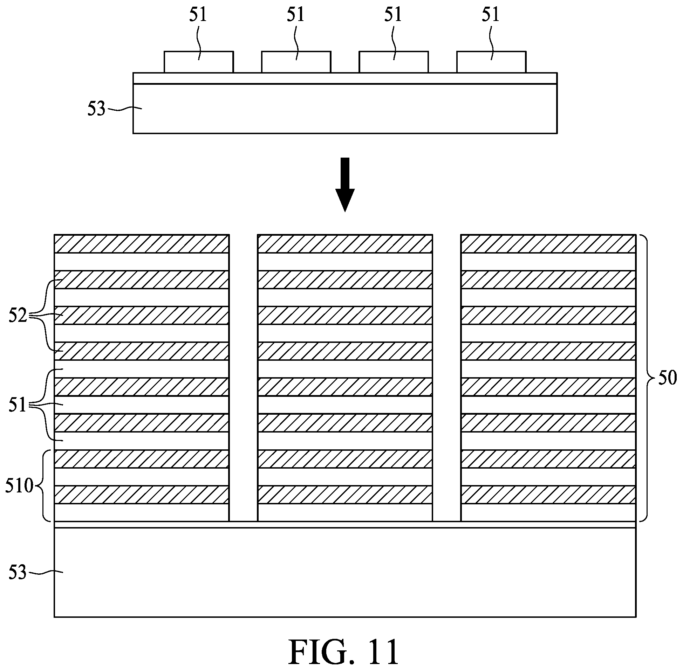

FIG. **11** shows cross-sectional views of intermediate stages of forming a NuHBM stack or shelf **50,** according to some embodiments of the present disclosure. As shown in an upper plot and a lower plot of FIG. **11****,** multiple NuHBM stack or shelf **50** can be formed by bonding multiple edge-pad semiconductor chips **51** and HTC layers **52** to a carrier **53,** followed by:
(1) Stacking more edge-pad semiconductor chips **51** of the same size to first form a short NuHBM stack **510,** wherein, a high thermal conductivity "HTC" material or layer **52** (such as AlN/BN/W/Cu/......) are inserted between two adjacent edge-pad semiconductor chips **51.** In some embodiments, the thermal conductivity (or thermal conductivity coefficient) of the high thermal conductivity layer **52** is higher than that of Si or SiO₂.
(2) Combining multiple short NuHBM stacks **510** together to form the NuHBM shelf **50** which are thick enough for ease of subsequent processing.
(3) Performing carrier release of the carrier **53,** and release the NuHBM shelf 50.

The present invention further utilizes the NuHBM system for 3D IC without using wafer or interposer in the COWOS structure **20** shown in FIG. **1****.** FIGS. **12A to 12C** show a 3D IC structure **60** according to some embodiments of the present disclosure. As shown in a right plot of FIG. **12A****,** the 3D IC structure **60** includes (1) a package substrate **64,** (2) a memory controller **61** (also referred to as "logic die with memory controller" throughout the present disclosure), (3) an NuHBM shelf **610,** (4) an SOC (System-on-a-Chip) chip **63** (also referred to as "logic die with processor circuit" throughout the present disclosure) and (5) optionally a heat sink **65.** The NuHBM shelf or stack **610** includes a plurality of edge-pad semiconductor dies (or semiconductor dies) **602,** optionally a plurality of high thermal conductivity layers **604** (also referred to as "upward extending high thermal conductivity layer" throughout the present disclosure) and optionally a top-high thermal conductivity layer **606** (also referred to as "laterally extending high thermal conductivity layer" throughout the present disclosure). There may be another adhesive layer between the edge-pad semiconductor die **602** and the high thermal conductivity layer **604.**

The NuHBM shelf **610** and the SOC chip **63** are electrically bonded to the memory controller **61.** The memory controller **61** is bonded to the package substrate **64.** Thus, there is no silicon interposer between the NuHBM shelf **610** (or the memory controller **61)** and the package substrate **64.** The heat sink **64** may be disposed over the SOC chip **63** and have a top surface substantially level with a top surface of the NuHBM shelf **610.**

In some embodiments, the package substrate **64** is a PCB (printed circuit board) substrate. The package substrate **64** may be a laminated substrate formed of multiple layers of copper foils with electrically insulating laminated materials, in which the laminated materials include fiberglass-reinforced epoxy resins, also known as FR-4, Teflon, polyimide, ceramic, or other suitable materials.

Any commercially available DRAM die, such as DDR4 die, DDR5 die, LDDR4 die, LDDR5 die, or GDDR7 die, etc. could be used as the edge-pad semiconductor die **602.** For example, as shown in a left plot of FIG. **12A****,** each edge-pad semiconductor die **602** in an example has a die size of about 5 or 6.25 mm (for a width **W3),** 10 mm (for a length **L3),** and 100µm (for a thickness **T30).** Each edge-pad semiconductor die **602** may include edge pads **601** arranged along a sidewall in the lengthwise direction of the edge-pad semiconductor die **602.** Thus, in some embodiments, each edge-pad semiconductor die **602** could have the edge pads **601** with a number of about 500 when the pad pitch is about 20µm (10mm/20µm) in the lengthwise direction **(L3),** wherein at least 250 edge pads **601** or more could be used as data pads.

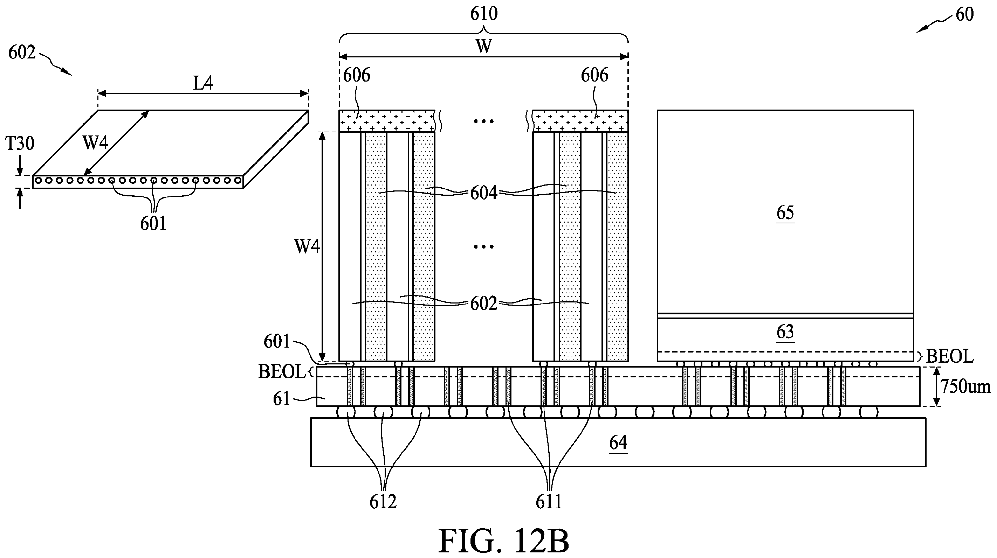

Nevertheless, embodiments of the present invention could be used in different die sizes of the edge-pad semiconductor die **602** and different bonding pitches for the edge pads **601.** For example, referring to FIG. **12B****,** each edge-pad semiconductor die **602** could have a reticle size or maximum scanner field area (MSFA) with 26mm (for a width **W4)** x 33mm (for a length **L4).** In the event the bonding pitch about 100µm is used, each edge-pad semiconductor die **602** could have 330 I/O edge pads **601** along the length direction with 33 mm, wherein suppose one half of 330 I/O edge pads **601** could be used for a data bus, that is, a data width of 165-bit I/O edge pads **601.** If the NuHBM system **610** includes 24 edge-pad semiconductor dies **602,** there are 3,960 data I/O edge pads **601** (24×165=3,960) for the NuHBM system 600 in the depicted embodiment, which is larger than the data width of 2K bits used in the HBM4 specification. Such edge-pad semiconductor die **602** with a 26mm (for the width **W4)** x 33mm (for the length **L4)** reticle may have about 172.7 to 207.**2G**b capacity. For example, a DRAM cell size for one bit storage is about 0.002484µm², and if the cell efficiency is 50%, then 33mmx26mmx0.5/0.002484µm²= 172.**7G**b (gigabits), or if cell efficiency is 60%, then 33mmx26mmx0.6/0.002484µm²= 207.**2G**b. Thus, in the event there are 24 edge-pad semiconductor dies **602** combined together in one NuHBM system **610,** the NuHBM system **610** can provide a capacity of about 518.1 to 621.6GB (24×172.**7G**b to 24×207.**2G**b). Of course, bigger edge-pad semiconductor die **602** could be used as well for bigger storage capacity in the present invention, for example, each edge-pad semiconductor die **602** could have a die size of about 26×2 mm (for a width **W),** 33×3 mm (for a length **L),** and 100µm (for a thickness **T),** and this die area is equal to 6 reticle sizes (each reticle size is expressed by 26 mm×33 mm). Each edge-pad semiconductor die **602** may include edge pads **601** arranged along a sidewall in the lengthwise direction of the edge-pad semiconductor die **602.** Thus, in some embodiments, each edge-pad semiconductor die **602** could have the edge pads **601** with a number of about 5K when the pad pitch is about 20µm (99mm/20µm) in the lengthwise direction **(L3),** wherein at least 2.5K edge pads **601** or more could be used as data pads.

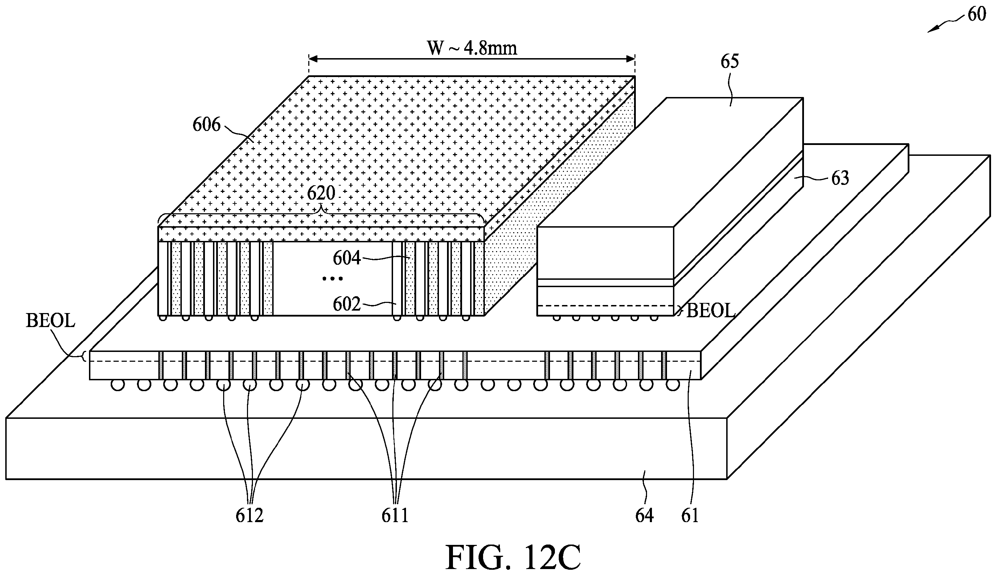

FIG. **12C** is the stereoscopic view of FIG. **12A** or FIG. **12B****,** as mentioned, the power/control/data signals of each edge-pad semiconductor die **602** of the NuHBM system **610** could be propagated to the memory controller **61** without through other edge-pad semiconductor dies **602.** Moreover, since there is high thermal conductivity layer **604** (such as AlN, BN, W, SiC, Copper, etc.) between two adjacent edge-pad semiconductor die **602** and connected to a top-high thermal conductivity layer **606** on other sidewall(s) of the NuHBM system **610,** the heat generated from those edge-pad semiconductor dies **602** could be spread through the high thermal conductivity layer **604** to the top-high thermal conductivity layer **606,** and passed to other heat sink (not shown) connected to the top-high thermal conductivity layer **606.** It should be noted that FIG. **12A****,** FIG. **12B****,** and FIG. **12C** of this embodiment are just sketched and exemplary drawings, and the components in those drawings may not be proportional to their real sizes.

As shown in FIG. **12C****,** in the event each edge-pad semiconductor die **602** has a length of 33 mm and a width of 26 mm (that is, the die area is equal one reticle size by 26 mm×33 mm), to accommodate the NuHBM system **610** with such edge-pad semiconductor dies **602,** the die area of the memory controller **61** could be 26mm (width)*66mm (length), which is around 2 reticle sizes. However, since the width **(W)** of the NuHBM system **610** with 24 edge-pad semiconductor dies **602** and 24 high thermal conductivity layers **604** is just around 4.8mm (the thickness of each edge-pad semiconductor die **602** and each high thermal conductivity layer **604** is around 100µm), the rest of the die area of the memory controller **61** could still accommodate another SOC chip **63,** such as CPU, GPU, etc. The area of the memory controller **61** is dependent on the size and number of the NuHBM system **610** and the SOC chip **63.** Furthermore, it is possible that there are two or more NuHBM system **610** over the memory controller **61.**

Both of the SOC die **63** and the edge-pad semiconductor dies **602** are designed to be disposed over the surface of the memory controller **61.** Their IOs are well connected by monolithic interconnections. The outgoing pads of the SOC die **63** are made in the electrical connection to the package substrate **64** through the memory controller **61.** On the memory controller **61,** the controller circuits are designed at the front surface, shown by a dash line with a label "BEOL" (back end of line), well connected to the IOs of the SOC die **63** designed at the bottom surface (shown by a dash line with a label "BEOL"). In this memory controller **61,** TSVs **611** are made across the die thickness, and micro bumps or hybrid bumps **612** are electrically connected to the TSVs **611.** The IOs of the SOC die **63** could be electrically connected to the IOs edge pads of semiconductor dies **602** through the memory controller **61.** Then the memory controller **61** is electrically connected to the package substrate **64** with properly designed alignment. In some embodiments, the thickness **(T)** of the memory controller **61** is about 750µm.

Although in this example the memory controller **61** is facing upward (shown by a dash line with the label "BEOL" in FIG. **12A****),** in another example the memory controller **61** could be facing downward or flipped and connected to the package substrate **64.** Since there are TSVs **611** in the memory controller **61,** the edge-pad semiconductor dies (or semiconductor dies) 602 could be electrically connected to the memory controller **61** through the TSVs **611** therein or RDLs (not shown) over the memory controller **61.**

These IOs output high-bandwidth data, and the memory controller 61 can be designed to select an appropriate number of IOs (such as, a portion of data IOs of one semiconductor die **602,** all data IOs of one semiconductor die **602,** portion of data IOs of multiple semiconductor dies **602,** or all data IOs of multiple semiconductor dies **602)** either by a cross-bar circuit design. In another embodiment, SRAM array is used to conduct the data IOs of the NuHBM shelf **610** from part or all semiconductor dies **602.** For example, a plurality of SRAM arrays are respectively corresponding to the plurality of semiconductor dies **602,** and each SRAM array temporarily holds the selected appropriate number of IOs from the corresponding semiconductor dies **602.** In some embodiments, the plurality of edge pads 601 of each semiconductor die **602** includes a subset of data pads, and the memory controller **61** selects a predetermined data bits from the data pads **601** of one semiconductor die **602,** a portion of the plurality of semiconductor dies **602,** or all the plurality of semiconductor dies **602.** The selected appropriate number of IOs of each semiconductor die **602** could be set by a mode register in each semiconductor dies **602.**

As previously mentioned, the memory controller 61 of the present invention includes multiple TSVs **611,** such that the power/control/data signals of each semiconductor die **602** and/or the SOC die **63** could be received or transmitted through the memory controller **61** to the package substrate **64,** as shown in FIG. **12A****.** Additionally, the heat sink **65** is disposed over the SOC die **63,** such that the top surface of the combination of the heat sink **65** and the SOC die **63** could be leveled with the top surface of the NuHBM shelf **610.**

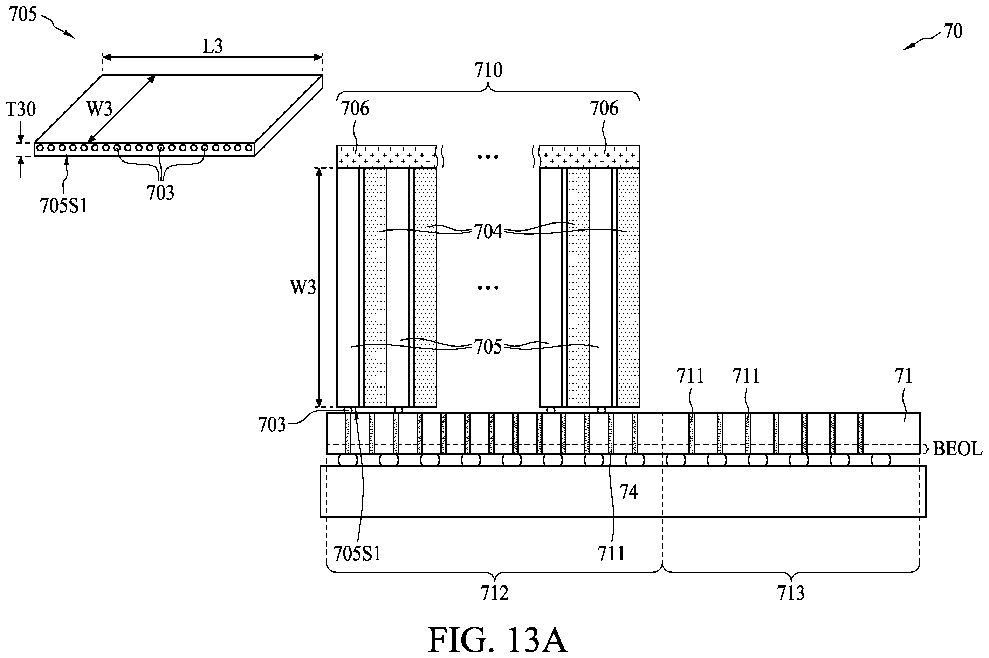

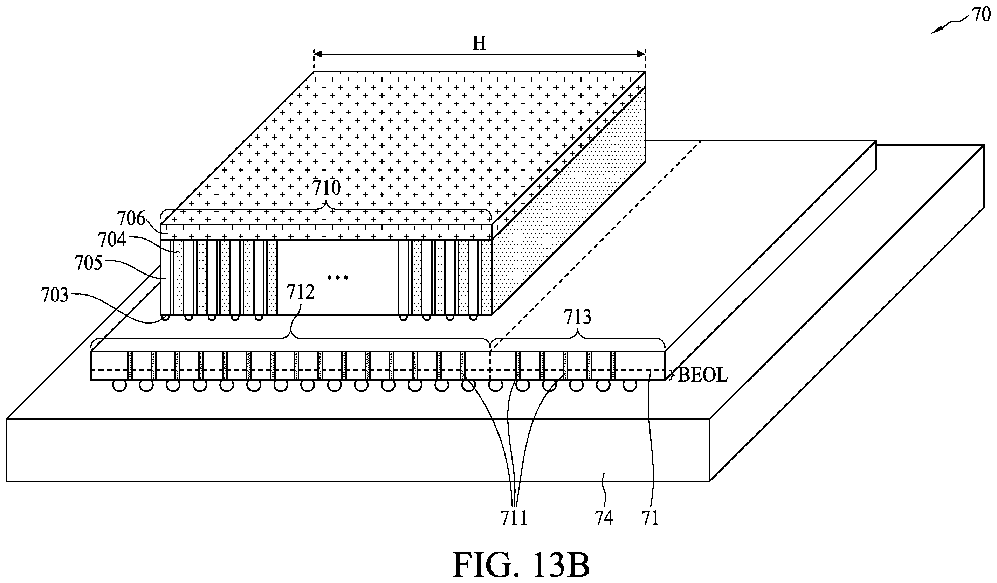

FIGS. **13A** shows another 3D IC structure **70** according to some embodiments of the present disclosure, and FIG. **13B** is the stereoscopic view of the 3D IC structure **70.** As shown in a right plot of FIG. **13A****,** the 3D IC structure **70** includes a package substrate **74,** a logic die **71** including memory controller and processor circuit, and an NuHBM system or stack **710** which includes a plurality of edge-pad semiconductor dies **705,** optionally a plurality of high thermal conductivity layers **704** and optionally a top-high thermal conductivity layer **706.** The NuHBM system **710** is electrically connected to the package substrate **74** through the logic die **71.** Each semiconductor die **705** may include edge pads **703** arranged along a sidewall **705S1** in the lengthwise direction (L3) of the semiconductor die **705.** The materials and configurations of the package substrate **74,** the edge-pad semiconductor dies **705,** the high thermal conductivity layer **704** and the top-high thermal conductivity layer **706** are similar to those of the package substrate **64,** the edge-pad semiconductor dies **602,** the high thermal conductivity layer **604** and the top-high thermal conductivity layer **606,** respectively, and details of these features are not repeated for brevity.

As shown in FIG. **13A****,** the SOC die (or processor circuit) is combined with the memory controller to be a single logic die, that is, the logic die **71** under the NuHBM shelf **710** includes not only the memory controller **712,** but also the SOC die **713** (such as GPU, CPU, NPU, TPU, FPGA, etc.), and the memory controller **712** of the logic die **71** could be disposed right under the NuHBM shelf **710.** In this embodiment, the logic die **71** is disposed over the packaging substrate **74** in a flip-chip manner, that is, the memory controller **712** and the SOC **713** circuits are designed at the bottom surface of the logic die **71** (shown by a dash line with a label "BEOL"). The logic die **71** further includes TSVs **711** penetrating through the logic die **71** (especially from the memory controller circuit to the NuHBM shelf **710),** and may include RDLs (not shown) on both sides of the optionally. Of course, there could be a heat sink (not shown) over the SOC die area, such that the top surface of the heat sink could be leveled with the top surface of the NuHBM shelf **710.** Similarly, FIG. **13A** and FIG. **13B** of this embodiment are just sketched and exemplary drawings, and the components in those drawings may not be proportional to their real sizes.

Moreover, since the NuHBM shelf **710** includes high thermal conductivity layer **704** (such as AlN, BN, W, Copper, etc.) between two adjacent semiconductor dies **705** and connected to a top-high thermal conductivity layer **706** on other sidewall(s) of the NuHBM shelf **710,** heat generated from those semiconductor dies **705** could be spread through the high thermal conductivity layer **704** to the top-high thermal conductivity layer 706, and passed to other heat sink (not shown) connected to the top-high thermal conductivity layer **706.**

Although in this example the logic die **71** is facing downward (shown by a dash line with a label "BEOL" shown in FIG. **13A****),** in another example the logic die **71** could be facing upward. Since the logic die **71** includes TSVs **711** and may further include RDLs, the logic die **71** could be electrically connected to the package substrate **74** through the TSVs **711** in this embodiment. Moreover, the signal and the power connections/transmissions in the present invention could be either based on the logic die **71,** or based on the package substrate **74** (through the logic die **71).**

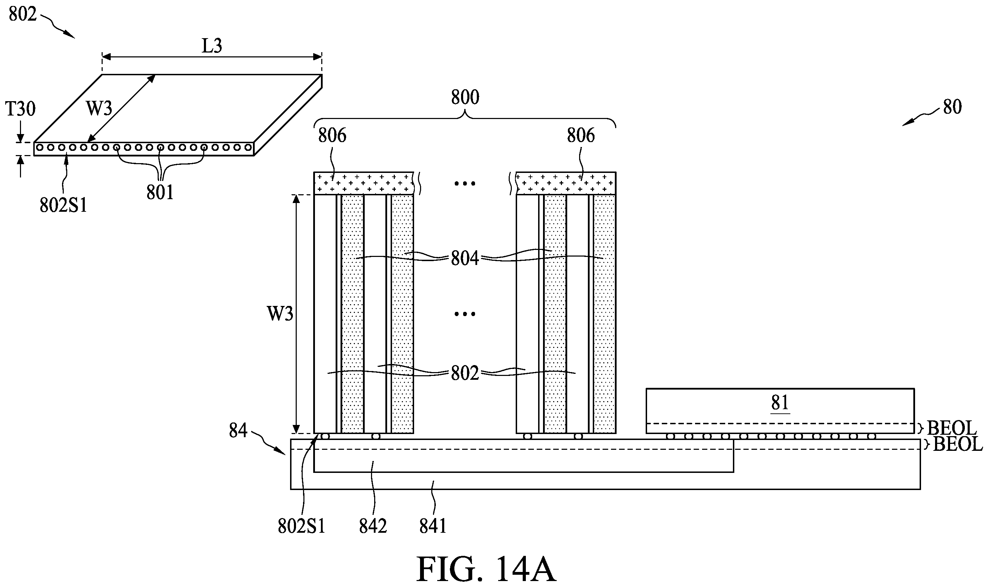

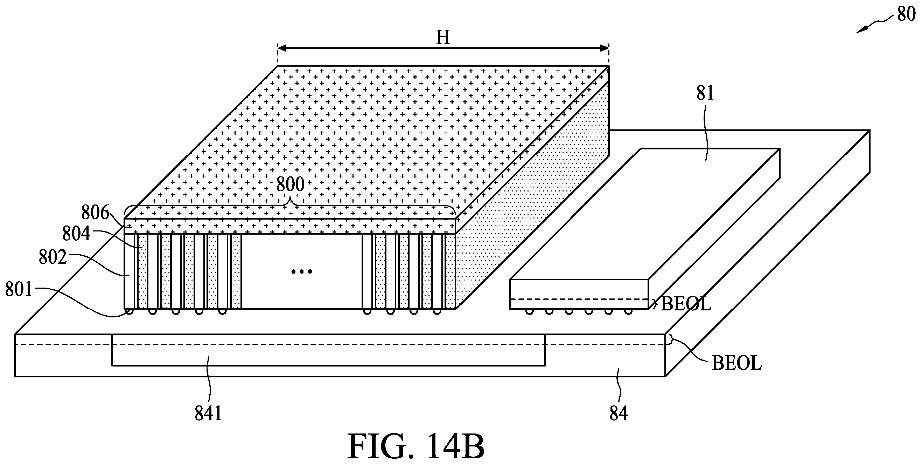

FIGS. **14A** shows another 3D IC structure **80** according to some embodiments of the present disclosure, and FIG. **14B** is the stereoscopic view of the 3D IC structure **80.** As shown in a right plot of FIG. **14A****,** the 3D IC structure **80** includes a package substrate **84,** a logic die **81** including memory controller and processor circuit, and an NuHBM system or NuHBM shelf **800** which includes a plurality of edge-pad semiconductor dies **802,** optionally a plurality of high thermal conductivity layers **804** and optionally a top-high thermal conductivity layer **806.** Each semiconductor die **802** may include edge pads **801** arranged along a sidewall **802S1** in the lengthwise direction **(L3)** of the semiconductor die **802.** The NuHBM system 800 is physically and electrically bonded to the package substrate **84.** The materials and configurations of the semiconductor dies **802,** the high thermal conductivity layer **804** and the top-high thermal conductivity layer **806** are similar to those of the semiconductor dies **602,** the high thermal conductivity layer **604** and the top-high thermal conductivity layer **606,** respectively, and details of these features are not repeated for brevity.

As shown in FIG. **14A****,** the NuHBM system **800** and the logic die **81** are separately disposed on the packaging substrate **84.** In some embodiments, the package substrate **84** includes a base portion **841,** which is formed of a material similar to the package substrate **64** or **74,** and an EMIB (Embedded Multi-die Interconnect Bridge) **842** embedded in the base portion **841,** in which the EMIB **842** may be exposed from an upper surface of the base portion **841** of the package substrate **84** and used for electrical connection between the NuHBM system **800** and the logic die **81.** Again, the logic die **81** is disposed over the packaging substrate **84** in a flip-chip manner, that is, the memory controller and the SOC or processor circuits are designed at the bottom surface (shown by a dash line with a label "BEOL") of the logic die **81.** However, there is no TSV penetrating through the logic die **81.** Of course, there could be a heat sink (not shown) over the logic die **81,** such that the top surface the heat sink could be leveled with the top surface of the NuHBM system **800.** Similarly, FIG. **14A** and FIG. **14B** of this embodiment are just sketched and exemplary drawings, the components in those drawings may not be proportional to their real sizes.

Although in this example the logic die **81** is facing downward (shown by a dash line with a label "BEOL" in FIG. **14A****),** in another example the logic 81 is facing upward. Since there could be TSVs and/or RDLs (not shown) in the logic die **81,** the logic die **81** could be electrically connected to the package substrate **84** through these TSVs. Moreover, the signal and the power connections/transmissions in the present invention could be either based on the logic die **81,** or based on the package substrate **84.**

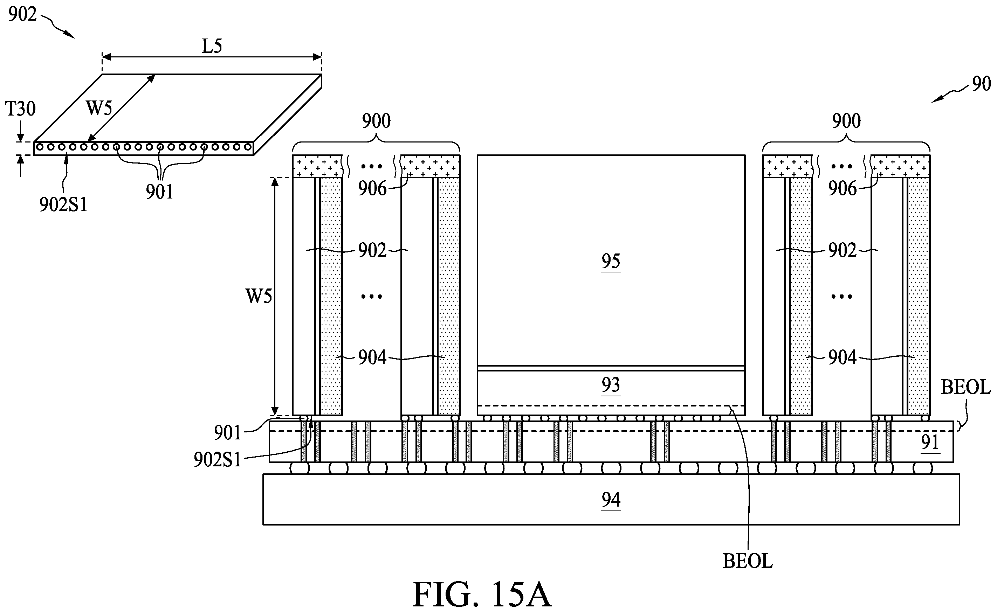

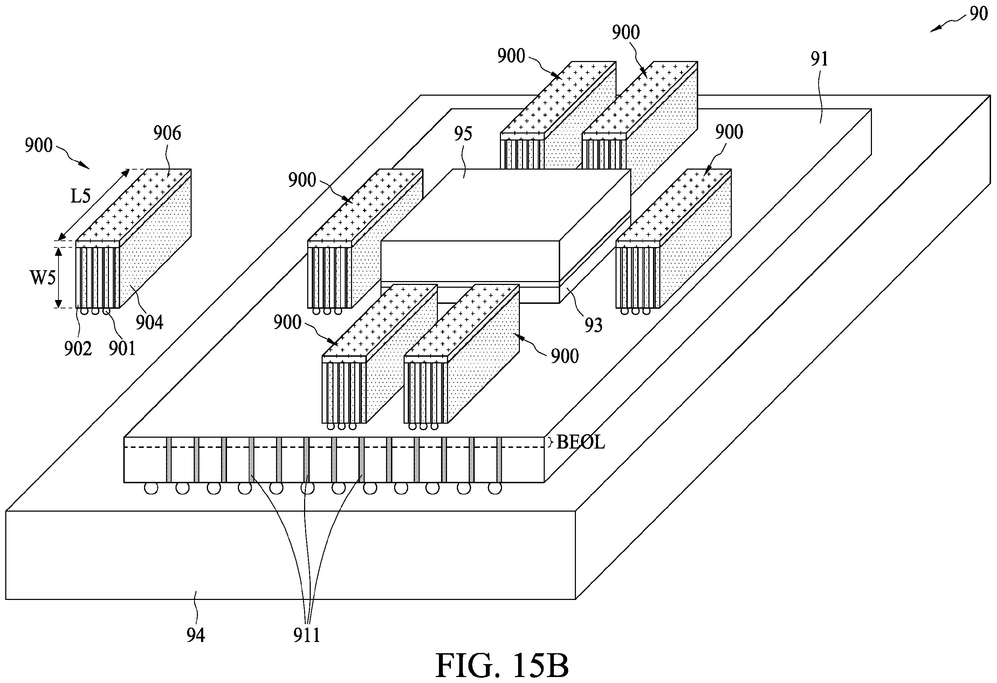

FIGS. **15A** shows another 3D IC structure **90** according to some embodiments of the present disclosure, and FIG. **15B** is the stereoscopic view of the 3D IC structure **90.** As shown in a right plot of FIG. **15A****,** the 3D IC structure **90** includes a package substrate **94,** a memory controller 91, a plurality of NuHBM systems or shelves **900** (each including a plurality of edge-pad semiconductor dies **902,** a plurality of high thermal conductivity layers **904** and a top-high thermal conductivity layer **906),** an SOC chip **93** and a heat sink **95.** Each NuHBM system **900** is separately and electrically bonded to the package substrate **94.** Each semiconductor die **902** may include edge pads **901** arranged along a sidewall **902S1** in the lengthwise direction **(L5)** of the HBM die **902.** The SOC chip **93** is electrically connected to the package substrate **94** through the memory controller **91.** The materials and configurations of the package substrate **94,** the semiconductor dies **902,** the high thermal conductivity layer **904,** the top-high thermal conductivity layer **906,** the memory controller **91,** the SOC chip **93** and the heat sink **95** are similar to those of the package substrate **64,** the semiconductor die **602,** the high thermal conductivity layer **604,** the top-high thermal conductivity layer **606,** the SOC chip **63** and the heat sink **65,** respectively, and details of these features are not repeated for brevity.

In some embodiments, twenty four (24) semiconductor dies **902** are split into 6 NuHBM systems 900, and each NuHBM system 900 comprises 4 semiconductor dies **902.** Those NuHBM systems **900** are placed on the 4 sides of the SOC die **93** (26mm x 33mm), as shown in FIG. **15B****.** Two NuHBM systems **900** are disposed along a lengthwise side (with the length of 33mm) of the SOC die **93,** another two NuHBM systems **900** are disposed along an opposite lengthwise side (with the length of 33mm) of the SOC die **93,** one NuHBM system **900** is disposed along a widthwise side (with the width of 26mm) of the SOC die **93,** and another one NuHBM system **900** is disposed along an opposite widthwise side (with the width of 26mm) of the SOC die **93.** Similarly, FIG. **15A** and FIG. **15B** of this embodiment are just sketched and exemplary drawings, the components in those drawings may not be proportional to their real sizes.

In the event each semiconductor die **902** is an LPDDR5 DRAM chip with special dimensions of 6.25mm width **(W5)** ×10mm length **(L5),** it may have 500 edge pads along the sidewall **902S1** of a length of 10 mm when the boning pitch is 20µm. Suppose about one half of the edge pads are used for data I/O, each semiconductor die **902** could have a 256-bit data width. If four such 16Gb LPDDR5 chips are horizontally stacked together as an NuHBM system **900,** each NuHBM system **900** can have a 1024-bit data width and a bandwidth about 9830 Gb/s (1024 × 9.6 Gb/s). Since the 3D IC structure **90** includes 6 NuHBM systems **900,** the total 6 NuHBM systems **900** can have a 6K-bit data width and a bandwidth about 58980 Gb/s ( 6 × 1024 × 9.6 Gb/s, wherein each I/O pad has a 9.6 Gb/s bandwidth).

In the event the bonding pitch is 10µm, it may have 1000 edge pads along the sidewalls of the length of 10 mm. Suppose about one half of edge pads are used for data I/O, each HBM die **902** could have a 512-bit data width. If four such 16Gb LPDDR5 chips are horizontally stacked together as an NuHBM system 900, each NuHBM system **900** can have a 2048-bit data width and a bandwidth about 19660 Gb/s (2048 × 9.6 Gb/s). Then the 3D IC structure **90** including 6 NuHBM systems **900** can have a 12K-bit data width and a bandwidth about 117964 Gb/s ( 6 × 2048 × 9.6 Gb/s). If each semiconductor die **902** in the NuHBM system 900 has a capacity of 32Gb, then each 4-layer NuHBM system **900** can have a capacity of 32Gb x 4= 128Gb, and the total 6 NuHBM systems **900** can support the capacity of 128Gb x 6=768Gb.

Of course, each NuHBM system **900** may have 6, 8, 10, or more semiconductor dies **902** in the present invention. For example, in FIG. **15A** and FIG. **15B****,** each NuHBM system **900** may have 10 semiconductor dies **902** and there are total 60 semiconductor dies **902.** Again, if each semiconductor die **902** is an LPDDR5 DRAM chip with special dimensions of 6.25mm width x10mm length, it may have 500 edge pads (which may include a 256-bit data width) along the sidewall **902S1** of the length of 10 mm when the boning pitch is 20µm. Each NuHBM system 900 can have a 2560-bit data width (256 bits × 10) and a bandwidth about 24576 Gb/s (2560 × 9.6 Gb/s, wherein each I/O pad has a 9.6 Gb/s bandwidth). Since the 3D IC structure **90** includes 6 NuHBM systems **900,** the total 6 NuHBM systems **900** can have a 15,360-bit data width and a bandwidth about 147456 Gb/s (6 × 2560 × 9.6 Gb/s). In the event the bonding pitch is 10µm, it may have 1000 edge pads (which may include a 512-bit data width) along the sidewall with the length of 10 mm. Each NuHBM system **900** can have a 5120-bit data width (512 bits × 10) and a bandwidth around 49152 Gb/s (5120 × 9.6 Gb/s). Then the 3D IC structure **90** including 6 NuHBM systems **900** can have a 12K-bit data width and a bandwidth about 294912 Gb/s (6 × 5120 × 9.6 Gb/s). If each semiconductor die 902 in the NuHBM system **900** has a 3**2G**b capacity, then each 10-layer NuHBM system **900** can have a capacity of 3**2G**b x 10= 320Gb, and the total 6 NuHBM systems **900** can support a capacity of 320Gb x 6=1920Gb.

The following table shows the comparison between several existing HBM systems (HBM3, HBM3E and HBM3E) and the proposed NuHBM systems (based on the LPDDR5 specification):

| | HBM3 | HBM3E | HBM4 | Proposed HBM system with 4 dice (6 group=24 dice) | Proposed HBM system with 10 dice (6 group=60 dice) |
|---|---|---|---|---|---|
| layers | 12 | 12 | 16 | 4 (24) | 10 (60) |
| Max Capacity | 24 GB | 36 GB | 48GB | 128Gb** =16GB (768Gb** =96GB) | 320Gb**=40GB (1920Gb** =240GB) |
| Data I/O | 1024 | 1024 | 2048 | 2048* (12288*) | 5120* (30720*) |
| I/O bandwidth | 6.**4**Gb/s | 9.**2**Gb/s | N/A | 9.6Gb/s (LPDDR5) | 9.6Gb/s (LPDDR5) |
| Total bandwidth | 819GB/s | 1.2TB/s | N/A (2.355 TB/s***) | 19660 Gb/s=2457 | 49152 Gb/s = 6144 |
| | | | | GB/s =2.457 TB/s (117964 Gb/s=14745 GB/s=14.745 TB/s) | GB/s =6.144 TB/s (294912 Gb/s=36864 GB/s=36.864 TB/s) |

| | | | | | |
|---|---|---|---|---|---|
| *bonding pitch=10µm **Each HBM die=32Gb ***Each I/O bandwidth=9.**2G**b/s | | | | | |

Under the above architecture to design a distributed NuHBM system 900 surrounding the 4 sides of the SOC chip **93,** each semiconductor **902** is definitely achievable with today's DRAM design skills in compliance with the specification of LPDDR5 (also applicable to the JEDEC standard). Since these I/Os of the NuHBM system **900** are electrically connected by the advanced bonding technology such as micro-bumps or hybrid-bonding methods to the I/O's of the SOC die **93** which should use the advanced logic technology such as 3nm or 5nm, a high performance and low power SOC-DRAM (HBM) interface will be achieved. The power distribution system may be achieved by the vertical TSV/RDLs connections between the bottom portion of the NuHBM system **900** and the bottom portion of the SOC chip **93** in the memory controller **91** (see FIG. **15A****),** and thus a large and stable current flow system can be well established.

For the embodiment shown in FIG. **15A** and **15B****,** 6 NuHBM systems **900** and the SOC die **93** are disposed over the memory controller 91 which is then disposed over the packaging substrate **94.** The memory controller **91** includes multiple TSVs **911.** Each NuHBM system **900** includes 4 or more layers of semiconductor dies **902** in a stacked structure along with the inventive thermal heat dissipation system and the edge I/O invention. In addition, the data latency on both row and column data read/write (R/W) performance should be achieved similarly like those of the LPDDR5 specification, as described in FIGS. **10A** and **10B****,** and the LPDDR5 latency specification should be achieved.

The above embodiment describes an example of the proposed inventive architecture of designing NuHBM systems to supply high-bandwidth/low-latency memory data to the SOC die. For example, if 24 semiconductor dies **902** are distributed to 8 NuHBM systems **900,** then each NuHBM system **900** just includes 3 semiconductor dies **902.**

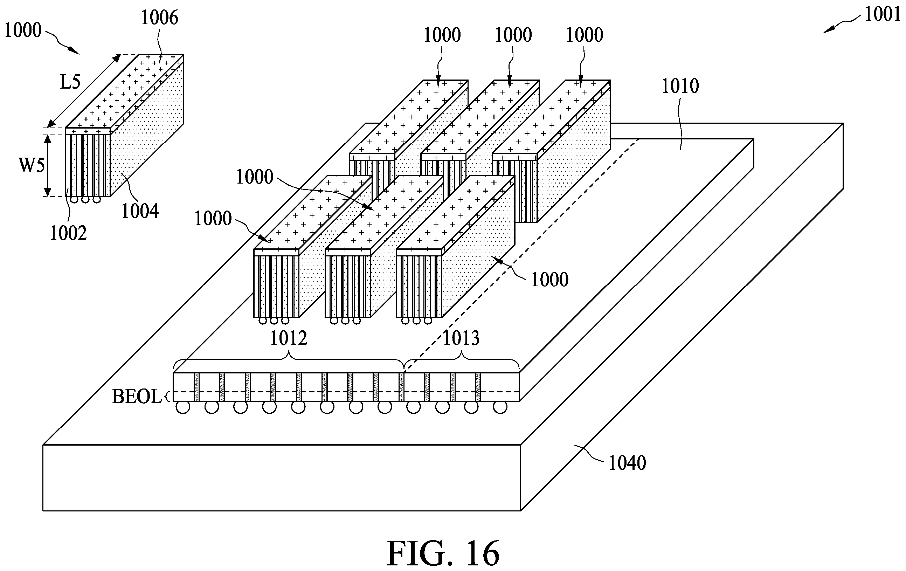

FIG. **16** shows another 3D IC structure **1001** of the present disclosure. The 3D IC structure **1001** includes a package substrate **1040,** a logic die **1010** with memory controller **1012** and SOC or processor circuit **1013,** a plurality of NuHBM systems **1000** (each including a plurality of edge-pad semiconductor dies **1002,** optionally a plurality of high thermal conductivity layers **1004** and optionally a top-high thermal conductivity layer **1006).** Each NuHBM system **1000** is electrically connected to the package substrate **1040** through the logic die **91.** The materials and configurations of the package substrate **1040,** the semiconductor die **1002,** the high thermal conductivity layer **1004,** the top-high thermal conductivity layer **1006,** and the logic die **1010** are similar to those of the package substrate **74,** the semiconductor die **705,** the high thermal conductivity layer **704,** the top-high thermal conductivity layer **706** and the logic die **71,** respectively, and details of these features are not repeated for brevity.

Similar to FIG. **15B****,** the 3D IC structure **1001** in FIG. **16** may include 24 edge-pad semiconductor dies **1002** split into 6 NuHBM systems **1000** and each NuHBM system **1000** comprises 4 semiconductor dies **1002.** However, unlike FIG. **15B****,** the SOC circuit **1013** of this embodiment is combined with the memory controller **1012** into the logic die **1010,** and the 6 NuHBM systems **1000** are stacked over the logic die **1010** with memory controller **1012** and SOC or processor circuit **1013.** Those 6 NuHBM systems **1000** could be bonded close to the memory controller **1012,** as shown in FIG. **16****.** Similarly, FIG. **16** of this embodiment are just sketched and exemplary drawings, the components in those drawings may not be proportional to their real sizes.

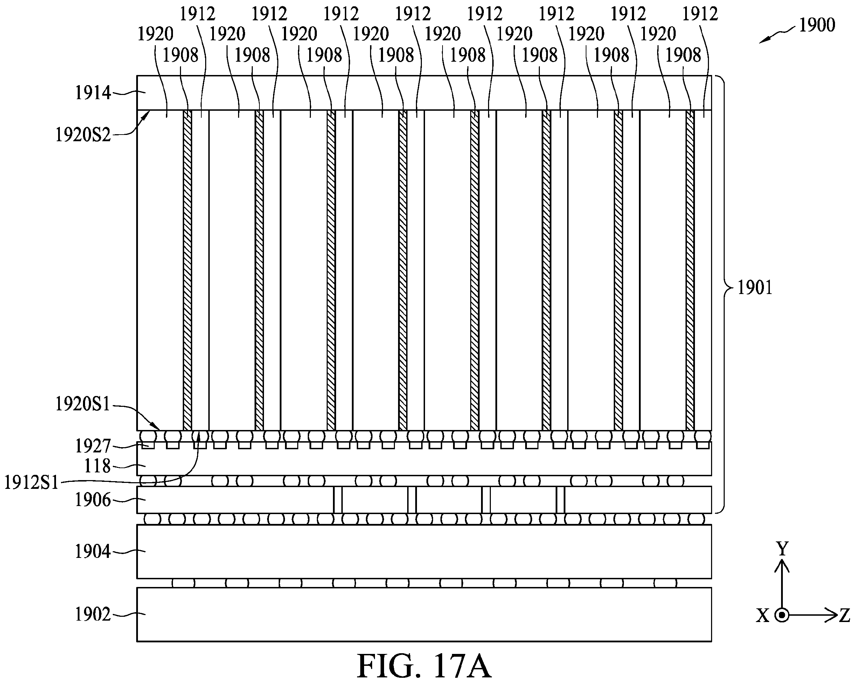

The short IC stacks **312** or the semiconductor packages **700A** then can be bonded to another interposer or IC chip, as shown in FIG. **17A** to form a semiconductor package assembly **1900** including a 3D IC structure stack **1901,** a substrate **1902,** an interposer **1904,** and a logic control chip **1906,** wherein the 3D IC structure stack **1901** in this embodiment includes a plurality of DRAM semiconductor dies **1920** (or a plurality of DRAM dies and control ICs) and a side RDL **118,** and each DRAM semiconductor die **1920** is horizontally separate from the others. The laterally extending RDL structure **118** on the sidewalls of the plurality of DRAM semiconductor dies (or DRAM and control ICs) **1920** is bonded to a logic memory control chip **1906** or the interposer **1904** which is then bonded to the substrate **1902.** The power/signaling functions of each DRAM semiconductor die **1920** could be taken care of using the RDL structure **118** which is connected to the logic memory control chip **1906** and the interposer **1904.** Unlike conventional HBM structure, in the present invention, each DRAM semiconductor die **1920** can transmit or receive power/signals independently without going through other DRAM semiconductor dies and each DRAM semiconductor die can generate high bandwidth data with low latency, therefore could be properly named HBLM (high bandwidth low latency memory), and the combination of the horizontally separated DRAM semiconductor dies **1920** could be named as HBLM Shelf.

Moreover, since there can exist an inter-(upward extending) high thermal conductivity layer **1912** (such as AlN, BN, W, copper, SiC, etc.) and optionally a HTC adhesive layer **1908** between the primary surfaces of two adjacent DRAM semiconductor dies **1920** which can be connected to a top-(laterally extending) HTC layer **1914** (such as AlN, BN, W, copper, SiC, etc.) on other sidewall(s) of the short 3D IC structure stack **1901,** the heat generated from those two DRAM semiconductor dies **1920** could be transmitted from the dies through the inter-high thermal conductivity layer **1912** to the top-high thermal conductivity layer **1914,** and then to a heatsinking device (e.g., a cold plate; not shown) thermally coupled to the HTC layer **1914.**

According to some embodiments, the RDL **118** further includes a plurality of bonding pads **1927** on an upper surface of the RDL **118** and electrically connecting the interposer **1904** to the DRAM semiconductor dies **1920.**

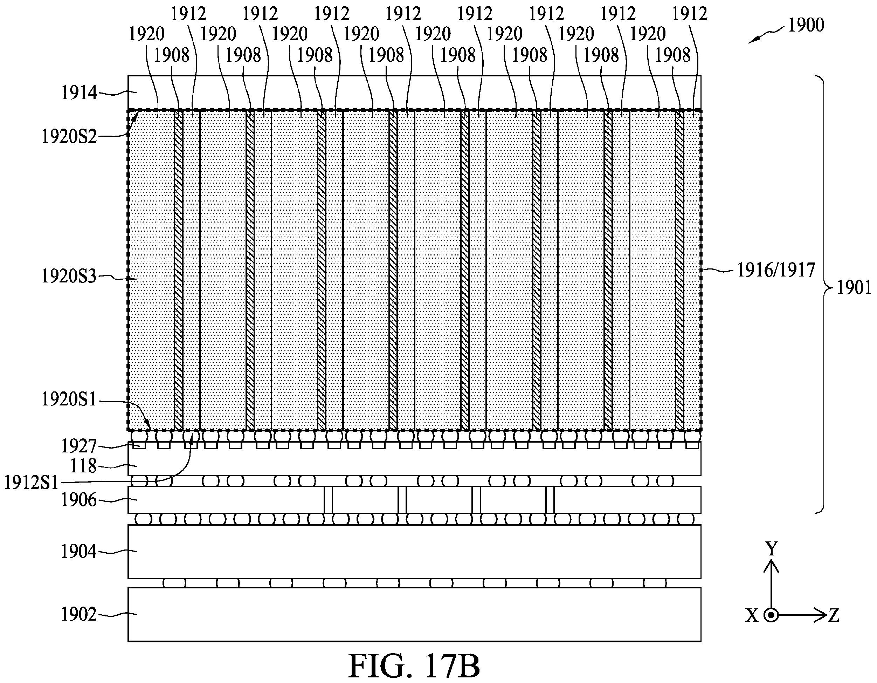

In the event there is a need to have more signals transmission in the plurality of DRAM semiconductor dies **1920,** as previously mentioned, more upward extending RDL structures **1916** could be formed on two or more side faces as shown in FIG. **17B****,** wherein the bottom RDL structure **118** is formed on one side face of the plurality of DRAM semiconductor dies **1920,** and another side RDL structure (or side RDL structures) could be formed on other side face(s) of the plurality of DRAM semiconductor dies **1920** opposite or adjacent to the inter-high thermal conductivity layer **1912** with the bottom RDL structure **118** electrically connected to these side RDL structure(s) **1916.**

In the event there is a need to have more heat dissipation in the plurality of DRAM semiconductor dies **1920,** as previously mentioned, more inter-HTC layers **1917** similar to the inter-HTC **1912** or the top HTC **1914** could be formed on two or more side faces and/or one or two of the primary surfaces, as shown in FIG. **17B****,** wherein the inter-HTC layer(s) **1917** is(are) thermally coupled to the top HTC **1914** and the inter-HTC **1912.** According to some embodiments, the HTC layers, **1912, 1914** and **1917,** have a thermal conductivity higher than that of silicon or SiO₂.

According to some embodiments, referring to FIGS. **17A** and **17B****,** an IC stack **1901** includes a plurality of IC structures **1920** horizontally separate with each other. Each IC structure **1920** can be the semiconductor structure in FIGS. **2C****~2F 3D~3F**, **4G-4N,** and **5A-5B,** and has a top surface **108P1,** a bottom surface **108P2** opposite to the top surface **108P1,** and four sidewalls **108S** with a first sidewall **1920S1** or **108S1,** a second sidewall **1920S2** or **108S2,** a third sidewall **1920S3** or **108S3** (parallel to the paper sheet) and a fourth sidewall (a sidewall opposite the sidewall **1920S3** shown in FIG. **17B** and parallel to the paper sheet or the sidewall **108S4** of FIG. **2D****).** The area of the bottom surface **108P2** or the top surface **108P1** is larger than that of any sidewall **102S** of FIG. **2C****,** e.g., **1920S1 (108S1), 1920S2 (108S2), 1920S3** (**108S3**) or **108S4.** The short 3D IC stack **1901** may further include a laterally extending RDL structure **118** covering the first sidewall **1920S1** of each of the plurality of IC structures **1920.**

According to some embodiments, referring to FIGS. **17A****,** **17B****,** FIGS. **4G** to **4N****,** **5A** to **5B** and **6E****,** each semiconductor structure includes a first integrated circuit (IC) structure, such as the IC structure **1920** in FIG. **17A** or **17B** or the die **122E** in FIGS. **4G** to **4N****,** and a first neighboring structure, such as the high thermal conductivity layer **1912** in FIG. **17A** or **17B****,** or the molding compound layer **242** and/or the die **122D** in FIGS. **4G** to **4N****,** physically separate from the first IC structure. The first IC structure and the first neighboring structure are (1) arranged along the first sidewall **1912S1** extending in the Z direction in FIG. **17A** or **17B****,** or (2) arranged along the first sidewall **1912S1** extending in the XZ plane in FIG. **17A** or **17B****.** In condition (2) described above, referring to FIGS. **4K** to **4N****,** the XZ plane of each of the IC structures **400E** to **400H** may face toward the RDL structure **118** and forming electrical connections therewith. The first IC structure **122E** and the first neighboring structure **122D** may be arranged on the XZ plane of each of the IC structures **400E** to **400H** and along the X direction depicted in FIG. **17A** or FIG. **17B****.** According to some embodiments, the laterally extending RDL structure **118** shown in FIGS. **17A** and **17B** comprises a first plurality of bonding pads **1927** arranged along the first sidewall of the respective semiconductor structure **1920,** wherein the first plurality of bonding pads are over or facing an edge of the first IC structure and an edge of the first neighboring structure.

In some embodiments, the first IC structure can contain more than one semiconductor die, e.g., dies **122E, 122G** and/or **122H** shown in FIGS. **4K** to **4N** or FIG. **6D****.** The first neighboring structure **122D** could be an active die or an HTC dummy interconnect spacer. The interconnect spacer can be a passive or an active silicon interposer. According to some embodiments, the interconnect spacer is a semiconductor interposer with a set of through-semiconductor vias (TSVs) electrically coupled to a subset of the first plurality of bonding pads or external connectors.

According to some embodiments, the first neighboring structure includes another IC structure, such as the semiconductor die **122D** shown in FIGS. **4G** to **4N****,** an interconnect spacer, such as the interposer **122D** shown in FIGS. **4G** to **4N****,** a molding compound layer, such as the potting material or molding compound layer **242** shown in FIGS. **4G** to **4N****,** or a high thermal conductivity (HTC) layer, such as the die **122D** shown in FIGS. **4G** to **4N****,** with the thermal conductivity higher than that of Si or SiO₂ so as to dissipate the heat generated from the adjacent IC structures.

According to some embodiments, the number of the first plurality of bonding pads **1927** is more than 1,300-1,500 per IC structure **1920.**

According to some embodiments, referring to FIG. **4G,** FIG. **4I**, FIG. **4K,** FIG. **4M****,** FIG. **5A** and FIG. **5B****,** the first IC structure **122E** or the another IC structure serving as the first neighboring structure includes a set of through-semiconductor vias (TSVs) **104B** exposed from the sidewall **102S** in the XZ plane and electrically coupled to a subset of the first plurality of bonding pads **1927** of the laterally extending RDL structure **118** of the 3D IC stack **1901** shown in FIG. **17A** or FIG. **17B****.**

According to some embodiments, referring to FIG. **4G,** FIG. **4H****,** FIG. **4K,** FIG. **4L****,** FIG. **5A** and FIG. **5B****,** the molding compound layer **242** includes a set of through-molding vias (TMVs) **232** exposed from a molding sidewall **102S** in the XZ plane and electrically coupled to a subset of the first plurality of bonding pads **1927** of the laterally extending RDL structure **118** (e.g., see also the RDL **118A** shown in FIG. **5A** or **5B****)** of the 3D IC stack **1901** shown in FIG. **17A** **or** **17B****.**

According to some embodiments, referring to FIG. **4G,** FIG. **4H****,** FIG. **4K,** FIG. **4L****,** FIG. **5A** and FIG. **5B****,** the first neighboring structure **122D** can include an interconnect spacer with or without active components, with a set of through-semiconductor vias (TSVs), similar to the TSVs **104B** in the first IC strutcure **122E,** exposed from the sidewall **102S** in the XZ plane and electrically coupled to a subset of the first plurality of bonding pads **1927** of the laterally extending RDL structure **118** of the short 3D IC stack **1901** shown in FIG. **17A** **or** **17B****.**

According to some embodiments, the IC stack **1901** further includes a high thermal conductivity structure, such as the interposer **1702 or 1706** in FIG. **17****,** between two semiconductor structures **1920, 1912** or next to some of the semiconductor structures **1920, 1912** of the IC stack **1901,** e.g., in a manner similar to the inter-high thermal conductivity layer **1912** shown in FIG. **17A** or **17B****.** The thermal conductivity of the high thermal conductivity structure is higher than that of Si or SiO₂.

According to some embodiments, each IC structure **1920** can be a DRAM semiconductor die, and the IC stack **1901**can be an HBM compatible structure.

According to some embodiments, the IC stack **1901** further includes the logic control chip **1906** under and electrically connected to the laterally extending RDL structure **118** of the IC stack **1901.**

According to some embodiments, referring to FIG. **17A** or **17B****,** the IC stack **1901** further includes the laterally extending thermal conductivity layer **1914** covering each second sidewall **1920S2** of the plurality of IC structures **1920,** wherein the laterally extending RDL structure **118** is opposite to the laterally extending thermal conductivity layer **1914,** and the thermal conductivity of the laterally extending thermal conductivity layer is higher than that of Si or SiO₂.

According to some embodiments, referring to FIGS. **17A** and **17B****,** an IC stack **1901** includes a plurality of IC structures **1920** horizontally separate with each other. Referring to FIGS. FIGS. **2C****~2F 3D~3F**, **4G-4N, 5A-5B** and **17A,** each IC structure **1920** can be referred to the IC structure **100A, 100A, 300A** to **300C, 400A** to **400H, 500A** and **500B in** FIGS. **2C** to **2F****,** **3D** to **3F****,** **4G** to **4N** and **5A** to **5B****.** As shown in FIG. **2D****,** each IC structure **1920** has dimensions similar to those of the RDL structure **108A** and includes a top surface **108P1,** a bottom surface **108P2** opposite to the top surface **108P1,** and four sidewalls with a first sidewall **1920S1** or **108S1,** a second sidewall **1920S2** or **108S2,** a third sidewall **1920S3** or **108S3** and a fourth sidewall **108S4.** The area of the bottom surface **108S2** or the top surface **108S1** is larger than that of any sidewall, e.g., **1920S1 (108S1), 1920S2 (108S2), 1920S3 (108S3)** and **108S4.** The IC stack **1901** may further include a laterally extending RDL structure **118** covering each first sidewall **1920S1 (108S1)** of each of the plurality of IC structures **1920.** The IC stack **1901** may also include an upward extending thermal conductivity layer **1912** between two adjacent IC structures **1920.** According to some embodiments, the thermal conductivity of the upward extending thermal conductivity layer **1912** is higher than that of Si or SiO₂, such as a SiC chip with the same size as the IC structure **1920.**

According to some embodiments, the IC stack **1901** further includes a laterally extending thermal conductivity layer **1914** covering each second sidewall **108S2** or **1920S2** of the plurality of IC structures **1920** and thermally coupling to each of the upward extending thermal conductivity layers **1912,** wherein the laterally extending RDL structure **118** is opposite to the laterally extending thermal conductivity layer **1914,** and the thermal conductivity of the laterally extending thermal conductivity layer **1914** is higher than that of Si or SiO₂ , such as a SiC chip.

According to some embodiments, the upward extending thermal conductivity layer **1912** or the laterally extending thermal conductivity layer **1914** includes a material of BN, AlN, W, SiC or copper.

According to some embodiments, referring to FIG. **17B****,** the IC stack **1901** further includes an upward extending RDL structure **1916** covering each third sidewall **108S3** or **1920S3** of the plurality of IC structures **1920,** wherein the upward extending RDL structure **1916** is electrically connected to the laterally extending RDL structure **118.**

According to some embodiments, each IC structure **1920** includes a DRAM semiconductor die, and the IC stack **1901** is a HBM-compatible structure (that is, the essential signals through its own IO pads **P31** to **P3N** is compatible with signal paths as defined by JEDEC for HBMs).

According to some embodiments, the IC stack **1901** further includes a logic control chip **1906** under and electrically connected to the laterally extending RDL structure **118** of the IC stack **1901.**

According to some embodiments, referring to FIG. **17A****,** **17B** and FIGS. **2C****,** **2D** to **2F, 3D** to **3F, 4G** to **4N, 5A, 5B** and **6E,** the IC structure **1920** can include the IC structure **100A** to **100C, 300A** to **300C, 400A** to **400H, 500A, 500B** and **600A** described therein. For example, referring to FIG. **5A, 5B** and FIG. **17A** or **17B****,** the IC structure **1920** includes the IC structure **500A,** and the IC structure includes a first semiconductor body **122F** and an interconnection structure **108A** or **108B.** The first semiconductor body **(122E** or **122F)** has a first primary surface **(102P)** and a first secondary surface **(102S),** with the first primary surface being substantially perpendicular to the first secondary surface. The interconnect structure includes a primary redistribution layer (RDL) (FIG. **5A****, 108A)** over the first primary surface **102P,** with the primary RDL **108A** having a second secondary surface (FIG. **5A****,108S)** that is aligned with the first secondary surface **102S** of the first semiconductor body **122F,** wherein the first secondary surface **102S** and the second secondary surface **108S** jointly form a secondary plane (FIG. **5A****, 500AS)** which could be corresponding to the first sidewall **1920S1** or second sidewall **1920S2** of the IC structure **1920,** wherein the primary RDL **108S** further comprises a first conductive element (FIG. **5A****, 212, 214)** exposed through the second secondary surface **108S** of the primary RDL **108A.**

According to some embodiments, the first conductive element can be a conductive pad **212** (see FIG. **2C****)** on a surface **108P** of the primary RDL structure **108A/108B** substantially parallel to the first primary surface **102P1,** a conductive via **216** (see FIG. **2G****)** connecting adjacent layers of the primary RDL **118A/118B,** a stacked via **214** (see FIG. **2G****)** traversing the primary RDL **118A/118B,** or a combination thereof.

According to some embodiments, the first semiconductor body **(122E** in FIG. **4G** or **4I**) further includes at least a through-silicon via **104B** (FIG. **4G****),** a through-molding via **232** (FIG. **4G****),** or an insulating element **242** (FIG. **4I**) exposed through the first secondary surface.

According to some embodiments, the first semiconductor body of the IC structure **1920** shown in FIG. **17A** or **17B** can be the counterparts as the semiconductor dies **400A** to **400H** or **600A** shown in FIGS. **4K** to **4N** or FIG. **6E** and includes (1) multiple first dies **122D** and **122E** placed in a same package layer (FIGS. **4K** to **4N****);** (2) multiple second dies **122G, 122H** vertically stacked (FIG. **6E****);** (3) multiple second dies **122G, 122H** placed side-by-side with other third dies **122E** in the same package layer (FIG. **6E****);** or a combination thereof. The first, second and third dies **122D, 122E, 122G, 122H** are of the same or different sizes.

According to some embodiments, the first semiconductor body (see the partial structure of the semiconductor die **600A** excluding the primary RDL **108C)** of the IC structures **1920** shown in FIG. **17A** or **17B** also includes a plurality of conductive vias **104B** (see the semiconductor die **122E),** pillars **224** or plugs **234** of same or different lengths, electrically connecting the multiple first dies **122E, 122G** and **122H** to the primary RDL **108C** along the Z-axis as shown in FIG **6E** and/or to the laterally extending RDL structure **118** in the XZ plane as shown in FIG. **6E****,** **17A** or **17B****.**

According to some embodiments, the laterally extending RDL structure **118** shown in FIG. **17A** or **17B** is electrically connected to the first conductive element of the primary RDL, to the the conductive pad **212** or conductive via **214** shown in FIG. **4G** or **6D****,** pillars **224** or plugs **234** shown in **FIG. 6D****.**

According to some embodiments, the laterally extending RDL structure **118** (corresponding to the RDL **118A** shown in FIG. **7I**) includes a hybrid bonding layer or a bump pad array **(244).**

According to some embodiments, referring to FIGS. **17A** and **17B****,** an IC stack **1901** includes a plurality of IC structures **1920** horizontally separate with each other. Referring to FIGS. **2C****,** **2D** and **17A****,** each IC structure **1920** can be the structure **108A** shown in FIG. **2D** that includes a top surface **108P1,** a bottom surface **108P2** opposite to the top surface, and four sidewalls including a first sidewall **1920S1** or **108S1,** a second sidewall **1920S2** or **108S2,** a third sidewall **1920S3** or **108S3** and a fourth sidewall **108S4.** The area of the bottom surface or the top surface is larger than that of any of the four sidewalls, e.g., **1920S1 (108S1), 1920S2 (108S2), 1920S3 (108S3)** and **108S4.** The IC stack **1901** may further include a laterally extending RDL structure **118** covering each first sidewall **1920S1 (108S1)** of each of the plurality of the IC structures **1920.**

According to some embodiments, the IC stack **1901** further includes a set of upward extending thermal conductivity layers **1912,** wherein a corresponding upward extending thermal conductivity layer **1912** is disposed between any two adjacent IC structures **1920** of the plurality of IC structures **1920.** The IC stack **1901** may also include a first laterally extending thermal conductivity layer **1914** covering each second sidewall **1920S2 (108S2)** of each of the plurality of IC structures **1920** and thermally coupling to the set of upward extending thermal conductivity layers **1912.** The thermal conductivity of any of the upward extending thermal conductivity layer **1912** or the first laterally extending thermal conductivity layer **1914** is higher than that of Si or SiO₂.

According to some embodiments, referring to FIG. **17B****,** the IC stack **1901** further includes a second laterally extending thermal conductivity layer **1917** covering each of the third sidewall **1920S3 (108S3)** of the plurality of IC structures **1920.** The second laterally extending thermal conductivity layer **1917** is thermally coupling to the set of upward extending thermal conductivity layers **1912.**

According to some embodiments, the IC stack **1901** is an HBM-compatible structure and each IC structure **1920** includes a DRAM semiconductor die **1920.** The IC stack **1901** further includes a logic control chip **1906** under and electrically connected to the laterally extending RDL structure **118** of the IC stack **1901.**

The present invention provides a 3D IC structure with at least one NuHBM system which includes a plurality of edge-pad semiconductor dies horizontally stacked together. Unlike existing HBM structures, edge pads of each semiconductor die are over the side face(s) of semiconductor die for interconnection to allow for skip-die signal and power distribution without going through other semiconductor dies. There is no TSVs in each semiconductor die as compared with an existing DRAM chip used in HBM; therefore, it is unnecessary to perform die thinning. Moreover, the high thermal conductivity material is disposed between two adjacent semiconductor dies and optionally coupled to another high thermal conductivity material covering other side faces of the semiconductor dies. Furthermore, as shown in the previous table, each NuHBM system could more easily offer the increased number of dice with a much higher data bandwidth (about 2.457 TB/s to about 6.144 TB/s) even based on more stringent requirements of the access latency (such as the LPDDR5 latency specification). Thus, the present invention can resolve the long-existing memory bandwidth bottleneck for data input and output from the Processor/SOC.

Furthermore, the expensive interposer is unnecessary in the 3D IC structure of the present invention. As shown in FIG. **1****,** in the CoWoS structure **20.** the HBM structure **21** with the SOC chip **22** has all signal and power connections arranged in a flipped manner to be electrically connected to the substrate **24** through an interposer **23** with TSVs **201,** which pitch is about 10 to 20 microns. However, the present invention could use memory controller and SOC circuit on a 3nm/5nm die, by simplifying CoWoS structure without a layer of wafer or an interposer, which is the most advanced version of integrating HBM systems on a die, in which the die serves both functions of being a memory controller and an SOC chip on the same level of silicon layer. The silicon layer has a flipped surface directly facing the substrate. Thus, the proposed new structure can be referred to as Integrated Memory System on SoC wafer on Substrate (IMSWonS).

The following summarizes advantages of the NuHBM system with Vertical Shelf Architecture (VSA) in contrast to the HBM specification:
(1) An HBM 4.0 die occupies a footprint area like that of an LPDDR5 HBM die with a capacity of 16Gb (e.g. 6.25mm x 7.59mm). However, the footprint area of the NuHBM system depends on how many units of the edge-pad semiconductor dies plus high thermal conductivity layer next to the edge-pad semiconductor die are used, for example, 24 edge-pad semiconductor dies occupy about 4.8mm (see FIG. **13B****)** which is much smaller than the area occupied by an HBM 4.0 structure.
(2) The I/Os of the NuHBM system comes directly from each single edge-pad semiconductor die without mixing with those of other edge-pad semiconductor dies. As such, the signal can be better managed (such as less skew) than the signal coming out from 16-die stack used in the HBM4.0 framework.
(3) The capacity of NuHBM system is scalable and adaptive without worrying about the signal transmission through other DRAM dies. The capacity of NuHBM system could be extremely high, or middle-size down to lower capacity, because each semiconductor die used in the present NuHBM system has its own identity or stand-alone edge-pads, but not limited by the TSVs used in today's HBM DRAM stack.
(4) The total data bandwidth can be achieved by increasing the total number of I/Os (equal to a product of "the number I/Os from each edge-pad semiconductor die" multiplied by "the number of edge-pad semiconductor die") by using more edge-pad semiconductor dies on the shelf structure, in contrast to 1K or 2K I/Os made in the stacked dice of the HBL4.0 framework. Thus, besides driving harshly on the data rate from each I/O, the total bandwidth can be achieved by using more dice for delivering more data I/Os.
(5) Since signals are coming out from each edge-pad semiconductor die and are directly connected to the I/Os of the memory controller and later immediately operated in and out from the SOC die, the signal integrity can be significantly improved. The power for handling the I/Os can also be reduced.

## Claims

1. An IC structure comprising:
a first memory stack comprising:
a plurality of semiconductor dies horizontally separate with each other, wherein each semiconductor die comprises a top surface, a bottom surface opposite to the top surface, and four sidewalls comprising a first sidewall, a second sidewall, a third sidewall and a fourth sidewall, and a plurality of edge pads arranged along the first sidewall; wherein the area of the bottom surface or the top surface of each semiconductor die is larger than that of any sidewall; and
a logic die with memory controller under the first memory stack and electrically connected to the plurality of edge pads of each semiconductor die;
a logic die with processor circuit disposed over and electrically connected to the logic die with memory controller; and
a packaging substrate under and electrically connected to the logic die with memory controller,
wherein a die area of the logic die with memory controller is larger than the sum of a horizontal cross-section area of the first memory stack and a die area of the logic die with processor circuit,
wherein there is no interposer between the packaging substrate and the logic die with memory controller, and there is no TSV in each semiconductor die.

2. The IC structure of claim 1, further comprising:
an upward extending thermal conductivity layer between two adjacent semiconductor dies; wherein the thermal conductivity of the upward extending thermal conductivity layer is higher than that of Si or SiO₂; and/or
a laterally extending thermal conductivity layer covering each second sidewall of the plurality of semiconductor dies and thermally coupled to the upward extending thermal conductivity layer, wherein the laterally extending thermal conductivity layer is opposite to the first sidewalls of the plurality of semiconductor dies, and the thermal conductivity of the laterally extending thermal conductivity layer is higher than that of Si or SiO₂.

3. The IC structure of claim 2, wherein the upward extending thermal conductivity layer or the laterally extending thermal conductivity layer comprises undoped polysilicon, large crystalline silicon ,SiC, BN, AlN, W, or copper.

4. The IC structure of claim 1, wherein each semiconductor die comprises a DRAM die, and the plurality of edge pads of each DRAM die includes about 128 to 5000 edge pads, and a pitch between two adjacent edge pads is between about 5 µm and about 100 µm.

5. The IC structure of claim 4, wherein the plurality of edge pads of each semiconductor die includes a subset of data pads, and the logic die with memory controller selects a predetermined data width from the subset of data pads of one semiconductor die, or portion of the plurality of semiconductor dies, or all the plurality of semiconductor dies.

6. The IC structure of claim 5, wherein the predetermined data width selected by the logic die with memory controller is set by a mode register in each semiconductor die.

7. The IC structure of claim 5, wherein the logic die with memory controller selects the predetermined data width from the subset of data pads of a portion or all of the plurality of semiconductor dies by a cross-bar circuit.

8. The IC structure of claim 5, wherein:
the logic die with memory controller selects the predetermined data width from the subset of data pads of one, a portion or all of the plurality of semiconductor dies by a plurality of SRAM array respectively corresponding to the plurality of semiconductor dies,
wherein each SRAM array temporarily holds the predetermined data width from the corresponding semiconductor die.

9. The IC structure of claim 4, wherein the logic die with memory controller includes multiple TSVs.

10. The IC structure of claim 1, further comprising a heat sink over the logic die with processor circuit, and a top surface of the heat sink is leveled with that of the first memory stack.

11. The IC structure of claim 1, further comprising:
a second memory stack comprising:
a plurality of semiconductor dies horizontally separate with each other, wherein each semiconductor die comprises a top surface, a bottom surface opposite to the top surface, and four sidewalls with a first sidewall, a second sidewall, a third sidewall and a fourth sidewall, and a plurality of edge pads arranged along the first sidewall; wherein the area of the bottom surface or the top surface of each semiconductor die of the second memory stack is larger than that of any sidewall; and
an upward extending thermal conductivity layer between two adjacent semiconductor dies; wherein the thermal conductivity of the upward extending thermal conductivity layer is higher than that of Si or SiO₂,
wherein the first memory stack and the second memory stack are horizontally spaced apart from the logic die with processor circuit, and
are disposed along one side of the logic die with processor circuit.

12. The IC structure of claim 1, further comprising:
a second memory stack, a third memory stack, and a fourth memory stack, each of them comprising:
a plurality of semiconductor dies horizontally separate with each other, wherein each semiconductor die comprises a top surface, a bottom surface opposite to the top surface, and four sidewalls with a first sidewall, a second sidewall, a third sidewall and a fourth sidewall, and a plurality of edge pads arranged along the first sidewall; wherein the area of the bottom surface or the top surface is larger than that of any sidewall; and
an upward extending thermal conductivity layer between two adjacent semiconductor dies; wherein the thermal conductivity of the upward extending thermal conductivity layer is higher than that of Si or SiO₂,
wherein the first memory stack, the second memory stack, the third memory stack and the fourth memory stack are horizontally spaced apart from the logic die with processor circuit, and are disposed along four sides of the logic die with processor circuit, respectively.

13. The IC structure of claim 1, wherein each edge pad of each semiconductor die includes an edge contact in a back-end-of-line (BEOL) region and a conductive via over the edge contact and in a dielectric layer at the top surface, wherein the area of the conductive via is greater than that of the edge contact.

14. The IC structure of claim 1, wherein each edge pad of each semiconductor die includes an edge contact in a back-end-of-line (BEOL) region and a conductive via over the edge contact and in a redistribution layer (RDL) at the top surface, wherein the area of the conductive via is greater than that of the edge contact.

15. The IC structure of claim 14, wherein the edge contact electrically connects to a signal pad in a back-end-of-line (BEOL) region of the semiconductor die surrounded by a seal ring structure.

16. The IC structure of claim 1, wherein each edge pad of each semiconductor die includes a conductive line in a redistribution layer (RDL), the conductive line electrically connected to a signal pad in a back-end-of-line (BEOL) region of the semiconductor die surrounded by a seal ring structure.

17. The IC structure of claim 16, wherein the RDL includes a plurality of stacked dielectric layers within which the conductive line is located.

18. The IC structure of claim 17, wherein a portion of the conductive line is configured to be disposed in a scribe line region of a semiconductor wafer prior to dicing of the semiconductor wafer.
